(19) **Europäisches Patentamt / European Patent Office / Office européen des brevets**

(11) **EP 3 583 312 B1**

(12) **FASCICULE DE BREVET EUROPEEN**

(45) Date de publication et mention
de la délivrance du brevet:
**09.12.2020 Bulletin 2020/50**

(21) Numéro de dépôt: **18705622.1**

(22) Date de dépôt: **14.02.2018**

(51) Int Cl.:
*F03D 1/06* $^{(2006.01)}$

(86) Numéro de dépôt international:
**PCT/EP2018/053727**

(87) Numéro de publication internationale:
**WO 2018/149895 (23.08.2018 Gazette 2018/34)**

(54) **PROCÉDÉ DE CONCEPTION D'UNE PALE D'ÉOLIENNE OU D'HYDROLIENNE**

VERFAHREN ZUM ENTWURF DES ROTORBLATTES EINER WINDTURBINE ODER
WASSERTURBINE

METHOD OF DESIGNING A BLADE OF A WIND TURBINE OR WATER TURBINE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.02.2017 FR 1751204**

(43) Date de publication de la demande:
**25.12.2019 Bulletin 2019/52**

(73) Titulaires:
• **Université Paris Diderot Paris 7
75013 Paris (FR)**
• **Ecole Supérieure de Physique et de Chimie
Industrielles de la Ville de Paris
75005 Paris (FR)**
• **Centre National de la Recherche Scientifique -
CNRS
75016 Paris (FR)**
• **Sorbonne Université
75006 Paris (FR)**

(72) Inventeurs:
• **COGNET, Vincent
92340 Bourg La Reine (FR)**
• **COURRECH DU PONT, Sylvain
94500 Champigny Sur Marne (FR)**
• **THIRIA, Benjamin
75013 Paris (FR)**

(74) Mandataire: **Regimbeau
20, rue de Chazelles
75847 Paris Cedex 17 (FR)**

(56) Documents cités:
**EP-A1- 2 818 408        WO-A1-2011/088372
DE-A1-102007 036 917     US-A1- 2011 206 529
US-A1- 2013 189 116**

**Description**

DOMAINE DE L'INVENTION

L'invention porte sur la conception de pales flexibles et la détermination de leurs caractéristiques pour améliorer les performances des éoliennes ou hydroliennes. Un exemple est connu du document EP 2 818 408 A1 qui divulgue un procédé de conception d'une pale flexible d'éolienne (ou d'hydrolienne) prédéfinie.

ARRIERE-PLAN TECHNOLOGIQUE

L'énergie éolienne est en plein essor. Cependant, alors que les panneaux solaires thermiques ou photovoltaïques font leur entrée chez les particuliers, la production d'énergie éolienne reste principalement réservée à de grands sites de production. Ce phénomène s'explique en partie par le manque de polyvalence des éoliennes à pales rigides.

Une éolienne est en effet conçue pour fonctionner à une vitesse de fluide incident et une vitesse de rotation données. Le rendement d'une éolienne est donc maximal pour une vitesse spécifique donnée, appelée vitesse spécifique optimale $\lambda_{max}$.

On définit la vitesse spécifique $\lambda$ comme le rapport entre la vitesse considérée en bout de pale et la vitesse de fluide incident. Ainsi, si la vitesse du fluide s'écarte de la valeur nominale de fonctionnement de l'éolienne, la vitesse spécifique $\lambda$ s'écarte de la vitesse spécifique optimale $\lambda_{max}$ et le rendement de l'éolienne baisse notablement. C'est la raison pour laquelle des études météorologiques préalables sont effectuées sur la zone d'implémentation d'une éolienne avant de la dimensionner.

De plus, afin de maximiser l'énergie extraite par l'éolienne dans la veine de fluide au sein duquel l'éolienne est placée, un angle d'attaque optimal $\beta_0$ est calculé à la vitesse spécifique optimale $\lambda_{max}$. On définit l'angle d'attaque $\beta$ d'une pale profilée comme l'angle entre la corde de la pale et la direction du fluide relatif circulant autour de la pale, dans le référentiel tournant attaché à la pale. On définit par ailleurs un autre paramètre de pale, appelé angle de calage $\theta$, qui est l'angle entre le plan de rotation de la pale et la corde de la pale.

Dans la mesure où la vitesse de fluide relatif incident augmente avec la hauteur le long de la pale, il est possible de vriller les pales d'éoliennes de sorte à ce que la force exercée par le fluide sur la pale soit le même en tous points de la pale, c'est-à-dire que l'angle d'attaque soit le même en tous points de la pale. Le vrillage d'une pale consiste en l'adaptation de sa géométrie pour garder un angle d'attaque comparable tout au long de la pale. Une pale vrillée possède une géométrie telle que l'angle de calage diminue avec la hauteur le long de la pale suivant une certaine évolution, appelée taux de vrillage.

La conception d'une pale rigide définit donc un angle d'attaque $\beta_0$ optimal pour une vitesse spécifique optimale $\lambda_{max}$ donnée, et peut en outre définir un angle de vrillage optimal associé à l'angle d'attaque $\beta_0$ optimal.

Une des principales raisons à la perte de rendement pour des valeurs de vitesse spécifique $\lambda$ différentes de la vitesse spécifique optimale $\lambda_{max}$, vient du fait que l'angle d'attaque $\beta$ qui maximise l'énergie extraite dans la veine de fluide, varie en fonction de la vitesse spécifique $\lambda$. Or il est impossible de faire évoluer le vrillage d'une pale rigide en fonction du régime de fonctionnement d'une éolienne. Ainsi, pour atteindre un rendement élevé sur toute la gamme de fonctionnement de l'éolienne (i.e. à tous les régimes de fluide incident), on fait varier l'angle de calage de la pale rigide $\theta$ en fonction de la vitesse de rotation $\Omega$ de l'éolienne.

En effet, lorsque la vitesse de rotation $\Omega$ d'une éolienne change, l'angle d'attaque $\beta$ du fluide sur les pales en rotation change. Ainsi, la géométrie des pales vue par le fluide est une fonction de la vitesse de rotation $\Omega$, et ne peut être optimale sur toute la gamme de fonctionnement. Si l'éolienne est à l'arrêt, l'angle d'attaque $\beta$ et l'angle de calage $\theta$ sont complémentaires. Le couple aérodynamique est alors maximum pour des angles d'attaque $\beta$ assez grands. Pour une vitesse de fluide donnée, lorsque l'éolienne accélère, l'angle d'attaque $\beta$ apparent diminue et lorsque l'angle d'attaque $\beta$ s'approche de zéro, le couple aérodynamique fait de même. Cette limite intervient pour des vitesses de rotation $\Omega$ d'autant plus faibles que l'angle de calage $\theta$ est grand. On comprend ainsi que le rendement peut être amélioré en adaptant l'angle de calage $\theta$ au régime de fonctionnement.

Actuellement cette variation de l'angle de calage $\theta$ se fait à l'aide d'un moteur, placé à la base de chaque pale, et dont les mouvements sont déterminés à partir de l'enregistrement des paramètres de fonctionnement (vitesse du fluide et vitesse de rotation de la pale entres autres). Une solution également connue est de placer des volets, également contrôlés au moyen de moteurs, sur les bords de fuite de chaque pale.

Néanmoins pour les petites éoliennes, il est trop coûteux d'alimenter en permanence des capteurs et des moteurs. Ces petites éoliennes ne bénéficient donc pas du changement de l'angle de calage et leur rendement, ainsi que leur plage de fonctionnement, s'en trouvent diminués.

Il existe donc un besoin de procédé de conception de pales d'éoliennes, notamment de petite et moyenne puissance, qui permettent de maximiser le rendement de l'éolienne sur une large plage de fonctionnement tout en n'étant pas coûteux en énergie.

**EP 3 583 312 B1**

RESUME DE L'INVENTION

Un des buts de l'invention est de proposer un procédé de conception de pales d'éolienne ou d'hydrolienne qui fonctionnent sur une plus large plage de régime de fluide incident, tout en n'étant pas coûteuses en énergie et plus aisée à mettre en place.

Un autre but de l'invention est de proposer un procédé de conception de pales d'éolienne ou d'hydrolienne quelle que soit la taille de l'éolienne.

Un autre but de l'invention est de proposer un procédé qui peut s'appliquer à toutes les géométries connues ou à venir de pales d'éoliennes ou d'hydroliennes, afin d'en améliorer le rendement.

Un autre but de l'invention est de proposer un procédé de conception de pale dont la régulation de l'angle de calage est passive, en rendant la pale flexible ou en la rendant apte à tourner autour de son envergure.

Un autre but de l'invention est de proposer un procédé de conception de pale qui soit en mesure de démarrer à une plus faible vitesse de fluide.

Un autre but de l'invention est de proposer un procédé de conception de pales qui puisse facilement être implémenté à la grande distribution et, de là, à l'industrialisation chez des particuliers.

A cet égard, dans une première partie de l'invention, l'invention propose un procédé de conception d'une pale flexible d'éolienne ou d'hydrolienne prédéfinie, la pale flexible présentant un profil géométrique connu : une envergure connue ainsi qu'une épaisseur et une corde qui sont connues et qui sont variables suivant la direction de l'envergure, un angle de calage au repos la pale flexible étant conçue à flexibilité au moins selon la corde, pour réguler passivement l'angle de calage de l'éolienne ou de l'hydrolienne en fonctionnement, le procédé comprenant les étapes suivantes :

a) réception du profil géométrique connu,
b) détermination, pour ledit profil géométrique appliqué à une pale rigide de référence, d'une évolution de l'angle de calage optimal de la pale rigide de référence $\theta_{0\,opt\,rigide}$ en fonction :

- de la vitesse spécifique $\lambda$ égale au rapport entre la vitesse considérée en bout de pale et la vitesse de fluide incident, pour un régime de vitesses du fluide s'écoulant autour de la pale rigide de référence, pour une première catégorie d'éoliennes/hydroliennes dite à axe horizontal de rotation et pour lesquelles la direction de vent U est orthogonale au plan de rotation de la pale,
- de la vitesse spécifique $\lambda$ et d'un angle $\alpha$, $\alpha$ étant l'angle de rotation de la pale autour de l'axe pour une deuxième catégorie d'éoliennes/hydroliennes dite à axe vertical de rotation, ou à axe de rotation horizontal quand la vitesse de vent U n'est pas orthogonale au plan de rotation de la pale,

c) détermination du comportement local de la pale flexible, se déformant d'une part sous l'effet du chargement aérodynamique du fluide circulant autour de pale flexible, et d'autre part de la force centrifuge qui s'exerce sur la pale flexible en rotation, et détermination de ratios locaux relatifs au chargement aérodynamique et à la force centrifuge s'exerçant sur la pale flexible,
d) détermination de valeurs locales de module de flexion B et de masse volumique $\rho$, à l'aide des ratios locaux et du comportement de la pale flexible déterminés à l'étape c), de sorte que l'évolution d'un angle de calage effectif $\theta_{0eff}$ de la pale flexible, conféré par la flexibilité au moins selon la corde de la pale flexible, en fonction de la vitesse spécifique $\lambda$, corresponde à l'évolution déterminée à l'étape précédente b), et
e) restitution d'une information relative au choix du matériau, déterminée à partir des valeurs locales de module de flexion B et de masse volumique $\rho$ calculés à l'étape d) et du profil géométrique reçu à l'étape a).

Avantageusement, il est aussi considéré une pale flexible selon l'envergure. En fonction de la distance r suivant la direction de l'envergure, il est dans ce cas considéré que la déformation de la pale n'est pas la même.

L'épaisseur de la pale peut être demandée par le constructeur ou bien laissée libre dans une certaine plage de valeurs. Dans la suite, on considère le cas où l'épaisseur est laissée libre dans une certaine plage de valeurs.

Avantageusement, mais facultativement, le procédé de conception d'une pale flexible d'éolienne ou d'hydrolienne peut en outre comprendre au moins l'une des caractéristiques suivantes :

- dans l'étape b), est déterminée la valeur optimale $\lambda_{max\,rigide}$ pour lequel le rendement Cp de l'éolienne ou hydrolienne à pales rigides avec le même profil géométrique fixé que celui de l'éolienne à pales flexibles est maximum, et dans lequel il est déduit à l'aide de l'évolution de l'angle de calage optimal de pale rigide de référence $\theta_{0\,opt\,rigide}$ le point de fonctionnement optimum maximum [$\theta_{0\,opt\,max\,rigide}$, $\lambda_{max\,rigide}$], et dans l'étape c), est déterminée une valeur de l'angle de calage initial $\theta_{0\,eff\,ini}$ des pales flexibles pour que, en fonctionnement, le point de fonctionnement effectif maximum [$\theta_{0\,eff\,max}$, $\lambda_{max}$] de l'éolienne ou hydrolienne ayant ces pales flexibles, soit égal au point de fonctionnement optimum maximum [$\theta_{0\,opt\,max\,rigide}$, $\lambda_{max\,rigide}$] de l'éolienne ou hydrolienne à pales rigides,

- lors de l'étape c), les ratios locaux relatifs au chargement aérodynamique et à la force centrifuge s'exerçant sur la pale flexible, sont le nombre de Cauchy $C_y$ et le nombre centrifuge $C_c$, et sont déterminés en chaque point de la pale flexible, le nombre de Cauchy $C_y$ étant le rapport des moments de la force aérodynamique et de la force élastique, le produit $Cc^* \lambda^2$ étant le rapport des moments de la force centrifuge et de la force élastique,
- le nombre de Cauchy est égal à $C_y = \rho_{fluide}U^2W_f^3/(2B)$, le nombre centrifuge étant égal à $C_c = \rho U^2 h W_f^4/(R^2B)$, avec, pour chaque point considéré de la pale, $\rho$ masse volumique de la pale, $\rho_{fluide}$ masse volumique du fluide circulant autour de la pale, U vitesse du fluide incident, $W_f$ longueur de la partie flexible de la corde, B module de flexion de la pale, R rayon de la pale, h épaisseur de la pale, $\Omega$ vitesse rotation de la pale, $\lambda$ vitesse spécifique de la pale,
- lors des étapes b) à c), la pale étant assimilée à une série de poutres encastrées dans une tige rigide radiale, et considérées à différents endroits selon la direction de l'envergure, et qui se déforment selon la corde indépendamment les unes des autres, et l'évolution de l'angle de calage effectif de la pale flexible étant déterminée en fonction de l'abscisse curviligne de la corde,
- lors des étapes b) à c), la pale est assimilée à une plaque à deux dimensions encastrées dans une tige rigide radiale, et qui se déforme selon la corde et le rayon, et dans lequel il est appliqué les équations de plaque issues de la théorie de Kirchhoff- Love,
- l'information relative au choix du matériau porte sur la répartition du ou des matériaux au sein de la pale flexible,
- l'information relative au choix du matériau comporte une information sur la répartition de la masse volumique au sein de la pale flexible,
- l'information relative au choix du matériau comporte une information sur la répartition du module de flexion au sein de la pale flexible,
- l'information relative au choix du matériau comporte une information sur l'insertion d'éléments extérieurs à une pale à profil géométrique fixé,
- l'éolienne est assimilée à une plaque à deux dimensions, et pour laquelle il est vérifié l'équation suivante :

$$\nabla^2(B(x,y)\nabla^2 w(x,y,t)) = -q(x,y,t) - h(x,y)\rho(x,y)\frac{\partial^2 w(x,y,t)}{\partial t^2}$$

où B est le module de flexion, q le chargement du aux forces aérodynamique et centrifuge, h l'épaisseur de la plaque, $\rho$ la densité de la pale et w la déformation transverse de la pale, x et y marquent l'espace, t le temps, le membre de gauche représentant la déformation de la plaque, et le premier terme du membre de droite représente le chargement, et le deuxième terme du membre de droite représente le terme d'inertie,
- au cours de l'étape e), les valeurs locales de module de flexion B et de masse volumique $\rho$ sont déterminés de sorte que, en fonctionnement, l'angle de calage ne varie pas au-delà de 6°, par rapport à une valeur de l'angle de calage de la pale obtenue pour une position de la pale au repos.

Alternativement, il peut être envisagé un procédé de conception d'une pale flexible d'éolienne ou d'hydrolienne prédéfinie, la pale flexible présentant un profil géométrique connu : une envergure connue ainsi qu'une épaisseur et une corde qui sont connues et qui sont variables suivant la direction de l'envergure, un angle de calage au repos, la pale flexible étant conçue à flexibilité selon la corde et selon l'envergure, pour réguler passivement l'angle de calage de l'éolienne ou de l'hydrolienne en fonctionnement, le procédé comprenant les étapes suivantes :

a) réception du profil géométrique connu,
b) détermination, pour ledit profil géométrique appliqué à une pale rigide de référence, d'une évolution de l'angle de calage local optimal de la pale rigide de référence $\theta_{0\ opt\ rigide}$ (x,y), en fonction de la vitesse spécifique $\lambda$ égale au rapport entre la vitesse considérée au bout de pale et la vitesse de fluide incident rigide et la vitesse du fluide, pour un régime de vitesses du fluide s'écoulant autour de la pale rigide de référence,
c) détermination du comportement local de la pale flexible selon la corde, se déformant d'une part sous l'effet du chargement aérodynamique du fluide circulant autour de pale flexible, et d'autre part de la force centrifuge qui s'exerce sur la pale flexible en rotation, et détermination de ratios locaux relatifs au chargement aérodynamique et à la force centrifuge s'exerçant sur la pale flexible,
d) détermination de valeurs locales de module de flexion B(x,y) et de masse volumique $\rho$(x,y), à l'aide des ratios locaux et du comportement de la pale flexible déterminés à l'étape c) de sorte que l'évolution d'un angle de calage local $\theta$(x,y) de la pale flexible, conféré par la flexibilité selon la corde de la pale flexible, en fonction de la vitesse spécifique $\lambda$, corresponde à l'évolution déterminée à l'étape précédente b), et
e) restitution d'une information relative au choix du matériau, déterminée à partir des valeurs locales de module de flexion B(x,y) et de masse volumique $\rho$(x,y) calculés à l'étape d) et du profil géométrique reçu à l'étape a).

Dans ce cas, dans l'étape b), est déterminée la valeur optimale $\lambda_{max\ rigide}$ our lequel le rendement Cp de l'éolienne ou hydrolienne à pales rigides avec le même profil géométrique fixé que celui de l'éolienne à pales flexibles est maximum, et dans lequel il est déduit à l'aide de l'évolution de l'angle de calage local optimal de pale rigide de référence $\theta_{0\ opt\ rigide}$ (x,y) le point de fonctionnement optimum maximum [$\theta_{0\ opt\ max\ rigide}$ (x,y), $\lambda_{max\ rigide}$], et dans lequel est déterminé dans l'étape c), une valeur de l'angle de calage local initial $\theta_{0\ eff\ ini}$ (x, y) des pales flexibles pour que, en fonctionnement, le point de fonctionnement effectif maximum [$\theta_{0\ eff\ max}$ (x,y), $\lambda_{max}$] de l'éolienne ou hydrolienne ayant ces pales flexibles, soit égal au point de fonctionnement optimum maximum [$\theta_{0\ opt\ max\ rigide}$ (x, y), $\lambda_{max\ rigide}$] de l'éolienne ou hydrolienne à pales rigides.

On peut évidemment appliquer les caractéristiques techniques définies ci-avant à cette alternative de réalisation pour laquelle on considère l'évolution d'un angle de calage local $\theta(x,y)$ de la pale flexible.

On peut ainsi considérer chercher un module de Young, une épaisseur, et une masse volumique qui dépendent de l'endroit où l'on se trouve sur la pale donc de x et y.

L'épaisseur de la pale peut être demandée par le constructeur ou bien laissée libre dans une certaine plage de valeurs. Dans la suite, on considère le cas où l'épaisseur est laissée libre dans une certaine plage de valeurs.

On peut aussi considérer une pale rigide de référence vrillée avec $\theta_{0\ opt\ rigide}$ (x,y).

L'invention porte également sur un procédé de fabrication d'une pale flexible d'une éolienne ou d'une hydrolienne, le procédé comprenant des étapes de :

- mise en œuvre du procédé de conception d'une pale flexible d'une éolienne ou d'une hydrolienne précédemment décrit de sorte à concevoir une pale flexible d'éolienne ou d'hydrolienne ;
- fabrication de ladite pale flexible conformément à la conception de la pale flexible d'éolienne ou d'hydrolienne obtenue.

L'invention porte en outre sur une pale d'éolienne ou d'hydrolienne, caractérisée en ce qu'elle est flexible selon la corde, et est fabriquée selon le procédé de fabrication précédemment décrit, la flexibilité de ladite pale régulant passivement l'angle de calage de l'éolienne ou de l'hydrolienne en fonctionnement.

Avantageusement, mais facultativement, une pale d'éolienne ou d'hydrolienne ainsi fabriquée peut en outre comprendre l'une au moins des caractéristiques suivantes :

- la masse volumique est inhomogène.
- le module de flexion est inhomogène.
- elle comprend en outre des éléments extérieurs insérés.

L'invention porte de plus sur une éolienne ou hydrolienne comprenant une pluralité de pales flexibles précédemment décrites.

Le procédé de conception d'une pale flexible d'une éolienne ou d'une hydrolienne précédemment décrit permet donc de définir les caractéristiques d'un matériau flexible (notamment rigidité, épaisseur, densité) de pale d'éolienne ou d'hydrolienne qui, en se pliant, ajuste l'angle de calage de ladite pale de la façon souhaitée. Cet ajustement est obtenu sans consommation d'énergie (à la différence du moteur et des capteurs).

Par ailleurs, en ce qui concerne les grandes structures, utiliser les pales flexibles permet non seulement de remplacer le moteur sans consommer d'énergie, mais surtout d'alléger les pales. En effet les éoliennes ou hydroliennes qui récupèrent de grandes puissances sont de taille telle que préserver la rigidité des pales est coûteux et contraignant.

Dans une deuxième partie de l'invention, il est réalisé une éolienne avec des pales rigides reliées aux bras de l'éolienne par des ressorts de torsion.

Le même procédé que précédemment est appliqué, la seule différence étant qu'il n'est plus calculé le module de flexion de la pale flexible mais la raideur de torsion K des ressorts de torsion.

DESCRIPTION DES DESSINS

D'autres caractéristiques, buts et avantages de la présente invention apparaîtront mieux à la lecture de la description détaillée qui va suivre, et au regard des dessins annexés donnés à titre d'exemples non limitatifs et sur lesquels :

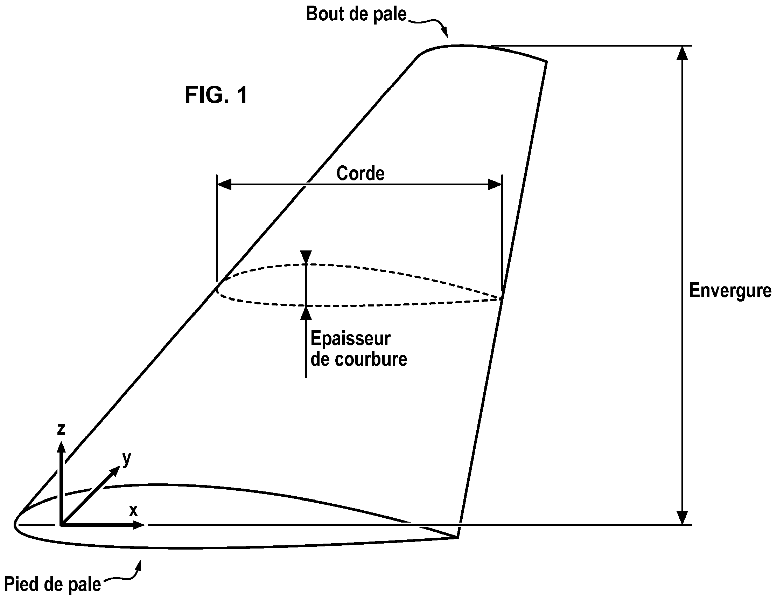

- la figure 1 illustre les dimensions principales d'une pale d'éolienne ;

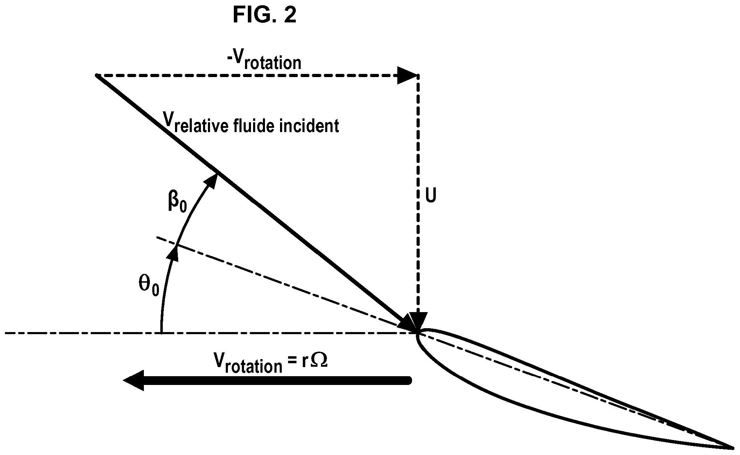

- la figure 2 illustre les notions d'angle d'attaque et d'angle de calage ;

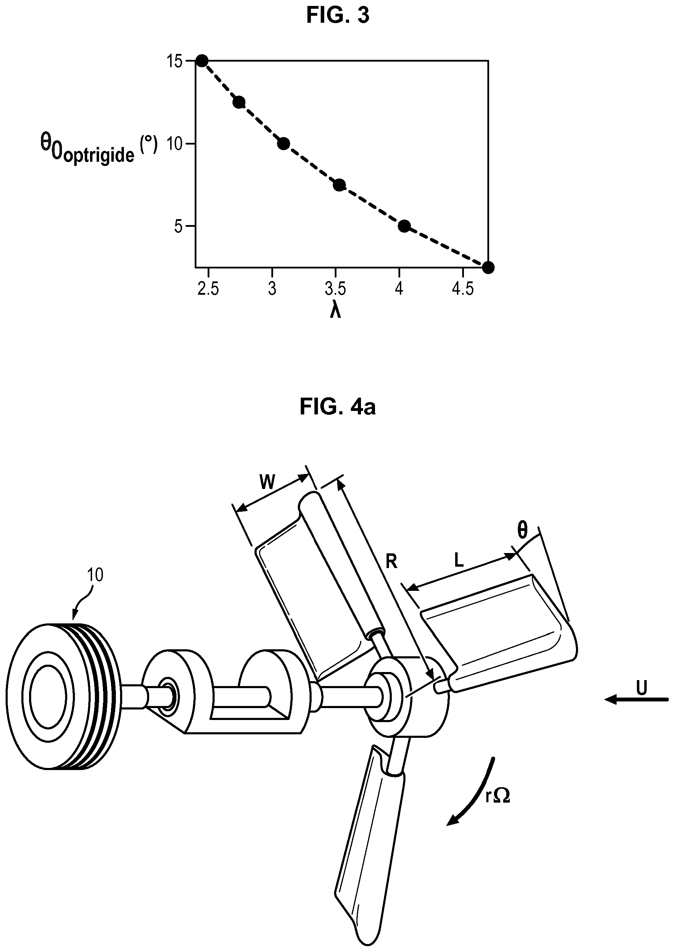

- la figure 3 est un exemple d'évolution de la valeur de l'angle de calage optimal $\theta_{0\ opt\ rigide}$ en fonction de la vitesse spécifique $\lambda$ ;
- les figures 4a à 4c illustrent une expérience d'étude d'une éolienne simplifiée en soufflerie, à axe horizontal de rotation ;

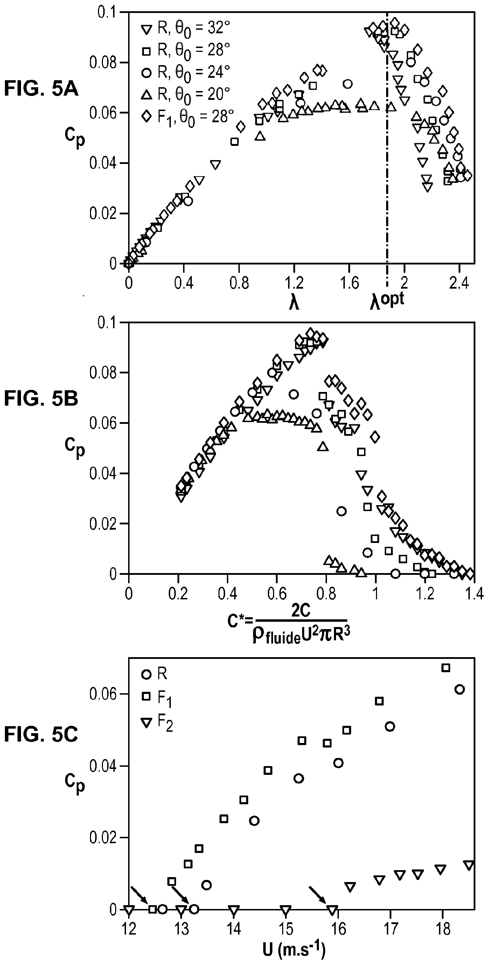

- les figures 5a à 5c illustrent un exemple d'évolution du rendement d'une éolienne en fonction de la rigidité des pales qu'elle comprend ;

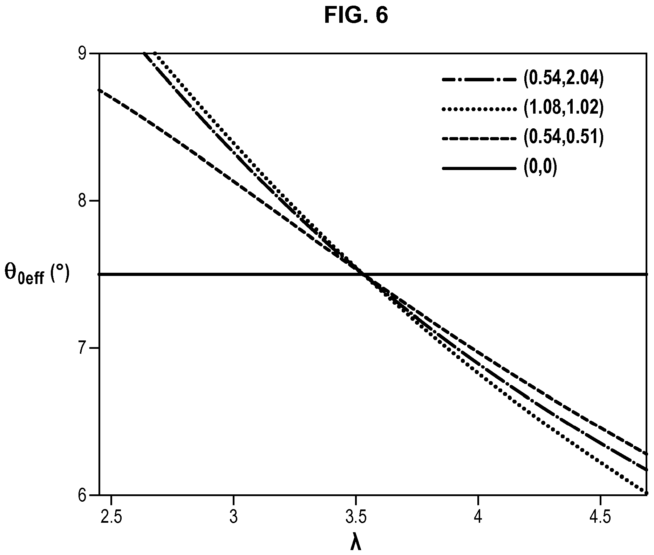

- la figure 6 est un exemple d'évolution de l'angle de calage effectif moyen $\theta_{0\,eff}$ d'une pale flexible, conçue au moyen du procédé de conception décrit (la pale est ici assimilée à une série de poutres flexibles), en fonction de la vitesse spécifique $\lambda$ pour différentes valeurs de nombre de Cauchy et de nombre centrifuge ;

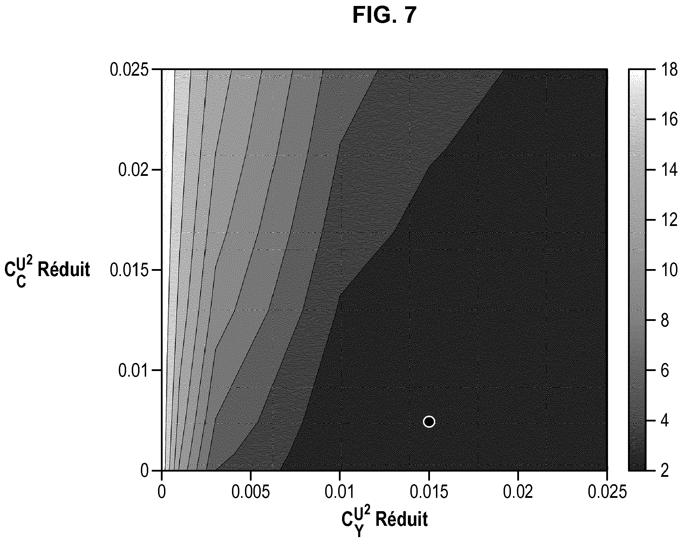

- la figure 7 illustre les résultats d'un exemple d'une étape de comparaison avec la méthode des moindres carrés dans le cas de la conception d'une pale homogène à deux dimensions au moyen du procédé de conception décrit ;

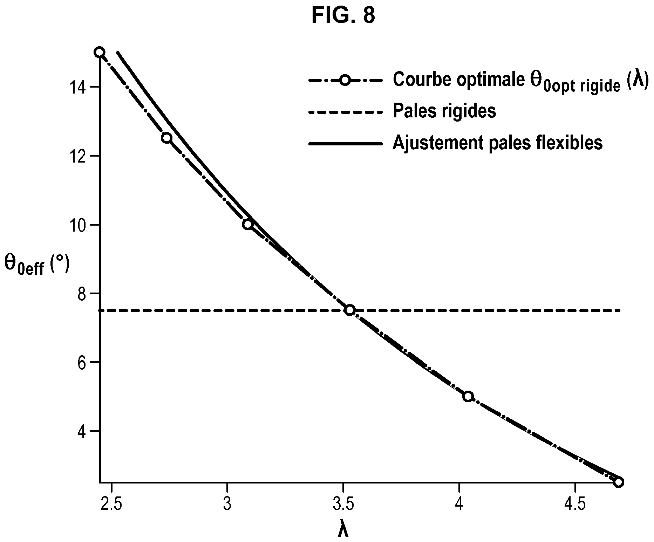

- la figure 8 illustre les résultats d'un exemple d'une étape de comparaison entre la courbe de référence et la courbe d'évolution de l'angle de calage effectif $\theta_{0eff}$ d'une pale à d'une pale homogène à deux dimension conçue au moyen du procédé de conception décrit ;

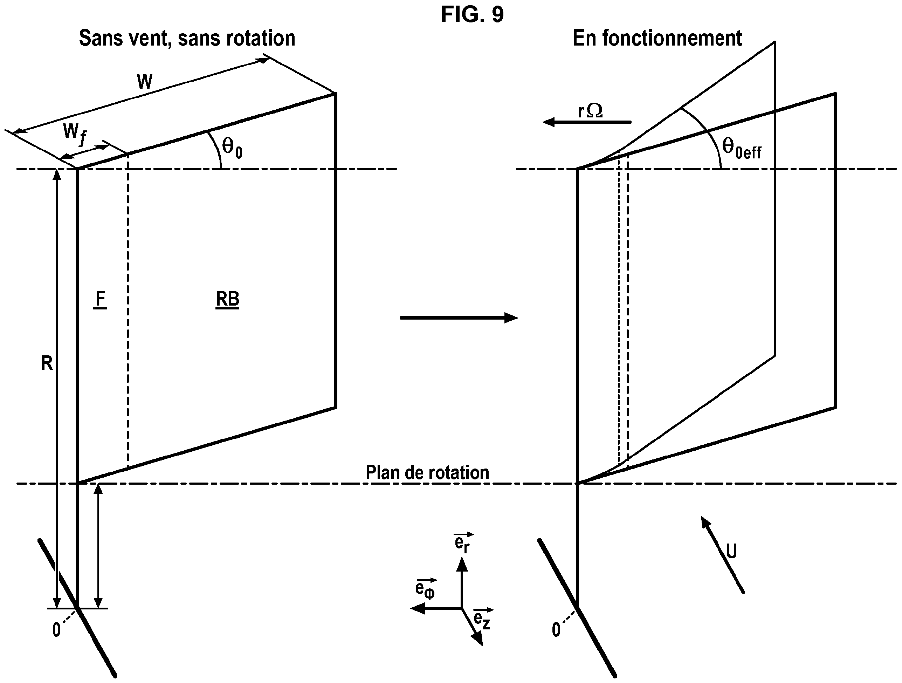

- la figure 9 est un schéma d'un exemple de pale flexible inhomogène ;

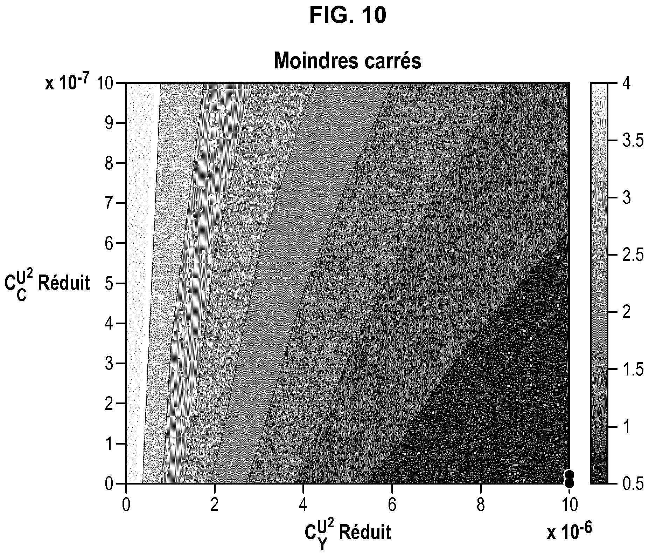

- la figure 10 illustre les résultats d'un exemple d'une étape de comparaison avec la méthode des moindres carrés dans le cas de la conception d'une pale inhomogène à deux dimension au moyen du procédé de conception décrit ;

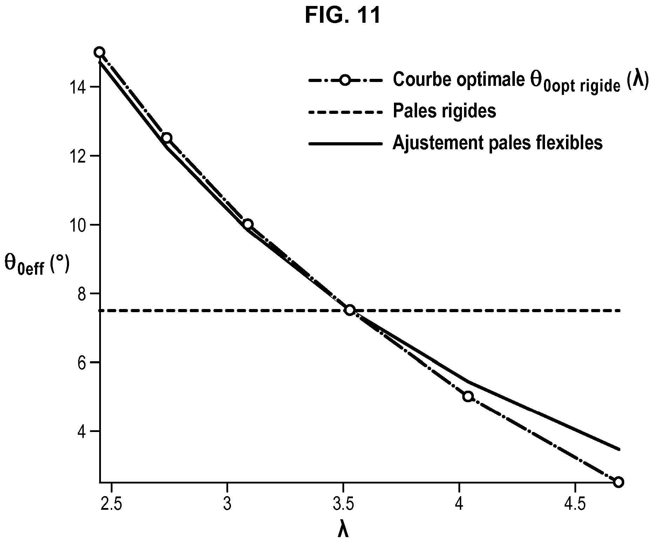

- la figure 11 illustre les résultats d'un exemple d'une étape de comparaison entre la courbe de référence et la courbe d'évolution de l'angle de calage effectif $\theta_{0eff}$ d'une pale à d'une pale inhomogène à deux dimension conçue au moyen du procédé de conception décrit ;

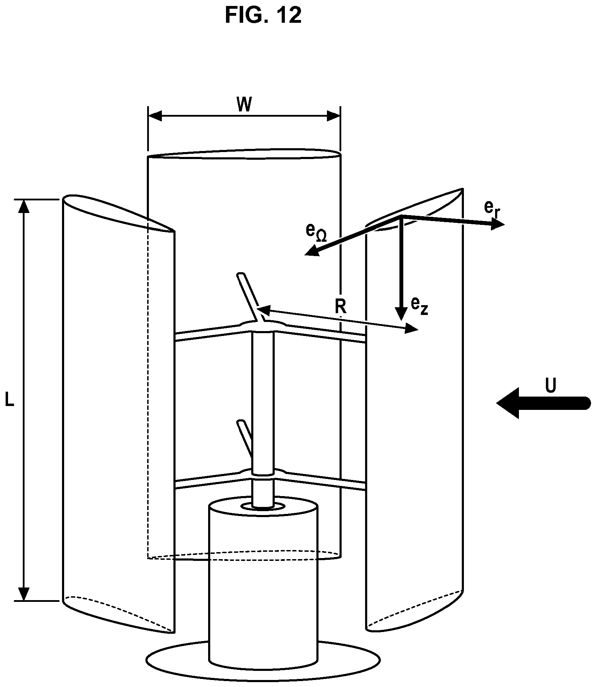

- la figure 12 est un schéma de l'éolienne à axe vertical de type Darrieus, avec le référentiel orthonormé ($\mathbf{e_r}$, $\mathbf{e_\Omega}$, $\mathbf{e_z}$) lié à la pale orthonormé ;

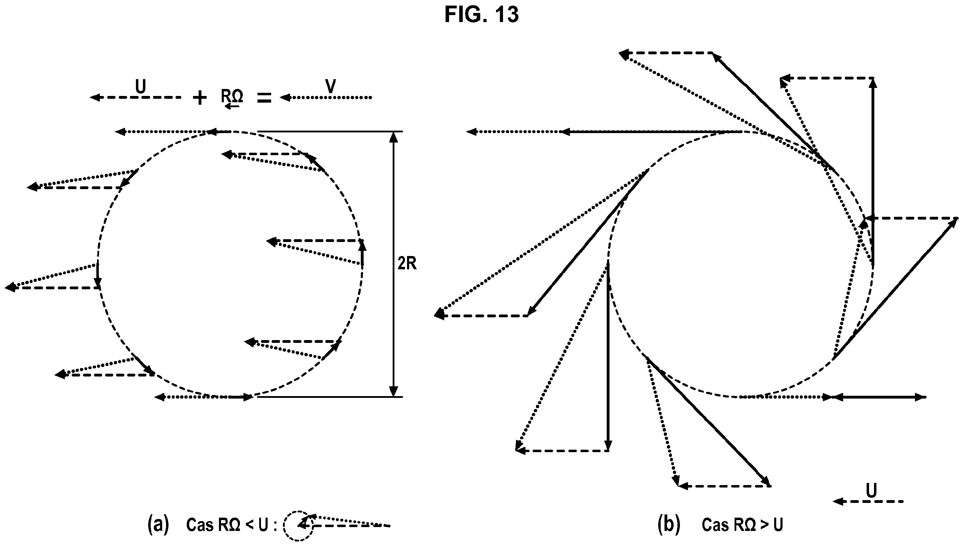

- la figure 13 illustre des schémas des vitesses de vent effectif $\mathbf{V = U + R}\Omega$ vues par la pale au cours d'une révolution (a) dans le cas où $R\Omega \leq U$ , (b) dans le cas où $R\Omega \geq U$ ;

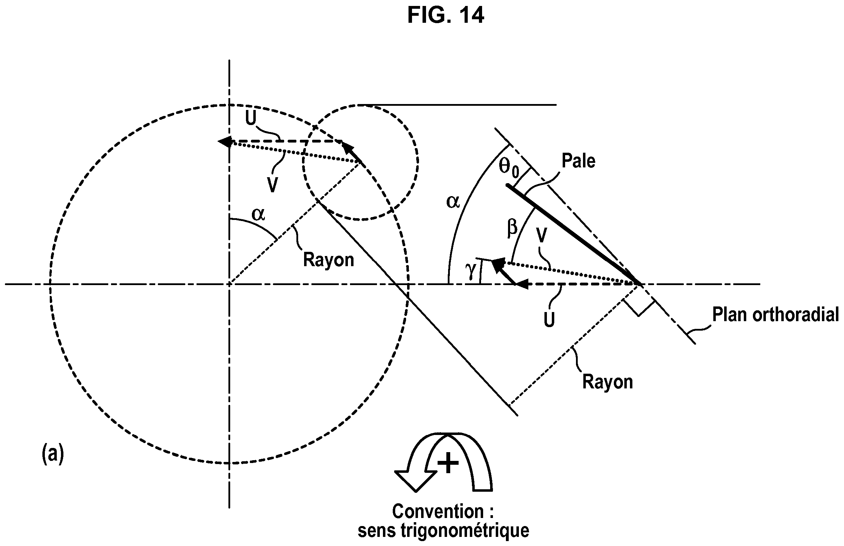

- la figure 14 représente la relation entre les différents angles : l'angle de calage $\theta_0$, l'angle d'attaque $\beta$, l'angle d'inclinaison du vent effectif $\mathbf{V}$ par rapport au vent incident $\mathbf{U}$ noté $\gamma$, et l'angle de révolution $\alpha$. On a ainsi la relation $\alpha = \theta_0 + \beta + \gamma$ ;

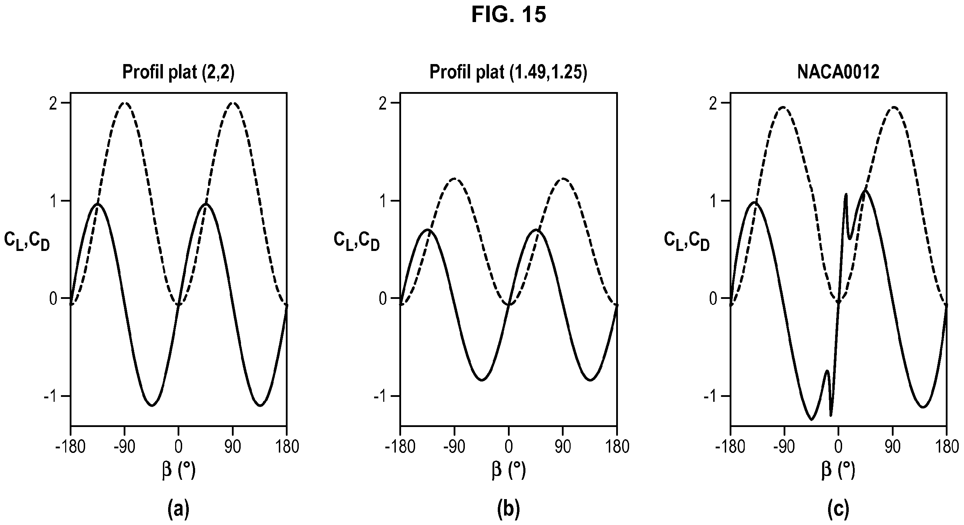

- la figure 15 montre l'évolution des coefficients de portance $C_L$ (trait plein) et de traînée $C_D$ (trait en pointillés) en fonction de l'angle d'incidence $\beta$ du vent sur la pale pour (a) une loi de pales minces $C_{L1} = C_{D1} = 2$, (b) une loi de pales minces $C_{L1} = 1.49$ et $C_{D1} = 1.25$, et (c) une loi inspirée des profils NACA 0012 ;

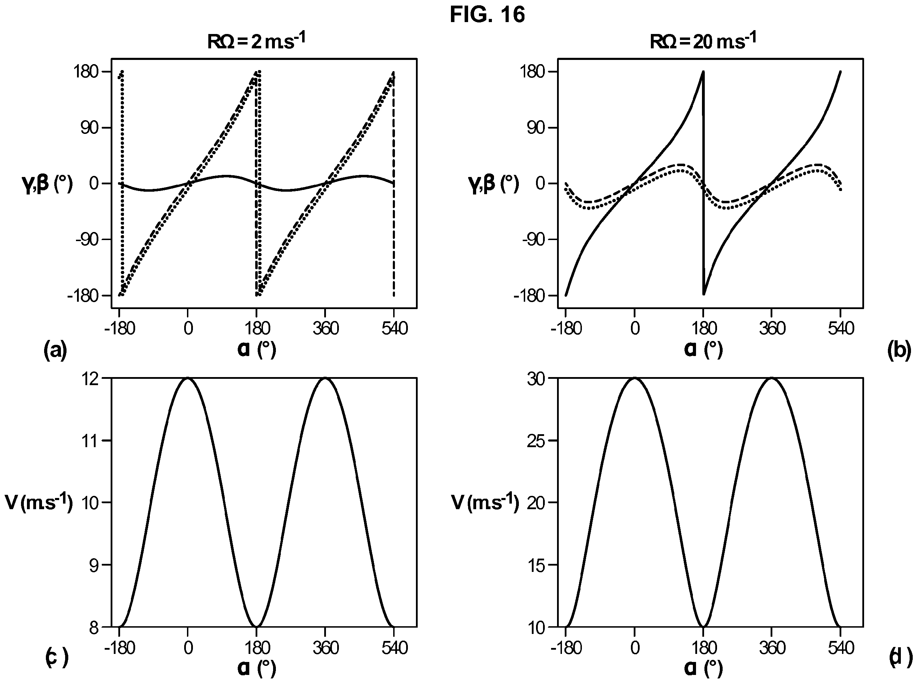

- la figure 16 montre en rangée du haut : évolutions des angles $\gamma$ (trait plein) et $\beta$ (trait en pointillés) en fonction de l'angle $\alpha$ pour une vitesse de vent incidente $U = 10$ m.s$^{-1}$ et (a) $R\Omega = 2$ m.s$^{-1}$, (b) $R\Omega = 20$ m.s$^{-1}$ ; trait en pointillés longs, $\theta_0 = 0°$, trait en pointillés courts, $\theta_0 = 10°$; et en rangée du bas : évolution respective de la norme de la vitesse de vent effectif V perçu par la pale ;

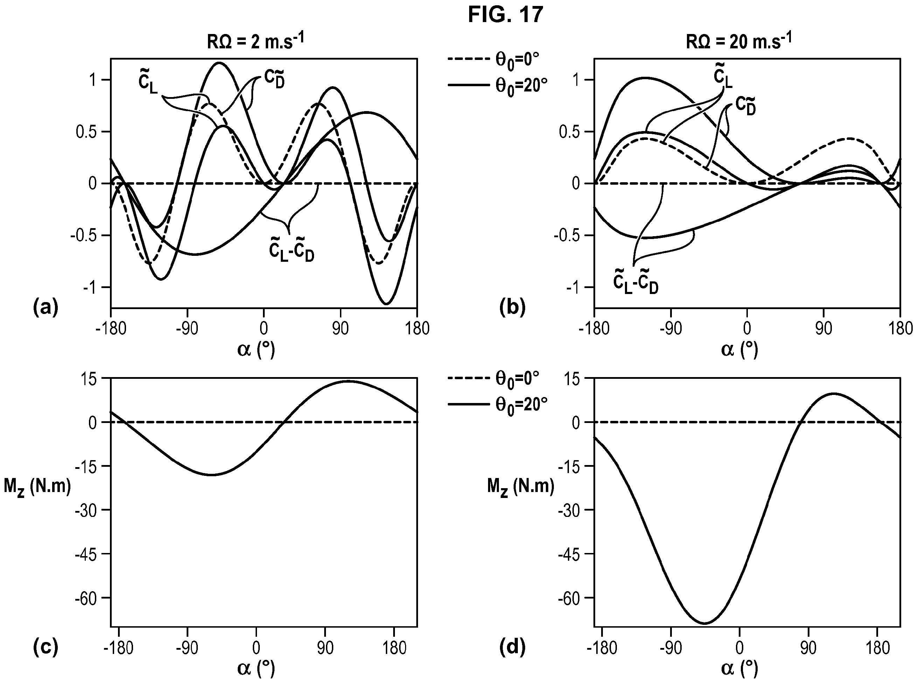

- la figure 17 montre l'évolution des projections de la force de portance $\tilde{C}_L = C_L \sin(\varphi)$ et de la force de traînée $\tilde{C}_D = C_D \cos(\varphi)$ ainsi que leur différence $\tilde{C}_L - \tilde{C}_D$ en fonction de l'angle $\alpha$, pour une vitesse de vent incidente $U = 10$ m.s$^{-1}$ et (a) $R\Omega = 2$ m.s$^{-1}$, (b) $R\Omega = 20$ m.s$^{-1}$ ; en traits pointillés, $\theta_0 = 0°$, en trait plein, $\theta_0 = 20°$ ; la loi choisie est la loi de pales minces $C_{L1} = C_{D1} = 2$ ; les figures (c) et (d) représentent les évolutions respectives du moment aérodynamique $M_z$ en fonction de l'angle $\alpha$ ;

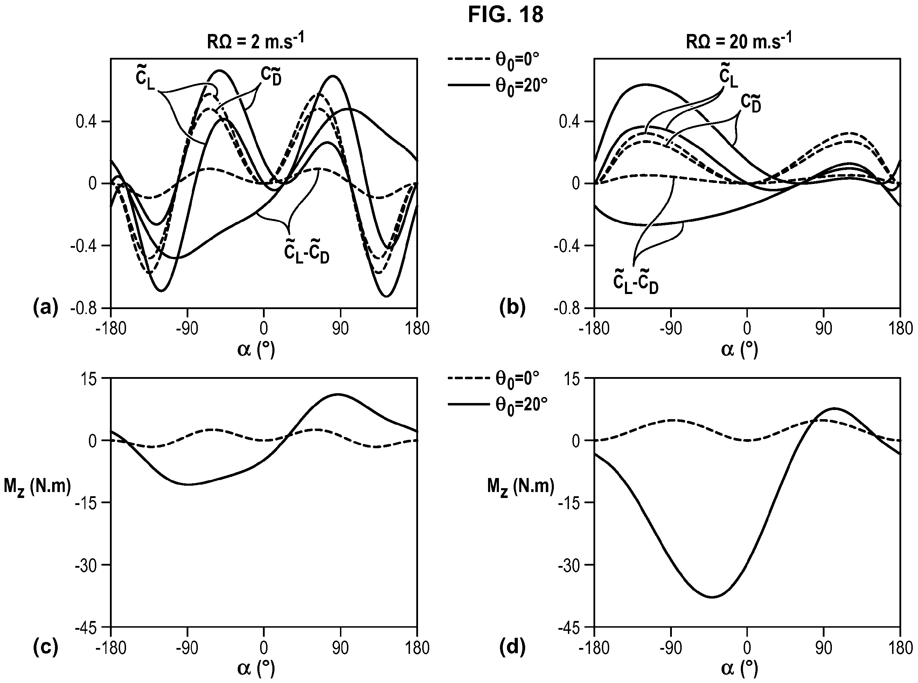

- la figure 18 montre l'évolution des projections de la force de portance $\tilde{C}_L = C_L \sin(\varphi)$ et de la force de traînée $\tilde{C}_D = C_D \cos(\varphi)$ ainsi que leur différence $\tilde{C}_L - \tilde{C}_D$ en fonction de l'angle $\alpha$, pour une vitesse de vent incidente $U = 10$ m.s$^{-1}$ et (a) $R\Omega = 2$ m.s$^{-1}$, (b) $R\Omega = 20$ m.s$^{-1}$ ; en traits pointillés, $\theta_0 = 0°$, en trait plein, $\theta_0 = 20$ ; la loi choisie est la loi de pales minces $C_{L1} = 1.49$ et $C_{D1} = 1.25$ ; les figures (c) et (d) représentent les évolutions respectives du moment aérodynamique $M_z$ en fonction de l'angle $\alpha$ ;

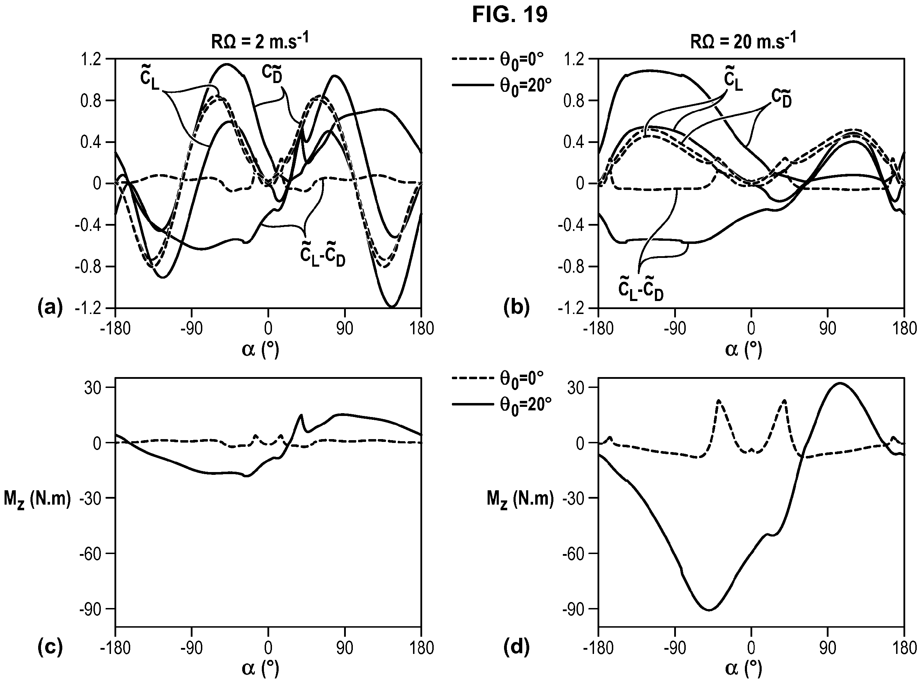

- la figure 19 montre l' évolution des projections de la force de portance $\tilde{C}_L = C_L \sin(\varphi)$ et de la force de traînée $\tilde{C}_D = C_D \cos(\varphi)$ ainsi que leur différence $\tilde{C}_L - \tilde{C}_D$ en fonction de l'angle $\alpha$, pour une vitesse de vent incidente $U = 10$ m.s-1 et (a) $R\Omega = 2$ m.s-1, $R\Omega = 20$ m.s-1 ; en traits pointillés, $\theta_0 = 0°$, en trait plein, $\theta_0 = 20°$ ; la loi choisie est la loi NACA0012 présentée à la figure 15 ; les figures (c) et (d) représentent les évolutions respectives du moment aérodynamique $M_z$ en fonction de l'angle alpha ;

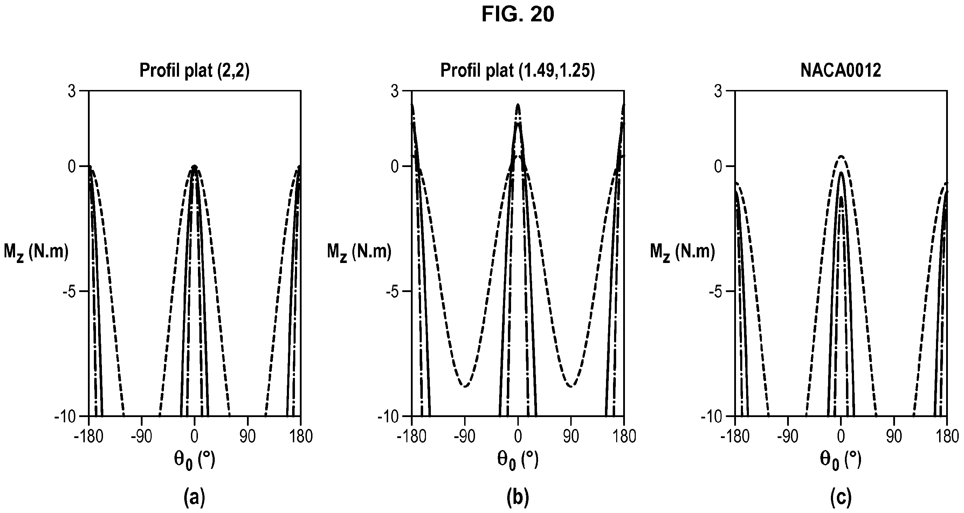

- la figure 20 montre les évolutions du moment aérodynamique moyen $M_z$ d'une pale sur une révolution en fonction de l'angle de calage $\theta_0$, pour une vitesse de vent incidente U=10m.s$^{-1}$ et $R\Omega = 2$ m.s$^{-1}$ (traits en pointillés), $R\Omega = 9$ m.s$^{-1}$ (trait plein), $R\Omega = 20$ m.s$^{-1}$ (trait en pointillés longs et courts alternés) pour (a) une loi de pales minces $C_{L1} = C_{D1} = 2$, (b) une loi de pales minces $C_{L1} = 1.49$ et $C_{D1} = 1.25$, et (c) une loi NACA 0012 ;

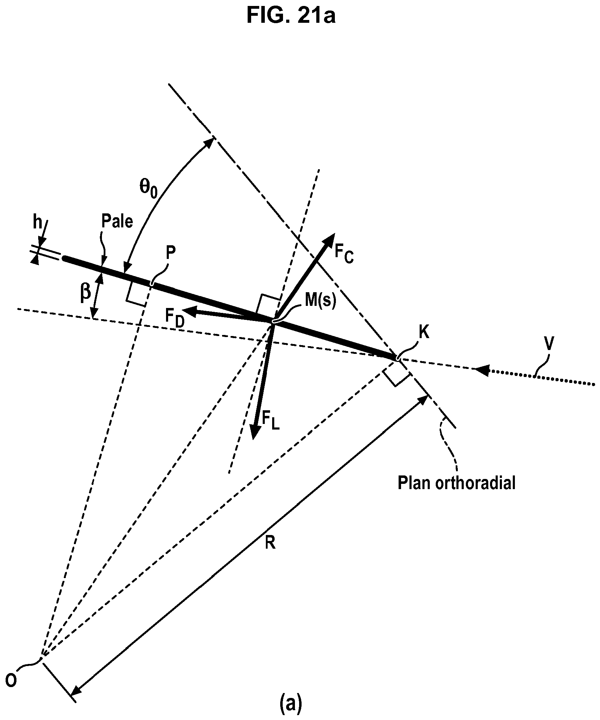

- la figure 21a représente les forces sur la pale d'épaisseur h ; la pale est encastrée au point K, situé à une distance R du centre de rotation ; cette pale est inclinée d'une angle de calage $\theta_0$ par rapport au plan orthoradial qui passe par K et voit un vent effectif V, qui arrive avec un angle d'incidence $\beta$ sur la pale ; les forces sont d'une part les forces de portance FL et de trainée FD qui tendent dans la situation à augmenter l'angle de calage $\theta_0$, et d'autre part la force centrifuge FC qui tend toujours à diminuer $\theta_0$ ; en M (s), ce sont les composantes localement orthogonales (suivant la ligne pointillée traversant la pale au niveau de M(s)) à la pale de ces forces qui font varier $\theta_0$ ;

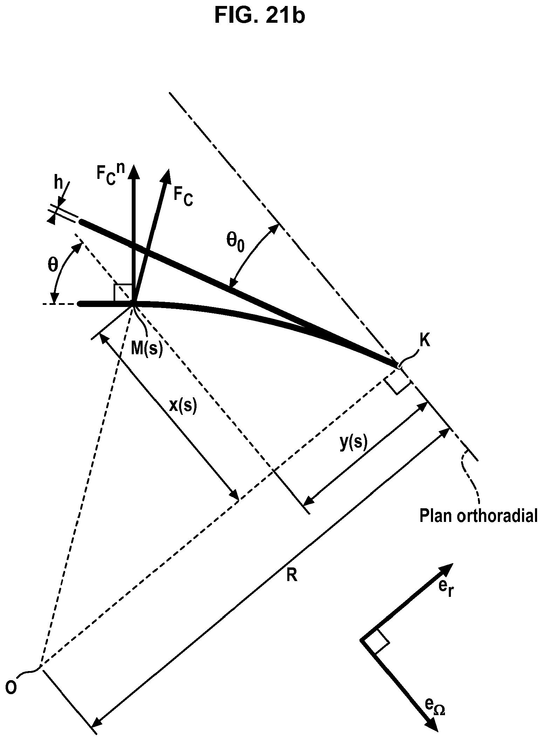

- -la figure 21b représente le schéma de situation d'un profil de pale rigide de référence (trait plein supérieur) et de pale flexible (trait plein inférieur) à une hauteur donnée ; la force centrifuge FC qui s'applique au point M(s), situé à une abscisse curviligne s du point d'encastrement K, est radiale ; cette force se décompose en une partie localement tangente en M(s) qui est équilibrée par les forces internes de la pale supposées inextensible, et en une partie Fn localement perpendiculaire à la pale en M , et qui tend à diminuer l'angle de calage $\theta$ ;

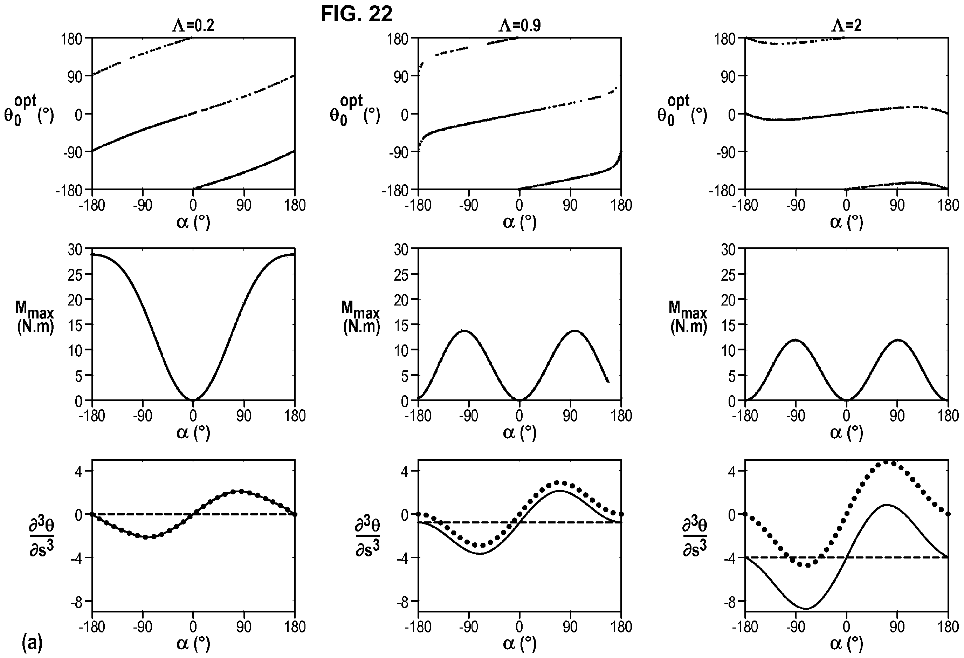

- la Figure 22 montre en première rangée l'évolution de l'angle de calage optimum $\theta^{opt}$ d'une EAV à pales rigides, c'est-à-dire l'angle de calage qui maximise le moment aérodynamique (représenté à la deuxième rangée) à vitesse de rotation fixée et donc qui optimise le rendement ; troisième rangée : évolution du moment issu des forces aérodynamiques qui fait plier la pale (trait en pointillés courts) et du moment issu de la force centrifuge qui fait plier la pale (trait en pointillés longs) ; la somme des deux est représenté en trait noir ; ces calculs sont réalisés pour $C_Y=C_C^{EAV}$ =1 et pour $\theta 0$ =0 degrés puisque l'on a vu plus tôt que c'était l'angle de calage initial rigide optimal. Si $\frac{\partial^3 \theta}{\partial s^3}$ est positif, alors cela augmente l'angle de calage, et inversement ; ces figures sont tracées pour la loi des pales minces $C_{L1}=C_{D1}=2$ et pour une vitesse incidente de vent U=10m.s$^{-1}$ et pour $\lambda$ =0.2 (première colonne), $\lambda$ =0.9 (deuxième colonne), $\lambda$ =2 (troisième colonne) ;

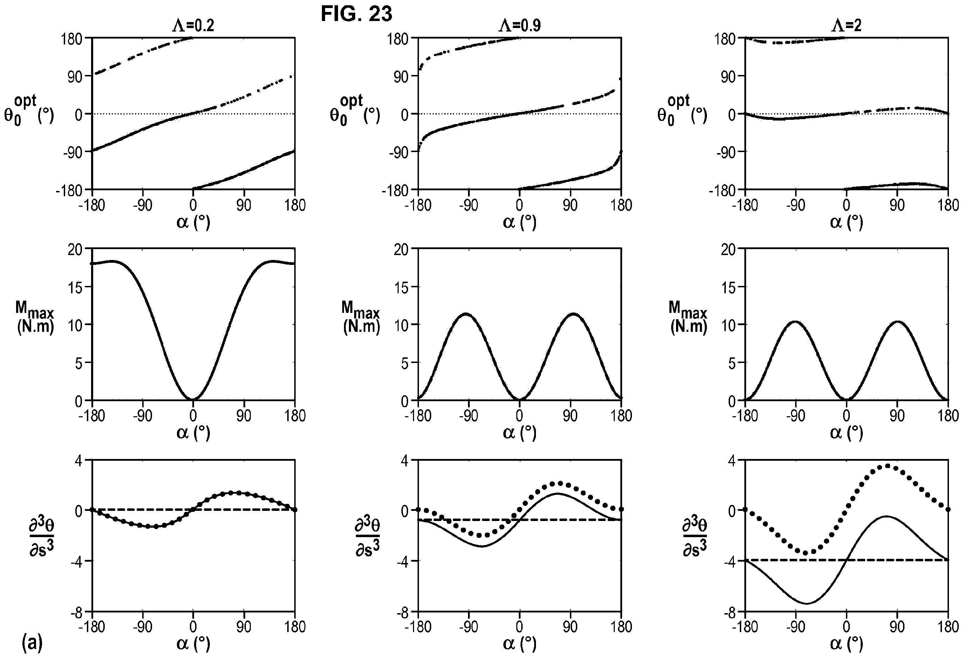

- la figure 23 montre : en première rangée :évolutions de l'angle de calage optimum d'une EAV à pales rigides, c'est-à-dire l'angle de calage qui maximise le moment aérodynamique (représenté à la deuxième rangée) à vitesse de rotation $\Omega$ fixée et donc qui optimise le rendement ; Troisième rangée : évolution du moment issu des forces aérodynamiques qui fait plier la pale (trait en pointillés courts) et du moment issu de la force centrifuge qui fait plier la pale (trait en pointillés longs). La somme des deux est représentée en trait noir ; Ces calculs sont réalisés pour $C_Y=C_C^{EAV}$ = 1 et pour $\theta_0$ = 0° puisque l'on a vu plus tôt que c'était l'angle de calage initial rigide optimal. Si $\frac{\partial^3 \theta}{\partial s^3}$ est positif, alors cela augmente l'angle de calage, si $\frac{\partial^3 \theta}{\partial s^3}$ est négatif, alors cela diminue l'angle de calage ; toutes ces figures sont tracées pour la loi de pales minces $C_{L1}$ = 1,49 et $C_{D1}$ =1,25 et pour une vitesse incidente de vent U = 10m.s$^{-1}$ et pour $\Lambda$ = 0.2 (première colonne), $\Lambda$ = 0.9 (deuxième colonne), $\Lambda$ = 2 (troisième colonne) ;

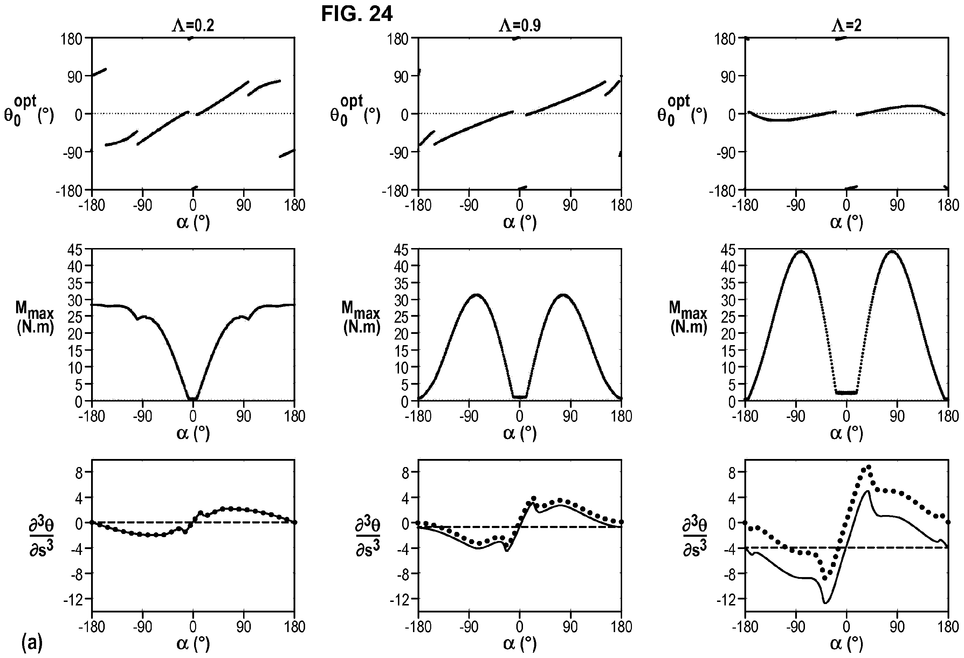

- la figure 24 montre en première rangée : évolutions de l'angle de calage optimum $\theta_0^{opt}$ d'une EAV à pales rigides, c'est-à-dire l'angle de calage qui maximise le moment aérodynamique (représenté à la deuxième rangée) à vitesse de rotation $\Omega$ fixée et donc qui optimise le rendement. Troisième rangée : évolution du moment issu des forces aérodynamiques qui fait plier la pale (trait en pointillés courts) et du moment issu de la force centrifuge qui fait plier la pale (trait en pointillés longs). La somme des deux est représentée en trait noir ; Ces calculs sont réalisés pour $C_Y=C_C^{EAV}$ =1 et pour $\theta_0$ = 0° puisque l'on a vu plus tôt que c'était l'angle de calage initial rigide optimal. Si $\frac{\partial^3 \theta}{\partial s^3}$ est positif, alors cela augmente l'angle de calage, si $\frac{\partial^3 \theta}{\partial s^3}$ est négatif, alors cela diminue l'angle de calage ; toutes ces figures sont tracées pour la loi inspirée des NACA 0012 et pour une vitesse incidente de vent U = 10 m.s$^{-1}$ et pour $\Lambda$ = 0.2 (première colonne), $\Lambda$ =0.9 (deuxième colonne), $\Lambda$ =2 (troisième colonne) la loi inspirée des NACA 0012 et pour une vitesse incidente de vent U = 10 m.s$^{-1}$ et pour $\Lambda$ = 0.2 (première colonne), $\Lambda$ =0.9 (deuxième colonne), $\Lambda$ =2 (troisième colonne) ;

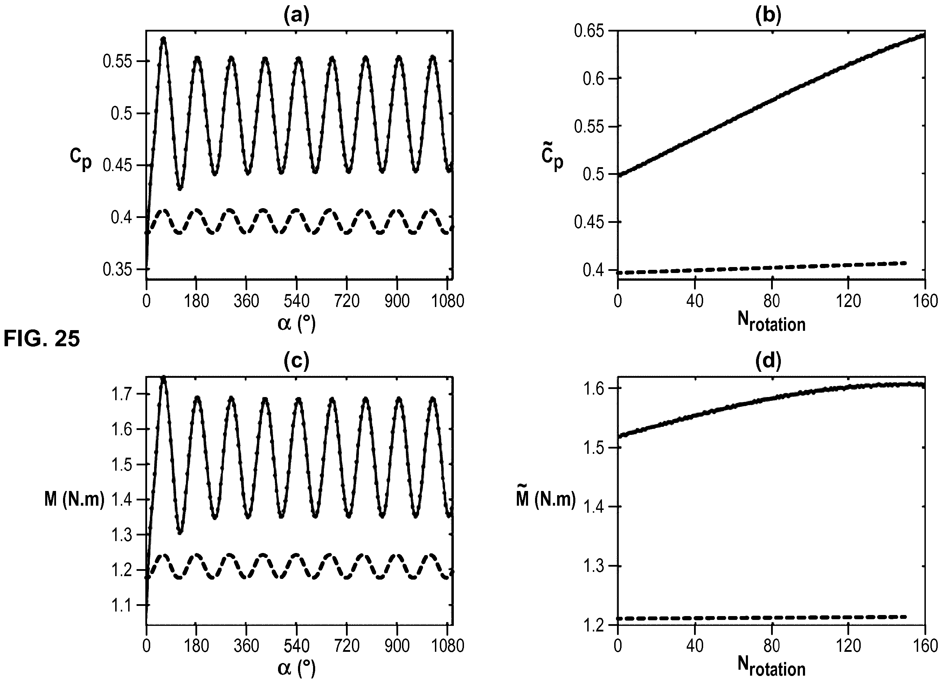

- la figure 25 représente des évolutions (a) du rendement $C_P$, (b) du rendement moyen par tour $\tilde{C}_P$ (c) du moment aérodynamique M, et (d) du moment aérodynamique par tour M de l'EAV munie de pales rigides B = 10000 N.m $C_Y$ = 1.20 10$^{-4}$ et $C_C$ = 1.38 10$^{-4}$ (trait en pointillés) et de l'EAV munie de pales flexibles B = 10 N.m, soit $C_Y$ = 0.12 et $C_C$ = 0.138 (trait plein) en fonction de l'angle azimutal $\alpha$ (figures (a,c)) et en fonction du nombre de rotations $N_{rotation}$ ; les deux éoliennes sont initialement lancées à une fréquence de rotation f = 3 Hz pour un couple résistant C = 1.1745 N.m et une vitesse incidente de vent U = 4 m.s$^{-1}$, un moment d'inertie J = 4.5 kg.m$^2$; l'angle de calage initial optimal $\theta_0$ est calculé et telle sorte que lorsque le vent effectif V est parallèle à la pale (il n'y a donc que la force centrifuge qui joue sur la déformation de la pale flexible), l'angle de calage moyen soit égal a 0 ; $\theta_0$ = 0° pour les pales rigides et $\theta_0$ = 2.74° pour les pales flexibles ;

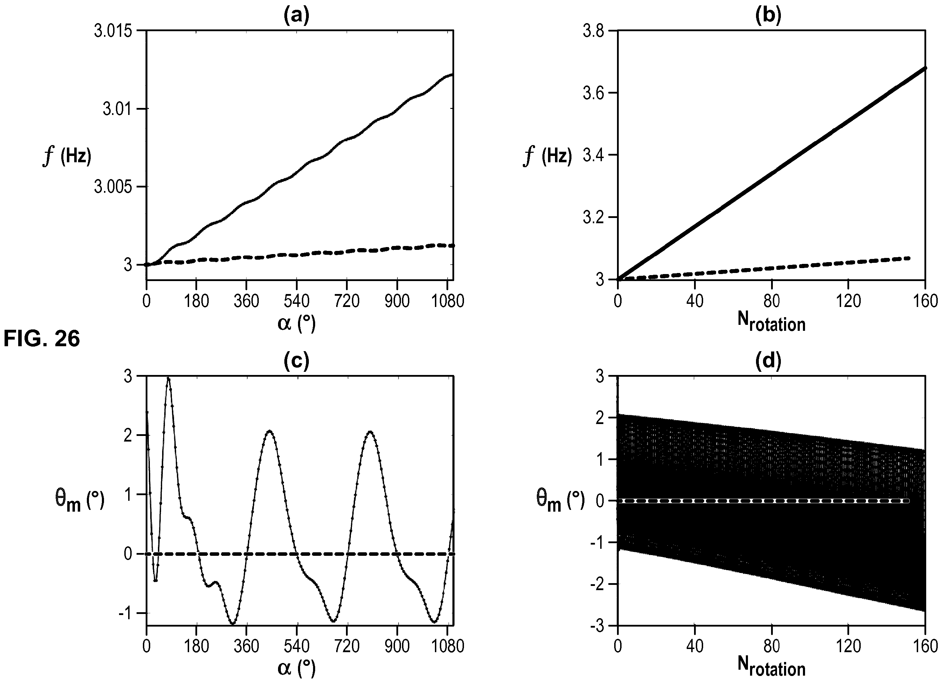

- la figure 26 représente des évolutions (a,b) de la fréquence de rotation f et (c,d) de l'angle de calage moyen $\theta_M$ de l'EAV munie de pales rigides B = 10000 N.m $C_Y$ = 1.20 10$^{-4}$ et $C_C$ = 1.38 10$^{-4}$ (trait en pointillés) et de l'EAV munie de pales flexibles B = 10 N.m, soit $C_Y$ = 0.12 et $C_C$ = 0.138 (trait noir) en fonction de l'angle azimutal $\alpha$ (figures (a,c)) et en fonction du nombre de rotations $N_{rotation}$ ; les deux éoliennes sont initialement lancées à une fréquence de rotation f = 3 Hz pour un couple résistant C = 1.1745 N.m et une vitesse incidente de vent U = 4 m.s$^{-1}$, un moment d'inertie J = 4.5 kg.m$^2$ ; l'angle de calage initial optimal $\theta_0$ est calculé et telle sorte que lorsque le vent effectif **V** est parallèle à la pale (il n'y a donc que la force centrifuge qui joue sur la déformation de la pale flexible), l'angle de calage moyen soit égal à 0 ; $\theta_0$ = 0° pour les pales rigides et $\theta_0$ = 2.74° pour les pales flexibles ;

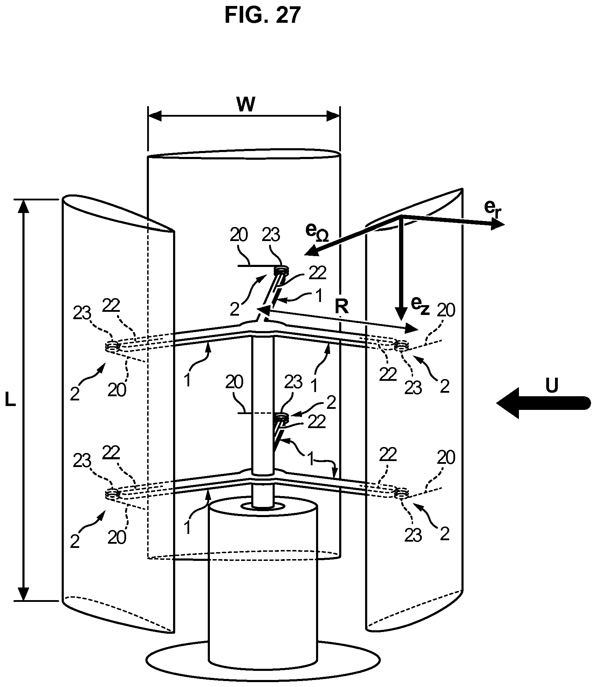

- la figure 27 représente une éolienne à axe de rotation vertical avec ressorts de torsion entre les bras et les pales rigides ;

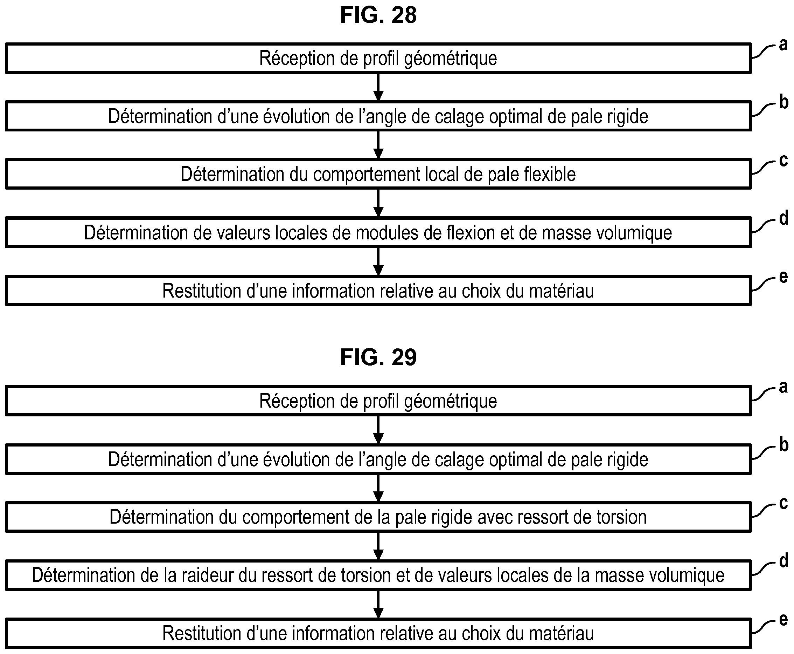

- la figure 28 illustre un organigramme d'une première mise en œuvre du procédé de conception selon l'invention ; et,
- la figure 29 illustre un organigramme d'une deuxième mise en œuvre du procédé de conception selon l'invention.

## DESCRIPTION DETAILLEE

Bien que dans tout ce qui suit, l'exemple de pales d'éoliennes va être décrit, les enseignements de l'invention ne sauraient se limiter à cette seule application. L'homme de l'art comprend en effet que le procédé de conception décrit peut également s'appliquer aux pales d'hydroliennes ou aux pales d'hélices aéronautiques (rotors de drones et/ou d'hélicoptère) avec les mêmes avantages.

La présente éolienne est dite prédéfinie au sens où elle est caractérisée à l'avance par son design (la forme du rotor, le nombre, la forme, l'orientation et la taille des pales), mais aussi par sa génératrice (qui détermine le couple résistant en fonction de la fréquence de rotation de l'éolienne).

*Caractéristiques générales d'une pale, notamment une pale rigide de référence*

Comme illustré sur la figure 1, la géométrie d'une pale profilée est déterminée par une cambrure (selon la direction z), une envergure (selon la direction y) et une corde (selon la direction x). La cambrure définit une épaisseur de pale d'éolienne qui peut être variable suivant la direction de l'envergure et de la corde. La longueur de corde peut également être variable suivant la direction de l'envergure.

R représente le rayon du bout de pale, i.e. la distance entre le bout de la pale et le rotor, suivant l'envergure.

r représente une valeur du rayon compris entre 0 et R.

De plus, comme décrit précédemment, et comme illustré sur la figure 2, on peut définir, en toute section de l'aile le long de l'envergure, deux paramètres d'une pale située dans un écoulement de fluide à la vitesse U : l'angle d'attaque $\beta$ et l'angle de calage $\theta$.

Dans ce qui suit, on choisit l'angle d'attaque $\beta_0$ et l'angle de calage $\theta_0$ respectivement l'angle d'attaque et de calage considérés en bout de pale. La connaissance de ces angles considérés en bout de pale suffisant à la connaissance de l'ensemble de la géométrie de la pale si le taux de vrillage est connu.

$\theta_{0\,rigide}$ représente l'angle de calage rigide pour une pale rigide de référence non vrillée (i.e. uniforme sur toute la pale, le même en bout et en pied de pale).

Dans le cas où la pale rigide de référence est vrillée, $\theta_{0\,rigide}$ représente l'angle de calage rigide en bout de pale. Et dans ce cas on a $\theta_{0\,opt\,rigide}\,(x,y)$.

L'expression ' pale rigide de référence' utilisée dans toute la demande de brevet désigne une pale rigide qui ne peut pas tourner autour de son envergure, qui est fixée au bras sans possibilité de mouvement par rapport au bras, et qui présente un angle de calage donné optimal.

Pour une pale flexible ou une pale articulée dont on va permettre la rotation autour de son envergure, $\theta$ représente l'angle de calage local, en un point donné de la pale de coordonnées (x,y).

$\theta_{0\,eff}$ représente la moyenne sur la pale de l'angle de calage local $\theta$ (intégré suivant x et y).

Dans la suite, on propose une procédure pour ajuster l'angle de calage $\theta_{0\,eff}$ de la pale flexible ou de la pale articulée avec l'angle de calage optimal $\theta_{0\,opt\,rig}$ (pour lequel le rendement Cp est optimisé).

Par extension on peut chercher les caractéristiques locales de la pale flexible (module de Young, masse volumique, épaisseur) ou de celles la pale rigide articulée à un bras de l'éolienne par un ou plusieurs ressorts de torsion (masse volumique pale rigide et ressort de torsion), en chaque point de la pale pour ajuster l'angle de calage local $\theta$, avec l'angle de calage optimal rigide local (par exemple dans le cas d'une pale vrillée), comme décrit précédemment.

Comme expliqué précédemment, on définit un paramètre d'éolienne $\lambda$, vitesse spécifique considéré en bout de pale, comme le rapport entre la vitesse considérée en bout de pale et la vitesse du fluide incident. Ainsi on a :

$$\lambda = \frac{R\Omega}{U},$$ où R est le rayon du centre du rotor en bout de la pale, $\Omega$ sa vitesse de rotation, et U la vitesse du fluide incident.

Une des principales raisons a la perte de rendement pour des valeurs de vitesse spécifique $\lambda$ plus petites ou plus grandes que la vitesse spécifique optimale $\lambda_{max}$ vient du fait que l'angle d'attaque $\beta$ dans le référentiel tournant attaché aux pales qui maximise l'énergie extraite dans la veine de fluide dépend de la vitesse du fluide U et de la vitesse de rotation $\Omega$ de l'éolienne et donc de $\lambda$.

Ainsi, il existe pour chaque valeur de $\lambda$ une valeur optimale de l'angle d'attaque $\beta_0$ du vent sur la pale en bout de la pale, pour un profil et une géométrie de pale donné, et par là même il existe une valeur optimale de l'angle de calage $\theta_0$ considéré en bout de pale de la pale qui maximise, pour ce profil et cette géométrie de pale donné, le rendement de l'éolienne.

L'angle de calage initial $\theta_{0\,ini\,rigide}$ d'une pale rigide de référence est généralement choisi comme la valeur optimale de l'angle de calage, à la vitesse spécifique optimale $\lambda_{max}$ de l'éolienne. A cet égard un procédé de conception d'une pale rigide de référence connu comprend une étape préalable de détermination d'une vitesse spécifique optimale $\lambda_{max}$ de l'éolienne en fonction des données météorologiques du lieu d'implantation de ladite éolienne. Un tel procédé comprend en outre une étape de détermination d'un angle de calage initial $\theta_{0\,ini\,rigide}$ optimal qui maximise le rendement de l'éolienne à la vitesse spécifique optimale $\lambda_{max}$ préalablement déterminée. Si l'éolienne est munie de systèmes de capteurs et de moteurs comme précédemment décrits, un tel procédé comprend enfin la détermination d'une évolution de l'angle de calage optimal $\theta_{0\,opt\,rigide}$ qui maximise le rendement de l'éolienne pour des valeurs de vitesse spécifiques $\lambda$ différentes de la vitesse spécifique optimale $\lambda_{max}$ préalablement déterminée.

La courbe fournissant l'évolution de l'angle de calage optimal $\theta_{0\,opt\,rigide}$ qui maximise le rendement de l'éolienne pour des valeurs de vitesse spécifiques $\lambda$ différentes de la vitesse spécifique optimale $\lambda_{max}$ peut être déterminée expérimentalement ou par la simulation numérique. De façon générique, l'évolution de l'angle de calage optimal $\theta_{0\,opt\,rigide}$ est une fonction décroissante de la vitesse spécifique $\lambda$. La figure 3 fournit un exemple d'évolution de la valeur de l'angle de calage optimal $\theta_{0\,opt\,rigide}$ en fonction de la vitesse spécifique $\lambda$.

On comprend, à l'analyse de cette évolution, que pour atteindre un rendement élevé sur toute la gamme de fonctionnement de l'éolienne, l'angle de calage $\theta_0$ doit varier en fonction de la vitesse de rotation de l'éolienne $\Omega$. Dans les procédés de conception de pales d'éoliennes rigides selon l'art antérieur, cette évolution n'est pas prise en compte. L'angle de calage $\theta_0$ varie en effet au moyen de moteurs et capteurs, comme décrits précédemment.

*Caractéristiques d'une pale d'éolienne flexible*

Il est proposé un procédé qui permet de concevoir une pale d'éolienne flexible dont le calage effectif varie dynamiquement avec la vitesse spécifique $\lambda$ de façon à améliorer le rendement de l'éolienne sur une large gamme de vitesse spécifique $\lambda$, autour de la vitesse spécifique optimale $\lambda_{max}$.

Ce procédé utilise l'élasticité conféré par le caractère flexible de la pale. Une pale flexible peut en effet se déformer selon la corde mais pas suivant l'envergure, puisque l'axe de la pale est maintenu rigide. On comprendra dans la suite par « pale flexible », une pale dont la déformation suivant la corde est suffisamment grande pour modifier l'aérodynamisme autour de l'éolienne et donc le rendement de l'éolienne (par exemple d'au moins 0,5%) par rapport à une éolienne à pales rigides.

La pale est flexible en raison du rapport des forces qui agissent sur la pale et de la rigidité de pale, mais aussi des conditions aux limites (inhomogénéité de la pale par exemple).

Un matériau constituant une pale est donc caractérisé par un module de flexion B et une masse volumique $\rho$.

L'angle de calage effectif $\theta_{0eff}$ d'une pale flexible, évolue sous l'action conjointe du fluide et de la force centrifuge.

En effet, sous l'effet du fluide la pale flexible se plie et augmente ainsi l'angle de calage effectif $\theta_{0eff}$. La force centrifuge va, quant à elle, ramener la pale dans le plan de rotation. L'angle de calage effectif $\theta_{0eff}$ diminue donc sous l'effet de la force centrifuge lorsque l'éolienne tourne suffisamment vite. Ainsi, une pale flexible se déforme de telle façon que l'angle de calage effectif $\theta_{0eff}$ est une fonction décroissante de la vitesse spécifique $\lambda$.

En choisissant convenablement les matériaux constituant la pale flexible, il est possible d'ajuster le taux de variation de l'angle de calage effectif $\theta_{0eff}$ avec la vitesse spécifique $\lambda$ autour du point de fonctionnement, et améliorer ainsi les performances de l'éolienne. En effet, plus le module de flexion B est petit, plus la pale est en mesure de se déformer. Plus la masse volumique $\rho$ est grande, plus la force centrifuge (qui tend à ramener l'angle de calage effectif $\theta_{0eff}$ vers 0°) va prendre de l'importance.

*Comparaison du comportement entre une pale flexible et une pale rigide de référence valable pour une éolienne à axe horizontal de rotation.*

On va maintenant illustrer le comportement comparatif entre une pale flexible et une pale rigide de référence. Il est à noter que les résultats présentés ci-dessous sont issus d'expériences réelles, effectuées en soufflerie, sur des modèles réduits. Comme illustrée sur la figure 4a, l'éolienne expérimentale possède trois pales de longueur d'envergure totale L = 10 cm, de longueur totale de corde W = 4,5 cm. Ici $W_f$=4 cm. $W=W_f+W_{rigide}$=4+0,5. Le frein à poudre magnétique 10 sert à simuler l'extraction d'énergie dans la veine de fluide circulant à une vitesse U autour de l'éolienne tournant à une vitesse de rotation $\Omega$. Le rayon total de l'éolienne vaut R = 14,6 cm.

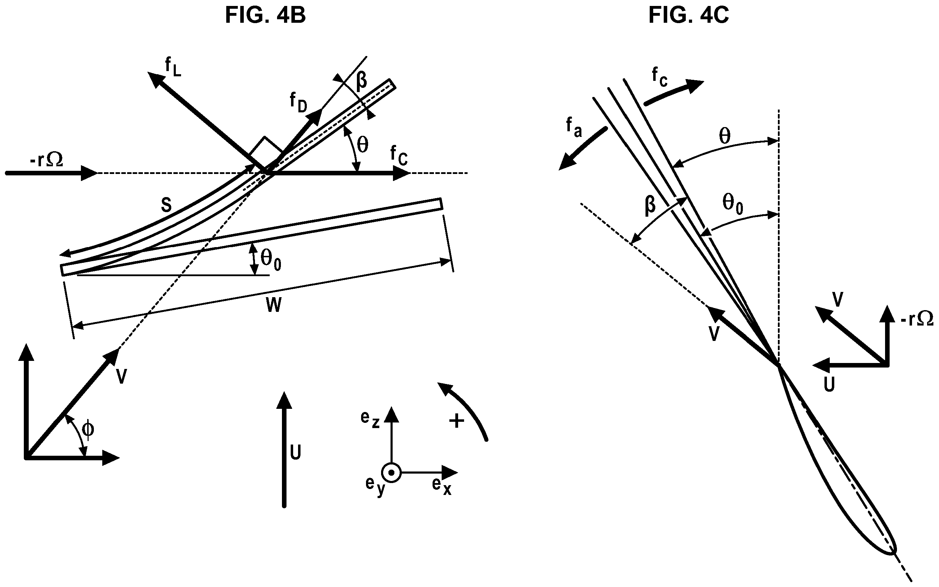

La figure 4b constitue un schéma d'une section orthoradiale de pale, en un rayon r donné de l'éolienne. La section de pale possède une vitesse dans le référentiel statique du rotor valant $r\Omega$. On définit par ailleurs une abscisse curviligne s le long de la corde W. La cambrure possède une forme simple qui se réduit ici à une épaisseur constante h. Sans forçage du fluide (i.e. sans rotation ni vitesse de vent), l'ensemble de la section de pale possède un angle de calage au repos $\theta_0$ valant 28°. Avec forçage du fluide, la pale se déforme avec un angle de calage en fonctionnement $\theta$, sous l'action conjointe de la force centrifuge fc et de la force aérodynamique du fluide (force de portance $f_L$ et de traînée $f_D$) qui fait un angle d'attaque $\beta$ avec la direction de la vitesse relative de fluide incident V, qui est décale d'un angle $\varphi$ avec la vitesse dans le référentiel statique du rotor.

La figure 4c illustre un profil d'une telle pale en fonctionnement pour trois valeurs différentes de vitesse spécifique $\lambda$. Le profil du milieu montre la situation de référence (sans forçage), sans rotation ni vitesse de vent et l'angle de calage au repos $\theta_0$ vaut 28°. Les deux profils de part et d'autre du profil en situation de référence montrent les pales déformées, respectivement pour une valeur de vitesse spécifique $\lambda$ valant 0,25 (la valeur de l'angle de calage en fonctionnement $\theta$ valant alors 30,8°) et pour une valeur de vitesse spécifique $\lambda$ valant 2,35 (la valeur de l'angle de calage en fonctionnement $\theta$ valant alors 25,3°).

On constate dans ces exemples, que la pale se plie dans un sens ou dans l'autre selon le régime de fonctionnement, c'est-à-dire selon que la force aérodynamique ou la force centrifuge domine.

Dans cet exemple, à titre purement illustratif, les pales flexibles sont des plaques de Mylar fixées à un bras rigide. Ainsi tenues, les pales se déforment principalement selon la corde. La flexibilité est modifiée en changeant l'épaisseur des pales. Ces jeux de pales sont comparés à des pales rigides en résine.

Dans un premier temps, l'angle de calage $\theta_0$ des pales au repos, la vitesse du fluide U, et le couple résistant C qui simule l'extraction d'énergie, sont prises comment variant dans une large plage de fonctionnement. La déformation des pales et la vitesse de rotation $\Omega$ de l'éolienne sont mesurées. De là, sont déduits une puissance et un rendement Cp tels que :

$$C_p = \frac{C\Omega}{0{,}5\rho_{air}U^3\pi R^2}$$

où $\rho_{air}$ est la masse volumique de l'air et R est le rayon de l'éolienne. Cp est le ratio entre la puissance extraite au fluide par l'éolienne et la puissance aérodynamique disponible sur l'aire balayée par les pales.

On constate déjà que, même pour un modèle d'éolienne simplifié, des pales flexibles permettent d'élargir la gamme de fonctionnement par rapport à des pales rigides. Les figures 5a à 5c illustrent en effet le rendement Cp en fonction du rapport de la vitesse spécifique $\lambda$ et du couple résistant C.

Sur les figures 5a à 5c, on distingue trois courbes fournissant l'évolution du rendement Cp de l'éolienne simplifiée étudiée, ayant un axe horizontal de rotation, en fonction :

- pour la courbe (a), de la vitesse spécifique $\lambda$,
- pour la courbe (b), du couple résistant (adimensionné) C*, et
- pour le courbe (c) de la vitesse de fluide U pour un couple résistant fixe C = 90.9mN.m et un angle de calage $\theta_0$ de 30°.

Cette évolution est mesurée pour :

- un système F1 où l'angle de calage $\theta_0$ vaut 28° et les pales sont en Mylar d'une épaisseur de 250$\mu$m, et
- des pales rigides (RB) pour différents angles de calage ($\theta_0$= 20°, 24°, 28° and 32°).

Pour les courbes (a) et (b), les mesures sont faites pour une vitesse de fluide fixe U de 13 m.s$^{-1}$ en faisant variant le couple résistant C.

La courbe (c) est tracée pour tous les systèmes RB, F1 et F2 (pales de Mylar d'une épaisseur de 125$\mu$m). La courbe (c) illustre notamment qu'une flexibilité modérée permet à l'éolienne de démarrer plus tôt.

Les données représentées correspondent à une vitesse de fluide U fixe et un couple résistant C variable. Les grandes valeurs de couple résistant correspondent donc à de petites valeurs de vitesse spécifique À.

Les figures 5a à 5c permettent donc de comparer le rendement obtenu avec un « meilleur » système (des pales de Mylar de 250 $\mu$m d'épaisseur et un angle de calage $\theta_0$ de 28°), aux rendements obtenus pour les pales rigides avec des angles de calage $\theta_0$ variant de 20 à 32°. Le meilleur rendement pour les pales rigides est obtenu pour un angle de calage $\theta_0$ de 28°. Les pales flexibles avec un angle de calage $\theta_0$ également de 28° permettent d'obtenir le même rendement optimum au même point de fonctionnement $\lambda_0$.

Les figures 5a à 5c illustrent également que lorsqu'on s'éloigne du point optimum de fonctionnement, les pales flexibles permettent d'obtenir un meilleur rendement. Sur la totalité de la plage de fonctionnement, le gain est de 35%. A grande vitesse de rotation ou grand couple résistant, il faut diminuer (24°) ou augmenter (32°) l'angle de calage des pales rigides pour obtenir des rendements comparables à celui obtenue avec les pales flexibles. Ces valeurs correspondent aux angles mesurés pour ces régimes de fonctionnement, sur les pales déformées par le fluide et la rotation. La flexibilité des pales peut améliorer le rendement mais aussi permet à l'éolienne de démarrer pour une plus faible vitesse de vent que lorsqu'elle est dotée de pales rigides.

*Exemple de mise en œuvre*

Il est proposé de concevoir une pale d'éolienne flexible pour laquelle on détermine les propriétés de matériau de sorte à optimiser l'adaptation de l'angle de calage effectif $\theta_{0eff}$ avec la vitesse spécifique $\lambda$. L'objectif est de déterminer le module de flexion B et la masse volumique $\rho$ de la pale flexible de sorte à s'ajuster au mieux l'évolution de l'angle de calage $\theta_0$ optimal en fonction de la vitesse spécifique $\lambda$.

A titre d'exemple, de manière purement illustrative, cette détermination est telle que, en fonctionnement, l'angle de calage effectif $\theta_{0eff}$ ne varie pas au-delà de 6°, par rapport à une valeur de l'angle de calage de la pale obtenue pour une position de la pale au repos.

A titre d'exemple non limitatif, il est possible de concevoir une pale de matériau inhomogène. Cette inhomogénéité peut concerner aussi bien le module de flexion B, que la masse volumique de la pale $\rho$. Plus particulièrement ce matériau peut comprendre des inserts plus denses n'importe où sur la corde, mais plus avantageusement en bout de corde pour pouvoir augmenter l'effet de la force centrifuge sans trop alourdir la pale, et en conservant un profil géométrique fixé.

En référence à la figure 28, le procédé de conception comprend par exemple les étapes suivantes :

a) réception d'un profil géométrique donné d'une pale d'éolienne rigide, ledit profil comprenant les éléments suivants :

◦ des données caractéristiques de la cambrure (évolution de l'épaisseur de pale le long de l'envergure par exemple),
◦ des données caractéristiques de l'envergure (longueur totale par exemple),
◦ des données caractéristiques de la corde (évolution de la corde le long de l'envergure par exemple),
◦ un angle de calage initial de pale $\theta_{0\,ini\,rigide}$, et

détermination, pour ledit profil géométrique appliqué à une pale rigide de référence, d'une évolution de l'angle de calage optimal de la pale rigide de référence $\theta_{0\,opt\,rigide}$ en fonction :

◦ de la vitesse spécifique $\lambda$ égale au rapport entre la vitesse considérée en bout de pale et la vitesse de fluide incident, pour un régime de vitesses du fluide s'écoulant autour de la pale rigide de référence, pour une première catégorie d'éoliennes/hydroliennes dite à axe horizontal de rotation et pour lesquelles la direction de vent U est orthogonale au plan de rotation de la pale,
◦ de la vitesse spécifique $\lambda$ et d'un angle $\alpha$, $\alpha$ étant l'angle de rotation de la pale autour de l'axe pour une deuxième catégorie d'éoliennes/hydroliennes dite à axe vertical de rotation, ou à axe de rotation horizontal quand la vitesse de vent U n'est pas orthogonale au plan de rotation de la pale,

b) détermination du comportement local de la pale flexible, se déformant d'une part sous l'effet du chargement aérodynamique du fluide circulant autour de pale flexible, et d'autre part de la force centrifuge qui s'exerce sur la pale flexible en rotation, et détermination de ratios locaux relatifs au chargement aérodynamique et à la force centrifuge s'exerçant sur la pale flexible,

c) détermination de valeurs locales de module de flexion B et de masse volumique $\rho$, à l'aide des ratios locaux et du comportement de la pale flexible déterminés à l'étape c), de sorte que l'évolution d'un angle de calage effectif $\theta_{0eff}$ de la pale flexible, conféré par la flexibilité au moins selon la corde de la pale flexible, en fonction de la vitesse spécifique $\lambda$, corresponde à l'évolution déterminée à l'étape précédente b), et

d) restitution d'une information relative au choix du matériau, déterminée à partir des valeurs locales de module de flexion B et de masse volumique $\rho$ calculés à l'étape d) et du profil géométrique reçu à l'étape a).

Avantageusement, la pale flexible est considérée comme flexible selon l'envergure.

L'étape a) est connue en soi. La détermination d'un profil géométrique de pale d'éolienne rigide qui maximise le rendement de l'éolienne à un point de fonctionnement prédéterminé, peut être effectuée par diverses méthodes connues de l'homme de l'art.

L'étape b) peut être effectuée par simulation numérique, selon des méthodes également connues, ou par expérimentations, par exemple sur une maquette de pale d'éolienne rigide présentant le profil géométrique reçu à l'étape a).

Lors de l'étape b), on détermine la valeur optimale de vitesse spécifique $\lambda_{max\,rigide}$ pour lequel le rendement $C_p$ de l'éolienne ou hydrolienne à pales rigides avec le même profil géométrique reçu à l'étape a) est maximum. Par suite, il est déduit, à l'aide de l'évolution de l'angle de calage optimal de pale rigide de référence $\theta_0^{opt\,rigide}$, le point de fonctionnement optimum maximum $[\theta_{0\,opt\,max\,rigide}, \lambda_{max\,rigide}]$. En tout état de cause, les étapes c) et d) doivent être effectuées pour une pale flexible servant dans les mêmes conditions que celles qui ont servi à obtenir l'évolution déter-

**EP 3 583 312 B1**

minée à l'étape b), notamment en termes de vitesse de fluide incident, de rotation des pales, de couple résistant du rotor, et de proportionnalité entre couple résistant et vitesse de rotation du rotor.

Pour des profils géométriques de pale « réelle », la détermination du comportement d'une pale flexible, de ratios relatifs à la charge aérodynamique, et à la force centrifuge s'exerçant sur la pale flexible, et des modules de flexion B ainsi que de la masse volumique ρ en tous points de la pale qui permettent à la pale d'effectuer une adaptation passive de son angle de calage, ne peut se faire par résolution analytique. Les équations dynamiques doivent, dans ce cas, être résolues localement de manière numérique.

Les étapes c) et d) peuvent être mises en œuvre par tout système, unité ou module de calcul, qu'il s'agisse de produit programme ordinateur ou de dispositif physique comme un processeur d'ordinateur, un contrôleur ou tout autre dispositif de logique informatique. Les instructions correspondant à ces étapes de détermination peuvent quant à elles être stockées sur des dispositifs de stockage informatique comme un disque dur d'ordinateur (ROM, RAM), ou des disques de stockage amovibles de type USB.

Les données relatives au profil géométrique reçu lors de l'étape a), ou les informations relatives au matériau restituées à l'étape e), tout comme les instructions de calcul, peuvent être transmises directement aux dispositifs de calcul, via des dispositifs de stockage amovibles ou directement depuis la mémoire des dispositifs de calcul, ou via des dispositifs de transfert à distance, comme une liaison internent Bluetooth, ou une liaison Wi-Fi.

A titre d'exemple non limitatif, il est possible d'assimiler les pales conçues à une série de poutres flexibles, ou à une plaque flexible. Cette modélisation permet de résoudre analytiquement les équations dynamiques qui régissent l'adaptation passive de l'angle de calage de la pale flexible.

*Mise en œuvre pour une pale flexible assimilée à une série de poutres flexibles encastrées dans une tige rigide radiale pour une éolienne à axe horizontal de rotation.*

En première approximation, il est possible d'assimiler une pale flexible à une série de poutres d'épaisseur h encastrée dans une tige rigide radiale (selon l'envergure), de longueur de corde $W_f$, la poutre étant prise comme une section orthogonale à l'envergure, à une distance r du centre du rotor.

A petite vitesse de rotation le fluide pousse sur la pale et augmente l'angle de calage effectif $\theta_{0\,eff}$. Cela permet également aux éoliennes dotées de pale flexibles de démarrer pour une plus faible vitesse de vent que des éoliennes à pales rigides, comme il sera décrit ci-après. A grande vitesse de rotation, c'est la force centrifuge qui domine et tend à ramener la pale dans le plan de rotation (vers un angle de calage effectif $\theta_{0\,eff}$ de 0°) ce qui retarde la vitesse spécifique λ critique pour lequel la direction de fluide apparent est parallèle à la pale et la force aérodynamique utile est nulle.

Dans la limite des petites déformations, l'équation déterminant le comportement de la tige selon la corde se déformant d'une part sous l'effet du chargement aérodynamique du fluide circulant autour de la pale, et d'autre part de la force centrifuge qui s'exerce sur en rotation est la suivante :

$$\frac{\partial^3 \theta}{\partial s^3} = C_y(1 + \lambda^2)\big[C_L\big(\beta(s)\big)\cos\big(\beta(s)\big) + C_D\big(\beta(s)\big)\sin\big(\beta(s)\big)\big]$$

$$- C_C\lambda^2\sin\big(\theta(s)\big)\int_0^s \cos\big(\theta'(s)\big)\,ds'$$

où θ est l'angle de calage de la tige à la distance r du centre du rotor considérée, s la coordonnée curviligne adimensionnée dans la direction de la corde, λ est la vitesse spécifique de la tige, β est l'angle d'attaque de la tige, et $C_L$ et $C_D$ sont respectivement les coefficients de trainée et de portance. Ces derniers coefficients dépendent du régime d'écoulement et de la géométrie de la pale.

Cette équation doit satisfaire les conditions aux limites $\theta(0) = \theta_0$ et $\theta(1) = 0$. Par ailleurs, cette équation met en évidence deux ratios $C_Y$ et $C_C$ relatifs au chargement aérodynamique et à la force centrifuge s'exerçant sur la pale flexible. On appelle ces ratios respectivement nombre de Cauchy et nombre centrifuge tels que :

$$C_y = \frac{\rho_{fluide}U^2 W\mathfrak{f}^3}{2B}$$

et

$$C_C \lambda^2 = \frac{\rho \Omega^2 h W f^4}{B}$$

Pour une pale homogène, le module de flexion B et la masse volumique $\rho$ sont constants mais ces coefficients peuvent dépendre de la distance au rotor r et de l'abscisse curviligne adimensionnée s.

Ainsi, les étapes c) et d) consistent ici en la résolution de l'équation ci-dessus, dont les paramètres libres sont l'angle de calage initial $\theta_{0\,eff\,ini}$ sans rotation ni vitesse de vent, le module de flexion B, et la masse volumique $\rho$. On peut ainsi déterminer le matériau de module de flexion B et de densité $\rho$, ou la disposition de matériaux, qui optimisent le rendement. Ainsi la pale flexible à une dimension considérée possède un comportement qui s'ajuste au mieux à l'évolution de l'angle de calage optimal $\theta_{0\,opt\,rigide}$ de pale en fonction de la vitesse spécifique $\lambda$ autour de la vitesse spécifique optimale $\lambda_{max}$ déterminée à l'étape b), et qui maximise le rendement d'une éolienne comprenant une telle pale lorsqu'elle est placée dans un fluide à la vitesse spécifique $\lambda$.

A titre illustratif, on a représenté sur la figure 6, un exemple d'évolution de l'angle de calage effectif moyen $\theta_{0\,eff}$ sur toute la pale d'une éolienne à axe horizontal de rotation en fonction de la vitesse spécifique $\lambda$ pour des coefficients dynamiques issus de la théorie d'écoulement potentiels, où le coefficient de traînée $C_L$ est tel que : $C_L = \pi \sin(\beta)$ et $C_D$ égal à 0. La ligne noire représente alors le cas rigide où l'angle de calage est constant avec la vitesse spécifique $\lambda$. La ligne de pointillées longs correspond au cas où le nombre de Cauchy $C_Y$ vaut 0,54, et le nombre centrifuge $C_C$ vaut 0,51. La ligne de pointillées courts correspond au cas où le nombre de Cauchy $C_Y$ vaut 1,08, et le nombre centrifuge $C_C$ vaut 1,02. La ligne de pointillées alternés longs et courts correspond au cas où le nombre de Cauchy $C_Y$ vaut 0,54, et le nombre centrifuge $C_C$ vaut 2,04. Pour une tige idéale, à faible angle d'attaque $\beta$, les coefficients de traînée et de portance sont bien décrits par les lois $C_D = 0$ et $C_L = \pi \sin(\beta)$.

La figure 6 montre donc différentes courbes de l'angle de calage effectif moyen $\theta_{0\,eff}$ effectif en fonction de la vitesse spécifique $\lambda$. Ces courbes présentent des variations différentes de l'angle de calage en fonction de la vitesse spécifique $\lambda$ autour de la vitesse spécifique optimale $\lambda_{max}$ obtenues en modifiant les valeurs des nombres de Cauchy et centrifuge $C_y$ et $C_c$, c'est à dire le moment de flexion B, la densité $\rho$. L'angle de calage au repos $\theta_{0\,eff\,ini}$ (i.e. sans rotation ni vitesse de vent) a été ajusté de manière à ce que, en fonctionnement, le point de fonctionnement effectif maximum $[\theta_{0\,eff\,max}, \lambda_{max}]$ de l'éolienne ayant ces pales flexibles, soit égal au point de fonctionnement optimum maximum $[\theta_{0\,opt\,max\,rigide}, \lambda_{max\,rigide}]$ de l'éolienne à pales rigides correspondante.

*Mise en œuvre pour une pale flexible assimilée à une plaque*

Il est également possible d'assimiler la pale flexible à une plaque flexible encastrée dans une tige rigide radiale (selon l'envergure), dont les équations de déformation sont fournies par la théorie des plaques de Krichhof-Love, de manière classique et connue de l'homme de l'art en mécanique des milieux continus.

L'équation déterminant le comportement de la plaque se déformant d'une part sous l'effet du chargement aérodynamique du fluide circulant autour de la pale, et d'autre part de la force centrifuge qui s'exerce sur en rotation est la suivante :

$$\nabla^2(B(x,y)\nabla^2 w(x,y,t)) = -q(x,y,t) - h(x,y)\rho(x,y)\frac{\partial^2 w(x,y,t)}{\partial t^2}$$

où B est le module de flexion, q le chargement des forces aérodynamique et centrifuge, h l'épaisseur de la plaque, $\rho$ la densité de la pale et w la déformation transverse de la pale. L'équation est écrite selon deux directions privilégiées de l'espace, x et y, correspondant aux dimensions de la plaque, et t marque l'évolution de la déformation en fonction du temps. Dans cette équation, le membre de gauche représentant la déformation de la plaque, et le membre de droite représentant le terme d'inertie.

Dans un mode de réalisation, les étapes c) et d) peuvent être effectuées par test systématique. Ainsi une multitude de jeux de paramètres ($\theta_0$, $C_y/U^2$, $C_C/U^2$) est testée. Les nombres de Cauchy et centrifuge $C_y$ et $C_C$ sont rapportés à la vitesse de fluide incident U au carré car cette vitesse varie. On cherche en effet à évaluer des valeurs constantes pour chaque courbe donnant l'évolution de l'angle de calage $\theta_0$ en fonction de la vitesse spécifique $\lambda$. Pour chaque jeu, la déformation moyenne de la pale $\theta_0$ est calculée grâce à l'équation de plaque présentée ci-dessus, en prenant pour coefficients de traînée et de portance $C_D$ et $C_D$ suivant : $C_L = 2\sin(\beta)\cos(\beta)$ et $C_D = 2\sin(\beta)^2 + 0.01$, avec $\beta$ l'angle d'attaque.

Chaque courbe donnant l'évolution la déformation moyenne effective de la pale $\theta_{0eff}$ en fonction de la vitesse spécifique $\lambda$ est comparée par la méthode des moindres carrés à l'évolution de l'angle de calage optimal $\theta_{0\,opt\,rigide}$ en fonction de la vitesse spécifique $\lambda$ autour de la vitesse spécifique optimale $\lambda_{max}$ déterminée à l'étape b), et qui maximise le rendement d'une éolienne comprenant une telle pale lorsqu'elle est placée dans un fluide à la vitesse spécifique λ. Ainsi, plus la valeur trouvée est faible et plus l'ajustement est adéquat.

L'étape d) utilise donc les valeurs optimales $(C_y/U^2)^{opt}$ et $(C_C/U^2)^{opt}$ déterminées lors de l'étape c) pour déterminer le matériau de la pale flexible. Comme il est trois inconnus (le module d'Young E, la masse volumique de la pale ρ, et h son épaisseur) pour deux équations, il faut fixer une des trois inconnues. Par exemple, à titre non limitatif, il est possible de fixer le module d'Young E. La détermination de l'épaisseur de la plaque h, puis de la masse volumique ρ est effectuée à l'aide des équations ci-dessous :

$$h = \left( \frac{\rho_{air} W f^3}{2E \left( \frac{C_y}{U^2} \right)^{opt}} \right)^{\frac{1}{3}}$$

$$\rho = \frac{R^2 h^2 E \left( \frac{C_C}{U^2} \right)^{opt}}{W f^4}$$

A titre purement illustratif, on décrit ci-dessous un exemple de procédé de conception pour une pale à deux dimensions schématisant une éolienne de rayon R = 20 mètres, à axe horizontal de rotation, de longueur de corde totale 1 mètre (dont seulement 90cm est flexible), tournant à une vitesse de 33 tours par minutes. Ces éléments correspondent à une partie des éléments reçus lors de l'étape a) du procédé de conception. L'étape b) est ensuite obtenue par simulation numérique.

Les étapes c) et d) telles que décrites précédemment sont effectuées. Les résultats de comparaison avec la méthode des moindres carrés sont illustrés sur la figure 7. Dans le cas d'espèce, les valeurs optimales déterminées sont $(C_y/U^2)^{opt} = 1.5 \ 10^{-2} \ s^2.m^{-2}$ et $(C_C/U^2)^{opt} = 3 \ 10^{-3} \ s^2.m^{-2}$ (point marqué sur la figure). La figure 8 illustre alors la comparaison entre la déformation de référence obtenue lors de l'étape b) et la déformation d'une pale flexible présentation les ratios optimaux déterminés à l'étape c).

Pour l'étape d), le module d'Young E est arbitrairement fixé, puis des valeurs d'épaisseur h de la pale et de masse volumique ρ sont déterminées. Des résultats d'une telle étape sont rassemblés dans le tableau ci-dessous.

| Test | E (Pa) | h (mm) | ρ (kg.m⁻³) |
|------|--------|--------|------------|
| 1 | $240 \ 10^9$ | 0.53 | $1.23 \ 10^5$ |
| 2 | $4 \ 10^9$ | 2.1 | $3.23 \ 10^4$ |
| 3 | $10^8$ | 7.1 | $9.22 \ 10^3$ |
| 4 | $10^7$ | 15.3 | $4.28 \ 10^3$ |
| 5 | $10^6$ | 33.0 | $1.99 \ 10^3$ |

Dans un autre mode de réalisation, la plaque est inhomogène. Comme illustré sur la figure 9, la plaque est alors constituée d'une partie flexible F, près de la tige, de longueur $W_f = 0,1$ mètre, et d'une partie rigide RB sur tout le reste de la pale, de longueur totale $W - W_f = 0,9$ mètre. La partie flexible fait donc ici office d'une charnière, et sa déformation est entièrement due aux forces qui agissent que la partie rigide. De plus, l'éolienne est de rayon R = 20 mètres, tournant à une vitesse de 33 tours par minute.

Les étapes c) et d) peuvent être effectuées par test systématique. Ainsi une multitude de jeux de paramètres $(\theta_0, C_y/U^2, C_C/U^2)$ est testée. Les nombres de Cauchy et centrifuge $C_y$ et $C_C$ sont rapportés à la vitesse de fluide incident U au carré car cette vitesse varie. On cherche en effet à évaluer des valeurs constantes pour chaque courbe donnant l'évolution de l'angle de calage $\theta_0$ en fonction de la vitesse spécifique λ. Pour chaque jeu, la déformation moyenne de la pale $\theta_0$ est calculée grâce à l'équation de plaque présentée ci-dessus, en prenant pour coefficients de traînée et de portance $C_D$ et $C_D$ suivant : $C_L = \pi \sin(\beta)$ et $C_D = 0$, avec β l'angle d'attaque.

Chaque courbe donnant l'évolution la déformation moyenne effective de la pale $\theta_{0eff}$ en fonction de la vitesse spécifique λ est comparée par la méthode des moindres carrés à l'évolution de l'angle de calage effectif $\theta_{0 \ opt \ rigide}$ en fonction de la vitesse spécifique λ autour de la vitesse spécifique optimale $\lambda_{max}$ déterminée à l'étape b), et qui maximise le rendement d'une éolienne comprenant une telle pale lorsqu'elle est placée dans un fluide à la vitesse spécifique λ. Ainsi, plus la valeur trouvée est faible et plus l'ajustement est adéquat.

Les résultats de comparaison avec la méthode des moindres carrés sont illustrés sur la figure 10. Dans le cas d'espèce, les valeurs optimales déterminées sont $(C_Y/U^2)^{opt} = 1\ 10^{-5}\ s^2.m^{-2}$ et $(C_C/U^2)^{opt}$ allant de $10^{-11}$ à $2\ 10^{-8}\ s^2.m^{-2}$ (points marqués sur la figure).

La figure 11 illustre alors la comparaison entre la déformation de référence obtenue lors de l'étape b) et la déformation d'une pale flexible présentation les ratios optimaux déterminés à l'étape c).

L'étape d) utilise donc les valeurs optimales $(C_Y/U^2)^{opt}$ et $(C_C/U^2)^{opt}$ déterminées lors de l'étape c) pour déterminer le matériau de la pale flexible.

La différence avec le cas de la pale homogène est qu'il y a ici deux épaisseurs différentes : d'une part $h_r$ est l'épaisseur de la partie rigide, et d'autre part $h_f$ est l'épaisseur de la partie flexible de la pale, et les nombres de Cauchy et centrifuge divisés par le carré de la vitesse de vent s'écrivent respectivement :

$$\left(\frac{C_Y}{U^2}\right)^{opt} = \frac{\rho_{air}W_f^3}{2B} = \frac{\rho_{air}W_f^3}{2Eh_f^3} \quad ; \quad \left(\frac{C_C}{U^2}\right)^{opt} = \frac{\rho h_r W_f^4}{R^2 B} = \frac{\rho h_r W_f^4}{R^2 Eh_f^3}.$$

Par la première équation on détermine le module de courbure de la partie flexible :

$$B = \frac{\rho_{air}W_f^3}{2\left(\dfrac{C_Y}{U^2}\right)^{opt}},$$

ainsi que la masse surfacique de la partie rigide :

$$\rho h_r = \frac{\left(\dfrac{C_C}{U^2}\right)^{opt} R^2 B}{W_f^4} = \frac{\left(\dfrac{C_C}{U^2}\right)^{opt} R^2 \rho_{air}}{\left(\dfrac{C_Y}{U^2}\right)^{opt} W_f}$$

Cela donne pour la partie flexible : $B=60\ kg.m^2.s^{-2}$.

| Test | E (Pa) | $h_f$ (mm) |
|------|--------|-----------|
| 1 | $240*10^9$ | 0.63 |
| 2 | $4*0^9$ | 2.5 |
| 3 | $10^8$ | 8.4 |
| 4 | $10^7$ | 18.2 |
| 5 | $10^6$ | 39.1 |

Une pale de 630 micromètres de carbone haute résistance, ou de 2.5 millimètres de mylar ou de 3.91 centimètres de caoutchouc de module d'Young $E=10^6$ Pa peut convenir.

Et pour la partie rigide : $\rho_{hr}$ = 0.0024 à 4.8 kg.m-2.

| Test | $\rho$ (kg.m-3) | hr (mm) |
|------|-----------------|---------|
| 1 | $10*10^3$ | $2.4*10^{-4}$ à 0.48 |
| 2 | $5*10^3$ | $4.8*10^{-4}$ à 0.96 |
| 3 | $2*10^3$ | $1.2*10^{-3}$ à 2.4 |
| 4 | $1*10^3$ | $2.4*10^{-3}$ à 4.8 |
| 5 | $0.7*10^3$ | $3.4*10^{-3}$ à 6.9 |

Ainsi la partie rigide de la pale peut être composée de fibre de carbone haute résistance de masse volumique $2. 10^3$ kg/m3 et d'épaisseur 2.4 mm.

L'étape d) utilise donc les valeurs optimales $(C_y/U^2)^{opt}$ et $(C_C/U^2)^{opt}$ déterminées lors de l'étape c) pour déterminer le matériau de la pale flexible. Comme il est trois inconnus (le module d'Young E, la masse volumique de la pale $\rho$, et h son épaisseur) pour deux équations, il faut fixer une des trois inconnues. Par exemple, à titre non limitatif, il est possible de fixer le module d'Young E. La détermination de l'épaisseur de la plaque h, puis de la masse volumique $\rho$ est effectuée à l'aide des équations ci-dessous :

$$h = \left( \frac{\rho_{air} W^3}{2E \left( \frac{C_y}{U^2} \right)^{opt}} \right)^{\frac{1}{3}}$$

$$\rho = \frac{R^2 h^2 E \left( \frac{C_C}{U^2} \right)^{opt}}{W^4}$$

Le module d'Young E est arbitrairement fixé, puis des valeurs d'épaisseur h de la pale et de masse volumique $\rho$ sont déterminées. Des résultats d'une telle étape sont rassemblés dans le tableau ci-dessous.

| Test | E (Pa) | h (mm) | $\rho$ ($10^3$ kg.m$^{-3}$) |
|------|--------|--------|------------------------------|
| 1 | $240\ 10^9$ | 0.63 | $3.81\ 10^{-3}$ à 7.6 |
| 2 | $4\ 10^9$ | 2.5 | $1.1\ 10^{-3}$ à 2 |
| 3 | $10^8$ | 8.4 | $0.28\ 10^{-3}$ à 0.56 |
| 4 | $10^7$ | 18.2 | $0.13\ 10^{-3}$ à 0.26 |
| 5 | $10^6$ | 39.1 | $0.06\ 10^{-3}$ à 0.12 |

Les tests 1 et 2 correspondent respectivement à un matériau de carbone haute résistance et à un matériau en mylar.

*Cas de pales flexibles pour une éolienne à axe vertical de rotation.*

Les vecteurs sont notés en gras (ex : V).

L'éolienne objet de cette étude est une éolienne tripale à axe vertical de rotation, de type Darrieus représentée sur la figure 12.

À la différence de l'éolienne à axe horizontal de rotation, ce type d'éolienne perçoit un vent :

- qui ne dépend pas de la longueur L ;

- qui varie en norme et en direction au cours d'une rotation, ce qui fait intervenir le paramètre temps, même en régime stationnaire (ie lorsque la vitesse de vent incidente U ne varie pas avec le temps), comme montré à la figure 13.

On appelle $\alpha$ l'azimut, c'est-à-dire l'angle qui quantifie la rotation de la pale autour de l'axe (pour l'instant on ne considère qu'une seule pale). Par convention, on choisit $\alpha = 0°$ lorsque la composante $R\Omega$ est colinéaire et de même sens que la vitesse de vent incidente U (sur les schémas de la figure 13, cela correspond à la position de la pale en haut du cercle).

On se pose la question de l'angle d'attaque $\beta$ du vent effectif V sur la pale. La figure 14 montre que l'angle d'attaque est relié à l'angle de calage $\theta_0$, à l'angle d'inclinaison du vent effectif V par rapport au vent incident U noté $\gamma$, et à l'angle de révolution $\alpha$ par la relation :

$$\beta = \alpha - \theta_0 - \gamma(\alpha, R\Omega, U) \qquad\qquad (1.1.1)$$

$\alpha$ est connu et $\theta_0$ est fixé. Regardons comment évolue $\gamma$ au cours d'une rotation. Il s'agit de distinguer deux cas.

1) Dans le cas où $R\Omega \leq U$ (figure 13(a)), alors $\gamma \in$ [-90° ; 90°] et on trouve la formule suivante :

$$\forall \alpha, \quad \gamma = \arctan\left(\frac{R\Omega \sin\alpha}{U + R\Omega \cos\alpha}\right). \qquad (1.1.2)$$

2) Dans le cas ou' $R\Omega \geq U$ (figure 13(b)), alors $\gamma \in$ [-180°; 180°] et la fonction arctan doit être prolongée en $\pm 90°$ :

$$\gamma = \arctan\left(\frac{R\Omega \sin\alpha}{U + R\Omega \cos\alpha}\right) \; si \; U + R\Omega \cos(\alpha) \geq 0$$

$$\gamma = \pi + \arctan\left(\frac{R\Omega \sin\alpha}{U + R\Omega \cos\alpha}\right) \; si \; U + R\Omega \cos(\alpha) \leq 0 \; et \; \sin(\alpha) \geq 0 \qquad (1.1.3)$$

$$\gamma = -\pi + \arctan\left(\frac{R\Omega \sin\alpha}{U + R\Omega \cos\alpha}\right) \; si \; U + R\Omega \cos(\alpha) \leq 0 \; et \; \sin(\alpha) \leq 0.$$

La vitesse de vent effectif $V = U + R\Omega$ a pour norme :

$$V = \sqrt{U^2 + (R\Omega)^2 + 2UR\Omega \cos\alpha}. \qquad (1.1.4)$$

Les évolutions de $\gamma$ et de $\beta$ ainsi que celles de $\| V \|$ sont représentées figure 16 pour $U = 10$ m.s$^{-1}$ et pour $R\Omega$ = 2 m.s$^{-1}$ et $R\Omega$ = 20 m.s$^{-1}$.

Ces évolutions sont à compléter par l'observation de la figure 13 pour voir les directions de V :

- lorsque $R\Omega \leq U$ , alors, $\gamma \in$ [-90° ; 90°] et $\beta$ parcourt l'ensemble du segment [-180° ; 180°]. Dans la limite $R\Omega \ll U$ , alors $\gamma = 0$ (voir équation 1.1.3) et $\beta = \alpha - \theta 0$.
- lorsque $R\Omega \geq U$, alors, $\gamma \in$ [-180° ; 180°] et $\beta$ reste d'autant plus confiné autour de 0° que $R\Omega$ est grand. Dans la limite $R\Omega \gg U$, alors $\gamma = a$ (voir équation 1.1.3) et $\beta = -\theta_0$. Cette limite est très intéressante car il suffit de choisir l'angle d'attaque (à travers le choix de l'angle de calage) pour lequel le moment aérodynamique est maximum afin d'optimiser l'éolienne.

**Moment aérodynamique M autour de l'axe de rotation.**

Le moment aérodynamique M résulte de l'action des forces aérodynamiques (forces de portance et de traînée) sur la pale. Tout d'abord, le moment infinitésimal dM correspondant à l'action de ces forces sur une pale dans la base ($\mathbf{e_r}$, $\mathbf{e_\Omega}$, $\mathbf{e_z}$) présentée à la figure 12, est calculé.
Hypothèse 1 : tous les points de la pale voient le même vent, c'est-à-dire le vent qui arrive au point de fixation de la pale.
Remarque : à cause de l'extension de la pale suivant la corde, tous les points de la pale ne voient pas le même vent effectif (ni en norme ni en direction), mais cette simplification ne change pas le m'mécanisme de fonctionnement de la pale. Cette simplification sera rectifiée dans le programme dans la suite.

$$dM = (Re_r \wedge (dF_L + dF_D)) \qquad (1.2.1)$$

$$\begin{pmatrix} d^2M_r \\ d^2M_\Omega \\ d^2M_z \end{pmatrix} = \left[ \begin{pmatrix} R \\ 0 \\ 0 \end{pmatrix} \wedge \frac{\rho}{2}V^2 \mathrm{ds}\,\mathrm{d}z \begin{pmatrix} -C_L\cos(\phi) - C_D\sin(\phi) \\ C_L\sin(\phi) - C_D\cos(\phi) \\ 0 \end{pmatrix} \right],$$

$$\begin{pmatrix} d^2M_r \\ d^2M_\omega \\ d^2M_z \end{pmatrix} = \frac{\rho}{2}V^2 R\mathrm{ds}\,\mathrm{d}r \left[ \begin{pmatrix} 0 \\ 0 \\ C_L\sin(\phi) - C_D\cos(\phi) \end{pmatrix} \right]. \tag{1.2.2}$$

$\varphi$ représente l'angle entre le vent effectif V et le plan orthoradial : $\varphi = \beta + \theta_0$.

Ainsi seule la composante $dM_z$ selon l'axe $(O_z)$ est non nulle (c'est celle qui fait tourner l'éolienne). En intégrant $dM_z$ sur toute la pale, on obtient $M_z$ la résultante sur moment aérodynamique généré par une pale.

$$M_z = \int_{z=0}^{z=L} \int_{s=0}^{s=W} dM_z$$

$$M_z = \int_{z=0}^{z=L} \int_{s=0}^{s=W} \frac{\rho}{2}V^2 R(C_L\sin(\phi) - C_D\cos(\phi))\mathrm{ds}\,\mathrm{d}z\,e_z \tag{1.2.3}$$

$$M_z = \frac{\rho}{2}V^2 RLW(C_L(\beta)\sin(\phi) - C_D(\beta)\cos(\phi))e_z.$$

L'expression du moment aérodynamique $M_z$ fait apparaître les coefficients de traînée $C_D$ et de portance $C_L$ qui représentent les projections de la force de pression sur la pale qui s'appliquent respectivement selon la direction du vent incident, et dans le plan orthogonal à la direction du vent. Dans la suite, nous utiliserons deux lois aérodynamiques :

1) La loi dite de "pales minces", qui s'applique pour des pales peu profilées ou pour des angles d'incidence élevés (au-delà de 30°) :

$$\begin{aligned} C_L &= C_{L_1}\sin(\beta)\cos(\beta) \\ C_D &= C_{D_1}\sin(\beta)^2. \end{aligned} \tag{1.2.4}$$

Pour une pale de rapport d'aspect AR infini (rapport longueur sur corde infini), CL1 = CD1 = 2 (voir figure 15 (a)). CL1 et CD1 diminuent lorsque AR diminue. Nous examinerons également le cas où CL1 et CD1 ne sont pas égaux, inspiré des pales de notre éolienne expérimentale : CL1 = 1.49 et CD1 = 1.25 (voir figure 15 (b)).

Une loi inspirée du profil aérodynamique NACA 0012 (voir figure 15(c)), plus proche de la force aérodynamique appliquée sur les pales d'éolienne commerciales.

Lorsque $R\Omega$ est inférieur à U, l'angle d'incidence $\beta$ parcourt le segment [-180° ; 180°] (voir figure 16).

Lorsque $R\Omega$ est supérieur à U, l'angle d'incidence $\beta$ décrit un segment inclus dans [-180° ; 180°],centré autour de 0° et d'autant plus petit que $R\Omega$ est grand (voir figure 16).

La norme de la vitesse effective de vent V varie entre |U - R$\Omega$| et |U + R$\Omega$|, est maximal en $\alpha$ = 0° et minimale en $\alpha$ = 180° (voir figure 16 (c,d)).

Sur la figure 17, comme la loi choisie est la loi de pales minces avec $C_{L1} = C_{D1} = 2$, cela signifie que la force aérodynamique résultante est toujours orthogonale à la pale. Si $\theta_0 = 0°$, alors la résultante est radiale et le moment $M_z$ est identiquement nul (trait plein en pointillés associé à $\tilde{C}_L$- $\tilde{C}_D$ sur les figures (c) et (d)).

Lorsque $R\Omega \leq U$, alors la pale est poussée et freinée successivement par la force de traînée puis de portance (voir les oscillations des courbes associées à $\tilde{C}_D$ et $\tilde{C}_L$ sur la figure (a)) : l'éolienne fonctionne successivement à la portance puis à la traînée (dans le cas $C_{L1} = C_{D1} = 2$, la traînée est toujours supérieure ou égale à la portance, ce qui n'est pas intéressant pour faire tourner l'éolienne).

Lorsque $R\Omega \geq U$, alors la pale est poussée par la force de portance (courbes associées à $\tilde{C}_L$ positives) et freinée par la force de traînée (courbes associées à $\tilde{C}_D$ positives sur la figure (a)) : l'éolienne fonctionne à la portance comme c'est le cas pour une éolienne à axe horizontal (dans le cas $C_{L1} = C_{D1} = 2$, la traînée est toujours supérieure ou égale à la portance, ce qui n'est pas intéressant pour faire tourner l'éolienne).

Sur la figure 18, $C_{L1}$ = 1.49 qui est différent de $C_{D1}$ = 1.25, cela signifie que la force aérodynamique résultante n'est plus orthogonale à la pale.

Sur la figure 20, on trouve le fait que :

- s'il s'agit d'une loi de pales minces CL1 = CD1 = 2 (la résultante des forces aérodynamiques est toujours orthogonale à la pale), le couple moyen sur une révolution est négatif ou nul.
- le moment moyen sur une révolution est maximum en $\theta°$ pour les trois lois étudiées. Cela semble cohérent avec le fait que les éoliennes à axe vertical ont des angles de calage nul.

*Fonctionnement d'une éolienne à axe vertical à pales flexibles.*

***Equation de déformée***

Les forces s'exerçant sur la pale sont les forces aérodynamiques - force de portance $F_L$ et force de traînée $F_D$ - et la force centrifuge Fc. Ces forces sont représentées sur la figure 21a et la figure 21b.

Ce sont les composantes localement orthogonales à la pale qui font plier la pale (selon la ligne pointillée traversant la pale au niveau de M(s) sur la figure 21a et 21b). On suppose que les composantes de ces forces localement colinéaires à la pale sont équilibrées par les forces internes de la pale (non extensibilité de la pale).

La composante localement normale à la pale des forces de pression par unité de surface au point M (s) s'écrit :

$$F_L^n + F_D^n = F_L \cos(\beta) + F_D \sin(\beta)$$
$$F_L^n + F_D^n = \frac{\rho}{2} V^2 (C_L \cos(\beta) + C_D \sin(\beta)) \tag{2.1.1}$$
$$F_L^n + F_D^n = \frac{\rho}{2} U^2 (1 + 2\Lambda \cos(\alpha) + \Lambda^2)(C_L \cos(\beta) + C_D \sin(\beta)),$$

où $\Lambda = R\Omega/U$ représente la vitesse de rotation adimensionnée par la vitesse de vent incident, comme pour les EAH.

La composante localement normale à la pale de la force centrifuge par unité de surface au point M (s) s'écrit :

$$F_C^n = -F_C \frac{PM}{OM}$$
$$F_C^n = -\rho_m h\Omega^2 OM \frac{OP}{OM} \tag{2.1.2}$$
$$F_C^n = -\rho_m h\Omega^2 OP$$

Le signe "-" vient du fait que la force centrifuge tend à diminuer l'angle de calage.

Dans une première approche pour prendre en compte la projection de la force centrifuge, on considère des petites variations d'angles de calage $\theta - \theta_0 \ll \theta_0$. Ainsi dans le triangle OPK rectangle en K, on montre que :

$$OP = \sqrt{R^2 - (R\sin(\theta_0))^2} = R|\cos(\theta_0)|.$$

L'équation de déformée sur une poutre de largeur L faiblement déformée est :

$$BL \frac{\partial^3 \theta}{\partial s^3} = \frac{\rho}{2} U^2 L(1 + 2\Lambda \cos(\alpha) + \Lambda^2)(C_L \cos(\beta) + C_D \sin(\beta)) - \rho_m h L \Omega^2 R |\cos(\theta_0)|.$$
$$\frac{\partial^3 \theta}{\partial \bar{s}^3} = \frac{\rho U^2 W^3}{2B}(1 + 2\Lambda \cos(\alpha) + \Lambda^2)(C_L \cos(\beta) + C_D \sin(\beta)) - \frac{\rho_m h R W^3}{B} \Omega^2 |\cos(\theta_0)|. \tag{2.1.3}$$
$$\frac{\partial^3 \theta}{\partial \bar{s}^3} = \frac{\rho U^2 W^3}{2B}(1 + 2\Lambda \cos(\alpha) + \Lambda^2)(C_L \cos(\beta) + C_D \sin(\beta)) - \frac{\rho_m U^2 h W^3}{RB} \Lambda^2 |\cos(\theta_0)|.$$

Les opérations suivantes ont été réalisées pour passer de la première à la deuxième ligne : division par BL et adimensionnement de s = W s~. Par adimensionnement, on entend la suppression partielle ou totale des unités d'une équation par une substitution appropriée de variables, dans le but de simplifier la représentation paramétrique de problèmes physiques. Pour passer à la troisième ligne, on fait apparaître $\Lambda$ dans le terme de la force centrifuge.

Deux nombres adimensionnés émergent :

$$C_Y^{EAV} = \frac{\rho U^2 W^3}{2B} = C_Y^{EAH} \ ; \ C_C^{EAV} = \frac{\rho_m U^2 h W^3}{RB} = C_C^{EAH} \frac{R}{W}. \qquad (2.1.4)$$

Remarque : si l'on veut garder les définitions des nombres de Cauchy et centrifuge donnés dans le brevet, on peut très bien réécrire l'équation sous la forme suivante :

$$\frac{\partial^3 \theta}{\partial \tilde{s}^3} = C_Y^{EAH}(1 + 2\Lambda\cos(\alpha) + \Lambda^2)(C_L\cos(\beta) + C_D\sin(\beta)) - C_C^{EAH}\frac{R}{W}\Lambda^2|\cos(\theta_0)|. \qquad (2.1.5)$$

### *Equation de déformée complète*

Par sa déformation, la pale flexible modifie l'intensité et la direction de la force centrifuge appliquée au point M. Il est pris en compte cet effet afin de déterminer l'équation exacte de la déformée.

D'après la définition de la force centrifuge (voir figure 21b) :

$$\delta f_C(M) = \delta m(M)\Omega^2 \boldsymbol{OM}$$
$$\delta f_C(M) = \rho_m ds h L \Omega^2 \boldsymbol{OM}. \qquad (2.2.1)$$

Or la composante de la force centrifuge qui contribue à la flexion de la poutre s'écrit :

$$\delta f_C^n(M) = \delta f_C(M) \cdot e_n(M)$$
$$\delta f_C^n(M) = \rho_m ds h L \Omega^2 \boldsymbol{OM} \cdot e_n(M), \qquad (2.2.2)$$

Où $e_n$(M) est le vecteur normal à la pale en M. Calculons OM.$e_n$(M)
Dans la base orthonormée ($\mathbf{e_r}$, $\mathbf{e_\Omega}$, $\mathbf{e_z}$) :

$$\boldsymbol{OM} = \begin{pmatrix} R - y(s) \\ -x(s) \\ 0 \end{pmatrix} \ ; \ e_n(M) = \begin{pmatrix} \cos(\theta(s)) \\ -\sin(\theta(s)) \\ 0 \end{pmatrix} \qquad (2.2.3)$$

Ainsi,

$$\delta f_C^n(M) = \rho_m h L ds \Omega^2 \left[(R - y(s))\cos(\theta(s)) + x(s)\sin(\theta(s))\right],$$
$$\delta f_C^n(M) = \rho_m h L ds \Omega^2 [\cos(\theta(s))(R - \int_0^s \sin(\theta_0 + \arctan(\frac{\partial z(s')}{\partial x'}))ds')$$
$$+ \sin(\theta(s)) \int_0^s \cos(\theta_0 + \arctan(\frac{\partial z(s')}{\partial x'}))ds'], \qquad (2.2.4)$$

Où x' représente la distance entre le projeté orthogonal de *M* sur la pale rigide de référence inclinée de $\theta_0$, par rapport au plan orthoradial, et le point d'encastrement.

*Discussion*

Dans le cas où la pale est rigide, $\frac{\partial z(s')}{\partial x'} = 0$ et $\theta = \theta_0$, d'où

$$\delta f_C^n(M) = \rho_m hLds\Omega^2[\cos(\theta_0)(R - s\sin(\theta_0))) + \sin(\theta_0)s\cos(\theta_0))],$$
$$\delta f_C^n(M) = \rho_m hLds\Omega^2\cos(\theta_0)R, \qquad (2.2.5)$$

Et on retombe sur l'équation 2.1.3. Dans le cas faiblement flexible et sachant que $\theta_0$ est proche de 0°, on pose $X(s)= \theta(s)$ et $X(s')= \theta(s')$.

En développant l'équation 2.2.4 au premier ordre en X, il vient

$$\delta f_C^n(M) = \rho_m hLds\Omega^2[(R - \int_0^s X(s')ds') + X(s)\,s],$$
$$\delta f_C^n(M) = \rho_m hLds\Omega^2[R + \int_0^s (\theta(s) - \theta(s'))ds'], \qquad (2.2.6)$$

Le terme est très petit lorsque la pale est faiblement flexible et que $\theta_0$ est proche de O, puisqu'il fait intervenir une différence entre deux termes d'ordre 1. Il n'est pas pris pas en compte dans les simulations dans ces conditions.

*Simulations du sens de déformation de la pale flexible. Comparaison avec la déformation optimale de l'angle de calage pour une éolienne à pales rigides.*

Remarques sur la figure 22 :

- La remarque la plus importante est que la déformation passive de la pale semble bien jouer dans le sens de l'amélioration des performances de l'éolienne. En effet les courbes noires de la troisième rangée sont positives sur [0° ; 180°] comme les courbes noires de la première rangée : quand il est bénéfique d'augmenter l'angle de calage, la pale flexible va également dans ce sens. A l'inverse les courbes noires de la troisième rangée sont négatives sur [-180° ; 0°] comme les courbes noires de la première rangée : quand il est bénéfique de diminuer l'angle de calage, la pale flexible va également dans ce sens. La force centrifuge diminue l'angle de calage sur tout le cycle (mais cela est rattrapable par une légère augmentation de l'angle de calage initial, et il est possible de diminuer l'effet de la force centrifuge par rapport à celle des forces aérodynamiques en choisissant une pale légère et flexible).
- Concernant les courbes de la première rangée, le programme qui les calcule est chargé de trouver l'angle de calage optimal à un angle $\alpha$ donné. On remarque que le programme "hésite" entre la valeur de $\theta_{opt}$ et d'autres valeurs décalées de 90°. Dans la suite, on considère uniquement la courbe du milieu (c'est-à-dire qui part de $\theta_0 = -90°$ en $\alpha = -180°$ pour aller en $\theta_0 = 90°$ en $\alpha = 180°$ en passant par $\theta_0 = 0°$ en $\alpha = 0°$ pour la figure à $\Lambda = 0.2$ par exemple) ;
- Puisque la résultante des forces aérodynamiques est pour cette loi orthogonale à la pale, on trouve normalement que dans la première rangée, lorsque $\Lambda \leq 1$, $\theta_{0\ opt}(\alpha = 0°) = 0°$ puisque la pale remonte le vent et $\theta_{0opt}(a = \pm180°) = \pm90°$ puisque la pale a le vent dans le dos. Lorsque $\Lambda \geq 1$, $\theta_0(\alpha = 0°) = 0°$ et $\theta_{0opt}(a = \pm180°) = \pm0°$ puisque la pale remonte tout le temps le vent ;
- Cela est bien cohérent avec le fait que $M_{max}(\alpha = 0°) = 0$ N.m (deuxième rangée) puisque le vent est colinéaire et de sens opposé au mouvement de la pale ;
- La force centrifuge ne dépend pas de $\alpha$, elle agit comme une constante.

Mêmes remarques sur la figure 23 que sur la figure 22.

Remarques sur la figure 24 :

Idem que précédemment. Les courbes $\theta^{opt}$ (première rangée) sont un peu bruitées (raccordement des coefficients aérodynamiques à améliorer) mais les évolutions sont similaires aux lois précédentes : $\theta^{opt}$ allant de -90° à 90° pour $\Lambda \leq 1$, et dans tous les cas négatifs pour $\alpha \in$ [-180° ; 0°] et positif pour $\alpha \in$ [-0° ; 180°]. Cette évolution est bien suivie par la résultante des forces qui font plier la pale : négatif pour $\alpha$ négatif et positif pour $\alpha$ positif.

Au vu de ces calculs, nous avons pu voir comment fonctionne une éolienne à axe vertical avec notre modèle. Celui-ci, malgré quelques approximations de second ordre, montre que les performances de l'EAV peuvent être améliorées significativement (comparer par exemple les 1 N.m du moment aérodynamique moyen de la figure 9(c) obtenus pour l'angle de calage fixé optimal à $\Lambda$ = 0.2 et les 15 N.m moyens de la figure 13(d) obtenus dans les mêmes conditions en modifiant l'angle de calage durant la rotation).

L'équation de moment et l'équation de déformée pour une EAV ont été démontré et l'analogie avec les équations pour une EAH est forte. On retrouve en particulier les nombres de Cauchy et centrifuge.

De plus, la troisième rangée des figures 22, 23 et 24 montre que la déformation passive de la pale flexible durant un tour sous l'effet des forces aérodynamiques et centrifuge se fait dans le même sens que l'optimisation de l'angle de calage : réduction de $\theta_0$ si $\alpha \leq 0°$ et augmentation de l'angle de calage lorsque $\alpha \geq 0°$.

Ces observations concernant le rendement (la fatigue reste à explorer) montrent que l'utilisation de pales flexibles est souhaitable.

*Simulations du fonctionnement d'une Eolienne à axe vertical à pales flexibles : quantification du gain en rendement par rapport à la même Eolienne à axe vertical à pâles rigides.*

Théorie : équation de déformée spatio-temporelle

Au cours d'une rotation, les forces sur la pale varient en norme et en direction. La déformation de la pale change donc lors d'une révolution. La prise en compte du terme d'inertie dans l'équation de la déformation sur une section de surface *S=L\*h* située à l'abscisse curviligne s du point d'encastrement donne :

$$\rho_m S \frac{\partial^2 z}{\partial t^2} = -EI \frac{\partial^4 z}{\partial x^4} + \frac{\rho U^2 L}{2}(1 + 2\Lambda \cos(\alpha) + \Lambda^2)(C_L \cos(\beta) + C_D \sin(\beta)) - \rho_m h L \Omega^2 R \cos(\theta_0). \tag{2.4.1}$$

En utilisant que EI=BL et en adimensionnant les longueurs x=$\tilde{x}$W et z=$\tilde{z}$W, le terme est isolé :

$$\rho_m L h W \frac{\partial^2 \tilde{z}}{\partial t^2} = -BL \frac{W}{W^4} \frac{\partial^4 \tilde{z}}{\partial \tilde{x}^4} + \frac{\rho U^2 L}{2}(1 + 2\Lambda \cos(\alpha) + \Lambda^2)(C_L \cos(\beta) + C_D \sin(\beta)) - \rho_m h L \Omega^2 R \cos(\theta_0).$$

$$\frac{\partial^4 \tilde{z}}{\partial \tilde{x}^4} = -\frac{\rho_m h W^3}{B} \frac{\partial^2 \tilde{z}}{\partial t^2} + \frac{\rho U^2 W^3}{2B}(1 + 2\Lambda \cos(\alpha) + \Lambda^2)(C_L \cos(\beta) + C_D \sin(\beta)) - \frac{\rho_m h W^3 \Omega^2 R}{B} \cos(\theta_0).$$

$$\frac{\partial^4 \tilde{z}}{\partial \tilde{x}^4} = -\frac{\rho_m h W^4}{B} \frac{\partial^2 \tilde{z}}{\partial t^2} + C_Y(1 + 2\Lambda \cos(\alpha) + \Lambda^2)(C_L \cos(\beta) + C_D \sin(\beta)) - C_C^{EAV} \Lambda^2 \cos(\theta_0).$$

$$\tag{2.4.2}$$

L'adimensionnement pertinent pour le temps est bien le temps de reconfiguration

$$\tau_p = W^2 \sqrt{\frac{\rho_m h}{B}} = \frac{W^2}{h} \sqrt{\frac{12(1 - \nu^2)\rho_m}{E}}. \tag{2.4.3}$$

En posant $t = \tilde{t}\tau_p$, l'équation 2.4.2 devient :

$$\frac{\partial^4 \tilde{z}}{\partial \tilde{x}^4} = -\frac{\partial^2 \tilde{z}}{\partial \tilde{t}^2} + C_Y(1 + 2\Lambda \cos(\alpha) + \Lambda^2)(C_L \cos(\beta) + C_D \sin(\beta)) - C_C^{EAV} \Lambda^2 \cos(\theta_0). \tag{2.4.4}$$

*Résolution numérique : discrétisation du temps*

Afin de résoudre l'équation 2.4.4, il est discrétisé le temps et l'espace et résolut l'équation au pas de temps $\Delta$t. $\Delta$t doit être le plus grand possible afin de minimiser le temps de calcul, tout en restant plus petit que la fréquence des variations de contraintes sur la pale (cf. figures 25 et 26).

*Deuxième partie de l'invention : Cas des pales rigides articulées à un bras par un ressort de torsion*

En référence à la figure 27, la présente éolienne ou hydrolienne comprend :

- une pluralité de pales rigides articulées chacune à un ou plusieurs bras 1 de l'éolienne/hydrolienne,
- au moins un ressort de torsion 2 par bras 1 reliant mécaniquement le bras 1 et la pale rigide, la raideur du ressort de torsion 2 étant choisie pour réguler passivement l'angle de calage de l'éolienne ou de l'hydrolienne en fonctionnement,
- chaque pale étant articulée au bras 1 de façon à tourner uniquement selon la direction de l'envergure de la pale, sous l'effet du ressort de torsion 2 et des forces dues à la rotation de la pale autour de l'axe de rotation de l'éolienne.

Ici le mot 'articulé' signifie que le bras 1 et la pale pivotent l'un par rapport à l'autre. Dans le cas de la présente invention, cette articulation est contrainte à un seul degré de liberté de rotation, autour d'un axe de rotation dont la direction est celle de l'envergure de la pale articulée.

Ainsi la réponse élastique du ressort de torsion 2 permet d'adapter par un choix adapté de la raideur du ressort de torsion 2 l'angle de calage de la pale rigide articulée pour que cet angle de calage suive la variation optimale de l'angle de calage d'une pale rigide de référence, et cette réponse élastique est passive c'est-à-dire qu'elle ne nécessite pas à minima de capteurs de vitesse couplés à un moteur pour régler l'angle de calage, comme cela peut être le cas pour la pale rigide de référence.

Tandis que pour la première catégorie d'éoliennes/hydroliennes, l'envergure de la pale est la direction suivant le rayon R de la pale, pour la deuxième catégorie d'éoliennes/hydroliennes, l'envergure de la pale est la hauteur L de la pale, notamment pour la pale rigide articulée.

Avantageusement, la masse volumique des pales rigides articulées à un ou plusieurs bras et la raideur des ressorts de torsion sont déterminées par le procédé de conception de l'invention.

En référence à la figure 29, le procédé appliqué à ces pales rigides articulées présente les étapes suivantes :

a) réception du profil géométrique connu de pales rigides,

b) détermination, pour ledit profil géométrique appliqué à une pale rigide de référence, d'une évolution de l'angle de calage optimal de la pale rigide $\theta_{0\,opt\,rigide}$ en fonction de la vitesse spécifique $\lambda$ égale au rapport entre la vitesse considérée au bout de pale et la vitesse de fluide incident, pour un régime de vitesses du fluide s'écoulant autour de la pale rigide,

c) détermination du comportement de la pale rigide avec ressort de torsion 2, se déplaçant d'une part sous l'effet du chargement aérodynamique du fluide circulant autour de cette pale rigide, et d'autre part de la force centrifuge qui s'exerce sur cette pale rigide en rotation, et détermination de ratios locaux relatifs au chargement aérodynamique et à la force centrifuge s'exerçant sur cette pale rigide,

d) détermination de la raideur K du ressort de torsion 2 et de valeurs locales de la masse volumique $\rho$ de la pale rigide articulée, à l'aide des ratios locaux et du comportement de la pale rigide déterminés à l'étape c) de sorte que l'évolution d'un angle de calage effectif $\theta_{0eff}$ de la pale rigide, conféré par la torsion du ressort de la pale rigide, en fonction de la vitesse spécifique À, corresponde à l'évolution déterminée à l'étape précédente b), et

e) restitution d'une information relative au choix du matériau de la pale rigide articulée, et de la raideur K du ressort de torsion.

La pale d'éolienne/hydrolienne articulée avec son ressort 2 vérifie l'équation suivante :

$$K\big(\theta(t)-\theta_0\big)=-\iint\limits_{pale} l(x,y,t)q(x,y,t)dxdy-\frac{d^2J\theta}{dt^2}$$

où K est la constante de raideur du/des ressort(s) de torsion 2, $\theta$ est l'angle de calage de la pale, $\theta_0$ est l'angle de calage initial de la pale (lorsque aucune force n'est appliquée sur la pale au repos), l(x,y,t) est la distance entre le point de la pale considéré sur l'intégrale et l'axe de rotation du ressort de torsion 2, q(x,y,t) est le chargement dû aux forces aérodynamiques et centrifuge, J est le moment d'inertie de la pale par rapport à l'axe de rotation du/des ressort(s) de torsion, J étant défini par la formule suivante :

$$J(t)=\iint\limits_{pale} h(x,y)\rho(x,y)l^2(x,y,t)dxdy$$

où h(x,y) est l'épaisseur de la pale, p(x,y) est la masse volumique de la pale, et I(x,y,t) est la distance entre le point de la pale considéré de coordonnées (x,y) et l'axe de rotation du ressort de torsion 2.

Les ratios locaux sont le nombre de Cauchy égal à $C_y = \rho_{fluide} U^2 W_f^2 R/(2K)$, et le nombre centrifuge égal à $C_c = \rho U^2 h W_f^3/(RK)$, avec, pour chaque point considéré de la pale rigide articulée, K la raideur du ressort de torsion 2, $\rho$ masse volumique de la pale, $\rho_{fluide}$ masse volumique du fluide circulant autour de la pale, U vitesse du fluide incident, W longueur de la corde de l'élément de pale considérée, R rayon de la pale, h épaisseur de la pale.

Avantageusement, comme visible sur la figure 27, l'éolienne est à axe vertical de rotation, ou à axe de rotation horizontal quand la vitesse de vent U n'est pas orthogonale au plan de rotation de la pale.

Dans ce cas, par exemple, une extrémité 20 du ressort de torsion 2 est fixée à l'intérieur de la pale rigide, une seconde extrémité 22 est fixée au bras 1, l'axe de la spire 23 du ressort de torsion 2 étant colinéaire avec l'envergure (selon le vecteur $e_z$ sur la figure 27).

La spire 23 peut être en appui sur le bras 1 et/ou logée dans la pale ou en appui sur la pale. Toutes les configurations peuvent être envisagées dans la mesure où la pale rigide articulée peut tourner uniquement par rapport au bras suivant une rotation dont la direction est la propre envergure de cette pale rigide.

Dans une réalisation, comme visible sur la figure 27, chaque pale articulée est reliée à l'axe d'articulation par plusieurs bras 1.

Dans une réalisation différents ressorts de torsion 2 avec différentes raideurs K, K', une raideur K, K', différente par bras, sont articulés à la pale.

Le schéma de la figure 27 n'est pas exclusif.

Les points d'accroche de la pale et les ressorts de torsion 2 peuvent être situés à d'autres endroits, en particulier en les rapprochant du bord d'attaque de la pale rigide articulée.

Le nombre de ressorts de torsion 2 n'est pas fixé à celui sur le schéma : on peut en mettre davantage ou moins.

Le procédé décrit dans la présente demande permet ainsi de déterminer les caractéristiques des ressorts 2 à utiliser (raideur K, longueur, diamètre).

Par exemple, dans une réalisation possible, le bras 1 présente un moyen de support de la pale, situé dans un logement de la pale, ce moyen de support permettant la rotation de la pale articulée, le moyen de support étant une liaison pivot ou une liaison rotule.

*Troisième partie de l'invention : cas des pales flexibles articulées à un bras par un ressort de torsion.*

Dans une troisième partie de l'invention, il peut être prévu aussi une éolienne ou hydrolienne à axe de rotation vertical comprenant :

- une pluralité de pales flexibles articulées chacune à un ou plusieurs bras 1 de l'éolienne/hydrolienne,
- au moins un ressort de torsion 2 par bras 1 reliant mécaniquement le bras1 et la pale flexible, la raideur du ressort de torsion 2 étant choisie pour réguler passivement l'angle de calage de l'éolienne ou de l'hydrolienne en fonctionnement,
- chaque pale flexible étant articulée au bras 1 de façon à tourner selon la direction de l'envergure de la pale, sous l'effet du ressort de torsion 2 et des forces dues à la rotation de la pale autour de l'axe de rotation de l'éolienne.

Dans ce cas, la réponse élastique du ressort de torsion 2 et de la flexibilité de la pale permet d'adapter l'angle de calage de la pale flexible articulée, par un choix adapté de la raideur du ressort de torsion 2 et de la flexibilité de la pale, pour que cet angle de calage suive la variation optimale de l'angle de calage d'une pale rigide de référence, et cette réponse élastique est passive c'est-à-dire qu'elle ne nécessite pas à minima de capteurs de vitesse couplés à un moteur pour régler l'angle de calage, comme cela peut être le cas pour la pale rigide de référence.

Dans ce cas, le procédé de conception selon l'invention permet :

- dans l'étape d), après avoir calculé les forces qui s'appliquent sur la pale flexible articulée, la détermination de valeurs locales de module de flexion B, de masse volumique $\rho$, et de la raideur K du ressort de torsion, à l'aide des ratios locaux et du comportement de la pale flexible déterminés à l'étape c) de sorte que l'évolution d'un angle de calage effectif $\theta_{0eff}$ de la pale flexible articulée, conférée par la torsion du ressort de la pale rigide et la flexibilité de la pale, en fonction de la vitesse spécifique $\lambda$, corresponde à l'évolution déterminée à l'étape précédente b), et
- dans l'étape e), restitution d'une information relative au choix du matériau, déterminée à partir des valeurs locales de module de flexion B, de masse volumique $\rho$, et de la valeur de la raideur du torsion K calculés à l'étape d) et du profil géométrique reçu à l'étape a).

**Revendications**

1. Procédé de conception d'une pale flexible d'éolienne ou d'hydrolienne prédéfinie, la pale flexible présentant un profil géométrique connu : une envergure connue ainsi qu'une épaisseur et une corde qui sont connues et qui sont variables suivant la direction de l'envergure, un angle de calage au repos la pale flexible étant conçue à flexibilité au moins selon la corde, pour réguler passivement l'angle de calage de l'éolienne ou de l'hydrolienne en fonctionnement,
   le procédé comprenant les étapes suivantes :

   a) réception du profil géométrique connu,
   b) détermination, pour ledit profil géométrique appliqué à une pale rigide de référence, d'une évolution de l'angle de calage optimal de la pale rigide $\theta_{0\,opt\,rigide}$ en fonction de la vitesse spécifique $\lambda$ égale au rapport entre la vitesse considérée au bout de pale et la vitesse de fluide incident, pour un régime de vitesses du fluide s'écoulant autour de la pale rigide de référence,
   c) détermination du comportement local de la pale flexible, se déformant d'une part sous l'effet du chargement aérodynamique du fluide circulant autour de pale flexible, et d'autre part de la force centrifuge qui s'exerce sur la pale flexible en rotation, et détermination de ratios locaux relatifs au chargement aérodynamique et à la force centrifuge s'exerçant sur la pale flexible,
   d) détermination de valeurs locales de module de flexion B et de masse volumique $\rho$, à l'aide des ratios locaux et du comportement de la pale flexible déterminés à l'étape c) de sorte que l'évolution d'un angle de calage effectif $\theta_{0eff}$ de la pale flexible, conféré par la flexibilité au moins selon la corde de la pale flexible, en fonction de la vitesse spécifique $\lambda$, corresponde à l'évolution déterminée à l'étape précédente b), et
   e) restitution d'une information relative au choix du matériau, déterminée à partir des valeurs locales de module de flexion B et de masse volumique $\rho$ calculés à l'étape d) et du profil géométrique reçu à l'étape a).

2. Procédé selon la revendication 1, dans lequel la pale flexible est une pale flexible d'une première catégorie d'éoliennes/hydroliennes dite à axe horizontal de rotation et pour lesquelles la direction de vent U est orthogonale au plan de rotation de la pale.

3. Procédé selon la revendication 1, dans lequel la pale flexible est une pale flexible d'une deuxième catégorie d'éoliennes/hydroliennes dite à axe vertical de rotation, ou à axe de rotation horizontal quand la vitesse de vent U n'est pas orthogonale au plan de rotation de la pale flexible, et dans ce cas $\theta_{0\,opt\,rigide}$ est aussi une fonction de $\alpha$, $\alpha$ étant l'angle azimutal (angle de rotation de la pale autour de l'axe), et dans l'étape b), à chaque vitesse spécifique $\lambda$ est associée une distribution de $\theta_{0\,opt\,rigide}\,(\alpha)$.

4. Procédé selon l'une des revendications 2 à 3, dans lequel :

   - dans l'étape b), est déterminée la valeur optimale $\lambda_{max\,rigide}$ pour lequel le rendement $C_p$ de l'éolienne ou hydrolienne à pales rigides de référence avec le même profil géométrique fixé que celui de l'éolienne/hydrolienne à pales flexibles est maximum, et dans lequel il est déduit, à l'aide de l'évolution de l'angle de calage optimal de pale rigide $\theta_{0\,opt\,rigide}$ de référence pour la première catégorie d'éoliennes/hydroliennes ou respectivement de celle de l'angle de calage optimal de pale rigide $\theta_{0\,opt\,rigide}$ (a) de référence pour la deuxième catégorie d'éoliennes/hydroliennes, le point de fonctionnement optimum maximum [$\theta_{0\,opt\,max\,rigide}$, $\lambda_{max\,rigide}$] ou respectivement le point de fonctionnement optimum maximum [$\theta_{0\,opt\,max\,rigide}(\alpha)$, $\lambda_{max\,rigide}$],
   - et dans l'étape c), est déterminée une valeur de l'angle de calage initial $\theta_{0\,eff\,ini}$ des pales flexibles pour que, en fonctionnement, le point de fonctionnement effectif maximum [$\theta_{0\,eff\,max}$, $\lambda_{max}$] pour la première catégorie d'éolienne/d'hydrolienne ou respectivement [$\theta_{0\,eff\,max}(\alpha)$, $\lambda_{max}$] pour la deuxième catégorie d'éolienne/ hydrolienne ayant ces pales flexibles, soit égal au point de fonctionnement optimum maximum [$\theta_{0\,opt\,max\,rigide}$, $\lambda_{max\,rigide}$] ou respectivement [$\theta_{0\,opt\,max\,rigide}$ $(\alpha)$, $\lambda_{max\,rigide}$], de l'éolienne ou hydrolienne à pales rigides de référence.

5. Procédé selon l'une des revendications 2 à 4, dans lequel lors de l'étape c), les ratios locaux relatifs au chargement aérodynamique et à la force centrifuge s'exerçant sur la pale flexible, sont le nombre de Cauchy $C_y$ et le nombre centrifuge $C_c$, et sont déterminés en chaque point de la pale flexible, le nombre de Cauchy $C_y$ étant le rapport des moments de la force aérodynamique et de la force élastique, le produit $C_c^* \lambda^2$ pour la première catégorie d'éolienne/d'hydrolienne, ou respectivement $C_c^* \lambda^2 \,^*(R/W)$ pour la deuxième catégorie d'éolienne/hydrolienne, étant le rapport des moments de la force centrifuge et de la force élastique.

6. Procédé selon l'une des revendications 1 à 5, dans lequel lors des étapes b) à c), la pale flexible étant assimilée à une série de poutres encastrées dans une tige rigide radiale, et considérées à différents endroits selon la direction de l'envergure, et qui se déforment selon la corde indépendamment les unes des autres, et l'évolution de l'angle de calage effectif de la pale flexible étant déterminée en fonction de l'abscisse curviligne de la corde.

7. Procédé selon l'une des revendications 1 à 5, dans lequel la pale flexible étant conçue à flexibilité aussi selon l'envergure.

8. Procédé selon l'une des revendications 2 à 7, dans lequel lors des étapes b) à c), la pale flexible est assimilée à une plaque à deux dimensions, encastrée dans une tige rigide radiale, et qui se déforme selon la corde et possiblement selon le rayon, et dans lequel il est appliqué les équations de plaque issues de la théorie de Kirchhoff-Love.

9. Procédé selon l'une des revendications 1 à 8, dans lequel l'information relative au choix du matériau porte sur la répartition du ou des matériaux au sein de la pale flexible, ou comporte une information sur la répartition de la masse volumique au sein de la pale flexible, la répartition du module de flexion au sein de la pale flexible, l'insertion d'éléments extérieurs à une pale à profil géométrique fixé.

10. Procédé de fabrication d'une pale flexible d'une éolienne ou d'une hydrolienne, le procédé comprenant des étapes de :

- mise en œuvre du procédé selon l'une des revendications 1 à 9 de sorte à concevoir une pale flexible d'éolienne ou d'hydrolienne ;
- fabrication de ladite pale flexible conformément à la conception de la pale flexible d'éolienne ou d'hydrolienne obtenue.

11. Pale d'éolienne ou d'hydrolienne, **caractérisée en ce qu'**elle est flexible selon la corde, et est fabriquée selon le procédé selon la revendication 10, la flexibilité de ladite pale régulant passivement l'angle de calage de l'éolienne ou de l'hydrolienne en fonctionnement.

12. Pale flexible d'éolienne ou d'hydrolienne selon la revendication 11, dans laquelle la masse volumique est inhomogène et/ou le module de flexion est inhomogène.

13. Eolienne ou hydrolienne comprenant une pluralité de pales flexibles selon l'une des revendications 11 à 12.

14. Procédé de conception d'une pale rigide d'éolienne ou d'hydrolienne prédéfinie, la pale rigide présentant un profil géométrique connu: une envergure connue ainsi qu'une épaisseur et une corde qui sont connues et qui sont variables suivant la direction de l'envergure, un angle de calage au repos, la pale rigide étant articulée autour d'un bras de l'éolienne/hydrolienne, la pale rigide pouvant effectuer un mouvement de rotation autour du bras selon son envergure, au moins un ressort de torsion reliant la pale rigide avec le bras dont la raideur K est choisie pour réguler passivement l'angle de calage de l'éolienne ou de l'hydrolienne en fonctionnement, le procédé comprenant les étapes suivantes :

a) réception du profil géométrique connu,
b) détermination, pour ledit profil géométrique appliqué à une pale rigide de référence, d'une évolution de l'angle de calage optimal de la pale rigide $\theta_{0\,opt\,rigide}$ en fonction au moins de la vitesse spécifique $\lambda$ égale au rapport entre la vitesse considérée au bout de pale et la vitesse de fluide incident, pour un régime de vitesses du fluide s'écoulant autour de la pale rigide,
c) détermination du comportement de la pale rigide articulée avec ressort de torsion, la pale rigide articulée se déplaçant sous l'effet du chargement aérodynamique du fluide circulant autour de cette pale rigide, de la force élastique de rappel du ressort de torsion et de la force centrifuge qui s'exerce sur cette pale rigide en rotation, et détermination de ratios locaux relatifs au chargement aérodynamique, à la force élastique de rappel et à la force centrifuge s'exerçant sur cette pale rigide articulée,
d) détermination de la raideur K du ressort de torsion et de valeurs locales de la masse volumique $\rho$ de la pale rigide articulée, à l'aide des ratios locaux et du comportement de la pale rigide déterminés à l'étape c) de sorte que l'évolution d'un angle de calage effectif $\theta_{0eff}$ de la pale rigide, conférée par la torsion du ressort de la pale rigide, en fonction de la vitesse spécifique À, corresponde à l'évolution déterminée à l'étape précédente b), et
e) restitution d'une information relative au choix du matériau de la pale rigide articulée, et de la raideur K du ressort de torsion.

**15.** Procédé selon la revendication 14, dans lequel la pale appartient à une première catégorie d'éoliennes/hydroliennes dite à axe horizontal de rotation et pour lesquelles la direction de vent U est orthogonale au plan de rotation de la pale.

**16.** Procédé selon la revendication 14, dans lequel la pale appartient à une deuxième catégorie d'éoliennes/hydroliennes dite à axe vertical de rotation, ou à axe de rotation horizontal quand la vitesse de vent U n'est pas orthogonale au plan de rotation de la pale, et dans ce cas $\theta_{0\ opt\ rigide}$ est une fonction de $\alpha$, a étant l'angle azimutal (angle de rotation de la pale autour de l'axe) et dans l'étape b), à chaque vitesse spécifique $\lambda$ est associée une distribution de $\theta_{0\ opt\ rigide}(\alpha)$.

**17.** Procédé selon l'une des revendications 14 à 16, dans lequel :

- dans l'étape b), est déterminée la valeur optimale $\lambda_{max\ rigide}$ pour lequel le rendement $C_p$ de l'éolienne ou hydrolienne à pales rigides avec le même profil géométrique fixé que celui de l'éolienne/hydrolienne à pales flexibles est maximum, et dans lequel il est déduit, à l'aide de l'évolution de l'angle de calage optimal de pale rigide de référence $\theta_{0\ opt\ rigide}$ pour la première catégorie d'éoliennes/hydroliennes ou respectivement $\theta_{0\ opt\ rigide}(\alpha)$ pour la deuxième catégorie d'éoliennes/hydroliennes,
le point de fonctionnement optimum maximum [$\theta_{0\ opt\ max\ rigide}$, $\lambda_{max\ rigide}$] ou respectivement le point de fonctionnement optimum maximum [$\theta_{0\ opt\ max\ rigide}(\alpha)$, $\lambda_{max\ rigide}$],
- et dans l'étape c), est déterminée une valeur de l'angle de calage initial $\theta_{0\ eff\ ini}$ des pales rigides articulées pour que, en fonctionnement, le point de fonctionnement effectif maximum [$\theta_{0\ eff\ max}$, $\lambda_{max}$] pour la première catégorie d'éolienne/d'hydrolienne ou respectivement [$\theta_{0\ eff\ max}(\alpha)$, $\lambda_{max}$] pour la deuxième catégorie d'éolienne/ hydrolienne ayant ces pales rigides articulées,
soit égal au point de fonctionnement optimum maximum [$\theta_{0\ opt\ max\ rigide}$, $\lambda_{max\ rigide}$] ou respectivement [$\theta_{0\ opt\ max\ rigide}(\alpha)$, $\lambda_{max\ rigide}$] de l'éolienne ou hydrolienne à pales rigides de référence.

**18.** Procédé selon l'une des revendications 14 à 17, dans lequel lors de l'étape c), les ratios locaux relatifs au chargement aérodynamique et à la force centrifuge s'exerçant sur la pale rigide articulée, sont le nombre de Cauchy $C_y$ et le nombre centrifuge $C_c$, et sont déterminés en chaque point de la pale rigide articulée, le nombre de Cauchy $C_y$ étant le rapport des moments de la force aérodynamique et de la force élastique, le produit $C_c^* \lambda^2$ pour la première catégorie d'éolienne/d'hydrolienne, ou respectivement $C_c^* \lambda^2 {}^*(R/W)$ pour la deuxième catégorie d'éolienne/hydrolienne, étant le rapport des moments de la force centrifuge et de la force élastique.

**19.** Eolienne ou hydrolienne comprenant :

- une pluralité de pales rigides articulées chacune à un ou plusieurs bras de l'éolienne/hydrolienne,
- au moins un ressort de torsion par bras reliant mécaniquement le bras et la pale rigide articulée, la raideur du ressort de torsion étant choisie pour réguler passivement l'angle de calage de l'éolienne ou de l'hydrolienne en fonctionnement,
- chaque pale étant articulée au bras de façon à tourner autour du bras uniquement selon la direction de l'envergure de la pale, sous l'effet du ressort de torsion et des forces dues à la rotation de la pale autour de l'axe de rotation de l'éolienne,
- la masse volumique des pales rigides articulées et la raideur des ressorts de torsion sont déterminées par le procédé défini selon l'une quelconque des revendications 14 à 18.

**20.** Eolienne ou hydrolienne selon la revendication 19, **caractérisée en ce que** l'éolienne est à axe vertical de rotation, ou à axe de rotation horizontal quand la vitesse de vent U n'est pas orthogonale au plan de rotation de la pale.

**21.** Eolienne ou hydrolienne selon l'une des revendications 19 à 20, l'éolienne étant à axe vertical de rotation, ou à axe de rotation horizontal quand la vitesse de vent U n'est pas orthogonale au plan de rotation de la pale, **caractérisée en ce qu'**une extrémité du ressort de torsion est fixée à l'intérieur de la pale rigide, une seconde extrémité est fixée au bras, l'axe de la spire du ressort de torsion étant colinéaire avec l'envergure, l'envergure étant la hauteur (L) de la pale rigide articulée.

**22.** Eolienne ou hydrolienne selon la revendication 21, **caractérisée en ce qu'**une extrémité de la spire est en appui sur le bras.

**23.** Eolienne ou hydrolienne selon l'une des revendications 19 à 22, **caractérisée en ce que** le bras présente un moyen de support de la pale, situé dans un logement de la pale, ce moyen de support permettant la rotation de la pale articulée, le moyen de support étant une liaison pivot ou une liaison rotule.

**Patentansprüche**

1. Verfahren zur Konstruktion einer vordefinierten flexiblen Wind- oder Wasserturbinenschaufel, wobei die flexible Schaufel ein bekanntes geometrisches Profil aufweist: eine bekannte Spannweite sowie eine Dicke und eine Sehne, die bekannt sind und die gemäß der Richtung der Spannweite variabel sind, einen Einstellwinkel in Ruhe wobei die flexible Schaufel mindestens gemäß der Sehne flexibel konstruiert ist, um den Einstellwinkel der Wind- oder Wasserturbine im Betrieb passiv zu regulieren,
   wobei das Verfahren die folgenden Schritte umfasst:

   a) Erhalten des bekannten geometrischen Profils,
   b) Bestimmen, für das auf eine starre Referenzschaufel angewendete geometrische Profil, einer Entwicklung des optimalen Einstellwinkels der starren Schaufel $\theta_{0\,opt\,starr}$ in Abhängigkeit von der spezifischen Geschwindigkeit $\lambda$ gleich dem Verhältnis zwischen der an der Schaufelspitze betrachteten Geschwindigkeit und der Geschwindigkeit des anströmenden Fluids für ein Geschwindigkeitsregime des Fluids, das um die starre Referenzschaufel strömt,
   c) Bestimmen des lokalen Verhaltens der flexiblen Schaufel, die sich zum einen unter der Wirkung der aerodynamischen Kraft des Fluids, das um die flexible Schaufel zirkuliert, und zum anderen der Zentrifugalkraft, die auf die rotierende flexible Schaufel wirkt, verformt, und Bestimmen lokalen Verhältniszahlen in Relation zu der aerodynamischen Kraft und der Zentrifugalkraft, die auf die flexible Schaufel wirkt,
   d) Bestimmen lokaler Werte des Flexionsmoduls B und der Volumenmasse p mit Hilfe der lokalen Verhältniszahlen und des Verhaltens der flexiblen Schaufel, die in Schritt c) bestimmt wurden, so dass die Entwicklung eines effektiven Einstellwinkels $\theta_{0eff}$ der flexiblen Schaufel, verliehen mindestens durch die Flexibilität gemäß der Sehne der flexiblen Schaufel, in Abhängigkeit von der spezifischen Geschwindigkeit $\lambda$ der in vorangegangenem Schritt b) bestimmten Entwicklung entspricht, und
   e) Rückmelden einer Information über die Auswahl des Materials, bestimmt auf der Basis der lokalen Werte des Flexionsmoduls B und der Volumenmasse p, berechnet in Schritt d), und des geometrischen Profils, erhalten in Schritt a).

2. Verfahren nach Anspruch 1, wobei die flexible Schaufel eine flexible Schaufel einer ersten Wind-/Wasserturbinenkategorie mit horizontaler Rotationsachse ist und für die die Windrichtung U orthogonal zur Rotationsebene der Schaufel ist.

3. Verfahren nach Anspruch 1, wobei die flexible Schaufel eine flexible Schaufel einer zweiten Wind-/Wasserturbinenkategorie mit vertikaler Rotationsachse ist oder mit horizontaler Rotationsachse, wenn die Windgeschwindigkeit U nicht orthogonal zur Rotationsebene der flexiblen Schaufel ist, und in diesem Fall $\theta_{0\,opt\,starr}$ auch eine Funktion von $\alpha$ ist, wobei $\alpha$ der Azimutwinkel (Rotationswinkel der Schaufel um die Achse) ist, und in Schritt b) jeder spezifischen Geschwindigkeit $\lambda$ eine Verteilung von $\theta_{0\,opt\,starr}(\alpha)$ zugeordnet ist.

4. Verfahren nach einem der Ansprüche 2 bis 3, wobei:

   - in Schritt b) der optimale Wert $\lambda_{max\,starr}$ bestimmt wird, für den die Ausbeute $C_p$ der Wind- oder Wasserturbine mit starren Referenzschaufeln mit demselben festgelegten geometrischen Profil wie das der Wind-/Wasserturbine mit flexiblen Schaufeln maximal ist, und wobei mit Hilfe der Entwicklung des optimalen Einstellwinkels einer starren Referenzschaufel $\theta_{0\,opt\,starr}$ für die erste Wind-/Wasserturbinenkategorie oder beziehungsweise der des optimalen Einstellwinkels einer starren Referenzschaufel $\theta_{0\,opt\,starr}(\alpha)$ für die zweite Wind-/Wasserturbinenkategorie der maximale optimale Arbeitspunkt $[\theta_{0\,opt\,max\,starr}, \lambda_{max\,starr}]$ oder beziehungsweise der maximale optimale Arbeitspunkt $[\theta_{0\,opt\,max\,starr}(\alpha), \lambda_{max\,starr}]$ abgeleitet wird,
   - und in Schritt c) ein Wert des Ersteinstellwinkels $\theta_{0\,eff\,erst}$ der flexiblen Schaufeln bestimmt wird, damit im Betrieb der maximale effektive Arbeitspunkt $[\theta_{0\,eff\,max}, \lambda_{max}]$ für die erste Wind-/Wasserturbinenkategorie oder beziehungsweise $[\theta_{0\,eff\,max}(\alpha), \lambda_{max}]$ für die zweite Wind-/Wasserturbinenkategorie mit flexiblen Schaufeln gleich dem maximalen optimalen Arbeitspunkt $[\theta_{0\,opt\,max\,starr}, \lambda_{max\,starr}]$ oder beziehungsweise $[\theta_{0\,opt\,max\,starr}(\alpha), \lambda_{max\,starr}]$ der Wind- oder Wasserturbine mit starren Referenzschaufeln ist.

5. Verfahren nach einem der Ansprüche 2 bis 4, wobei bei Schritt c) die lokalen Verhältniszahlen in Relation zu der aerodynamischen Kraft und der Zentrifugalkraft, die auf die flexible Schaufel wirkt, die Cauchy-Zahl $C_y$ und die Zentrifugalzahl $C_c$ sind und an jedem Punkt der flexiblen Schaufel bestimmt werden, wobei die Cauchy-Zahl $C_y$ das Verhältnis der Momente der aerodynamischen Kraft und der elastischen Kraft ist, wobei das Produkt $C_c*\lambda^2$ für die erste Wind- /Wasserturbinenkategorie oder beziehungsweise $C_c*\lambda^2*(R/W)$ für die zweite Wind-/Wasserturbinenkategorie das Verhältnis der Momente der Zentrifugalkraft und der elastischen Kraft ist.

6. Verfahren nach einem der Ansprüche 1 bis 5, wobei bei den Schritten b) bis c) die flexible Schaufel einer Reihe von Balken gleichgesetzt wird, die in einer radialen starren Stange eingesetzt sind, und an verschiedenen Stellen gemäß der Spannweitenrichtung betrachtet werden, und die sich gemäß der Sehne unabhängig voneinander verformen, und die Entwicklung des effektiven Einstellwinkels der flexiblen Schaufel in Abhängigkeit von der gekrümmten Abszisse der Sehne bestimmt wird.

7. Verfahren nach einem der Ansprüche 1 bis 5, wobei die flexible Schaufel auch gemäß der Spannweite flexibel konstruiert ist.

8. Verfahren nach einem der Ansprüche 2 bis 7, wobei bei den Schritten b) bis c) die flexible Schaufel einer zweidimensionalen Platte gleichgesetzt wird, die in einer radialen starren Stange eingesetzt ist, und die sich gemäß der Sehne und möglicherweise gemäß dem Radius verformt, und wobei die Plattengleichungen der Kirchhoff-Love-Theorie angewendet werden.

9. Verfahren nach einem der Ansprüche 1 bis 8, wobei sich die Information über die Auswahl des Materials auf die Aufteilung des oder der Materialen innerhalb der flexiblen Schaufel beziehen oder eine Information über die Aufteilung der Volumenmasse innerhalb der flexiblen Schaufel, die Aufteilung des Flexionsmoduls innerhalb der flexiblen Schaufel, das Einsetzen von zu einer Schaufel mit festgelegtem geometrischem Profil äußeren Elementen aufweist.

10. Verfahren zur Herstellung einer flexiblen Schaufel einer Wind- oder einer Wasserturbine, wobei das Verfahren die Schritte umfasst:

   - Durchführen des Verfahrens nach einem der Ansprüche 1 bis 9 derart, dass eine flexible Wind- oder Wasserturbinenschaufel konstruiert wird;
   - Herstellen der flexiblen Schaufel in Übereinstimmung mit der erhaltenen Konstruktion der flexiblen Wind- oder Wasserturbinenschaufel.

11. Wind- oder Wasserturbinenschaufel, **dadurch gekennzeichnet, dass** sie gemäß der Sehne flexibel ist und gemäß dem Verfahren nach Anspruch 10 hergestellt ist, wobei die Flexibilität der Schaufel den Einstellwinkel der Wind- oder Wasserturbine im Betrieb passiv einstellt.

12. Flexible Wind- oder Wasserturbinenschaufel nach Anspruch 11, wobei die Volumenmasse inhomogen ist und/oder das Flexionsmodul inhomogen ist.

13. Wind- oder Wasserturbine, umfassend eine Vielzahl flexibler Schaufeln nach einem der Ansprüche 11 bis 12.

14. Verfahren zur Konstruktion einer vordefinierten starren Wind- oder Wasserturbinenschaufel, wobei die starre Schaufel ein bekanntes geometrisches Profil aufweist: eine bekannte Spannweite sowie eine Dicke und eine Sehne, die bekannt sind und die gemäß der Spannweitenrichtung variabel sind, einen Einstellwinkel in Ruhe, wobei die starre Schaufel um einen Arm der Wind- /Wasserturbine angelenkt ist, wobei die starre Schaufel eine Rotationsbewegung um den Arm gemäß ihrer Spannweite durchführen kann, wobei mindestens eine Torsionsfeder die starre Schaufel mit dem Arm verbindet, deren Steifigkeit K ausgewählt ist, um den Einstellwinkel der Wind- oder Wasserturbine im Betrieb passiv zu regulieren, wobei das Verfahren die folgenden Schritte umfasst:

   a) Erhalten des bekannten geometrischen Profils,
   b) Bestimmen, für das auf eine starre Referenzschaufel angewendete geometrische Profil, einer Entwicklung des optimalen Einstellwinkels der starren Schaufel $\theta_{0\ opt\ starr}$ in Abhängigkeit von mindestens der spezifischen Geschwindigkeit $\lambda$ gleich dem Verhältnis zwischen der an der Schaufelspitze betrachteten Geschwindigkeit und der Geschwindigkeit des anströmenden Fluids für ein Geschwindigkeitsregime des Fluids, das um die starre Referenzschaufel strömt,
   c) Bestimmen des Verhaltens der flexiblen Schaufel, die mit der Torsionsfeder angelenkt ist, wobei sich die angelenkte starre Schaufel unter der Wirkung der aerodynamischen Kraft des Fluids, das um diese starre Schaufel zirkuliert, der elastischen Rückstellkraft der Torsionsfeder und der Zentrifugalkraft, die auf diese rotierende starre Schaufel wirkt, verlagert,

und Bestimmen lokaler Verhältniszahlen in Relation zu der aerodynamischen Kraft, der elastischen Rückstellkraft und der Zentrifugalkraft, die auf diese angelenkte starre Schaufel wirkt,

d) Bestimmen der Steifigkeit K der Torsionsfeder und von lokalen Werten der Volumenmasse p der angelenkten starren Schaufel mit Hilfe der lokalen Verhältniszahlen und des Verhaltens der flexiblen Schaufel, die in Schritt c) bestimmt wurden, so dass die Entwicklung eines effektiven Einstellwinkels $\theta_{0eff}$ der starren Schaufel, verliehen durch die Torsion der Feder der starren Schaufel, in Abhängigkeit von der spezifischen Geschwindigkeit $\lambda$ der in vorangegangenem Schritt b) bestimmten Entwicklung entspricht, und

e) Rückmelden einer Information über die Auswahl des Materials der angelenkten starren Schaufel und der Steifigkeit K der Torsionsfeder.

**15.** Verfahren nach Anspruch 14, wobei die Schaufel zu einer ersten Wind-/Wasserturbinenkategorie mit horizontaler Rotationsachse gehört und für die die Windrichtung U orthogonal zur Rotationsebene der Schaufel ist.

**16.** Verfahren nach Anspruch 14, wobei die Schaufel zu einer zweiten Wind-/Wasserturbinenkategorie mit vertikaler Rotationsachse oder mit horizontaler Rotationsachse gehört, wenn die Windgeschwindigkeit U nicht orthogonal zur Rotationsebene der Schaufel ist und in diesem Fall $\theta_{0\ opt\ starr}$ eine Funktion von $\alpha$ ist, wobei $\alpha$ der Azimutwinkel (Rotationswinkel der Schaufel um die Achse) ist, und in Schritt b) jeder spezifischen Geschwindigkeit $\lambda$ eine Verteilung von $\theta_{0\ opt\ starr}(\alpha)$ zugeordnet ist.

**17.** Verfahren nach einem der Ansprüche 14 bis 16, wobei:

- in Schritt b) der optimale Wert $\lambda_{max\ starr}$ bestimmt wird, für den die Ausbeute $C_p$ der Wind- oder Wasserturbine mit starren Schaufeln mit demselben festgelegten geometrischen Profil wie das der Wind- /Wasserturbine mit flexiblen Schaufeln maximal ist,

und wobei mit Hilfe der Entwicklung des optimalen Einstellwinkels einer starren Referenzschaufel $\theta_{0\ opt\ starr}$ für die erste Wind-/Wasserturbinenkategorie oder beziehungsweise $\theta_{0\ opt\ starr}(\alpha)$ für die zweite Wind- /Wasserturbinenkategorie

der maximale optimale Arbeitspunkt $[\theta_{0\ opt\ max\ starr}, \lambda_{max\ starr}]$ oder beziehungsweise der maximale optimale Arbeitspunkt $[\theta_{0\ opt\ max\ starr}(\alpha), \lambda_{max\ starr}]$ abgeleitet wird,

- und in Schritt c) ein Wert des Ersteinstellwinkels $\theta_{0\ eff\ erst}$ der angelenkten starren Schaufeln bestimmt wird, damit im Betrieb der maximale effektive Arbeitspunkt $[\theta_{0\ eff\ max}, \lambda_{max}]$ für die erste Wind-/Wasserturbinenkategorie oder beziehungsweise $[\theta_{0\ eff\ max}(\alpha), \lambda_{max}]$ für die zweite Wind- /Wasserturbinenkategorie mit diesen angelenkten starren Schaufeln

gleich dem maximalen optimalen Arbeitspunkt $[\theta_{0\ opt\ max\ starr}, \lambda_{max\ starr}]$ oder beziehungsweise $[\theta_{0\ opt\ max\ starr}(\alpha), \lambda_{max\ starr}]$ der Wind- oder Wasserturbine mit starren Referenzschaufeln ist.

**18.** Verfahren nach einem der Ansprüche 14 bis 17, wobei bei Schritt c) die lokalen Verhältniszahlen in Relation zu der aerodynamischen Kraft und der Zentrifugalkraft, die auf die angelenkte starre Schaufel wirkt, die Cauchy-Zahl $C_y$ und die Zentrifugalzahl $C_c$ sind und an jedem Punkt der angelenkten starren Schaufel bestimmt werden, wobei die Cauchy-Zahl $C_y$ das Verhältnis der Momente der aerodynamischen Kraft und der elastischen Kraft ist, wobei das Produkt $C_c*A^2$ für die erste Wind-/Wasserturbinenkategorie oder beziehungsweise $C_c*\lambda^{2*}(R/W)$ für die zweite Wind-/Wasserturbinenkategorie das Verhältnis der Momente der Zentrifugalkraft und der elastischen Kraft ist.

**19.** Wind- oder Wasserturbine, umfassend:

- eine Vielzahl angelenkter starrer Schaufeln, von denen jede an einen oder mehrere Wind- /Wasserturbinenarme angelenkt ist,
- mindestens eine Torsionsfeder je Arm, die den Arm und die angelenkte starre Schaufel mechanisch verbindet, wobei die Steifigkeit der Torsionsfeder ausgewählt ist, um den Einstellwinkel der Wind- oder Wasserturbine im Betrieb passiv zu regulieren,
- wobei jede Schaufel am Arm derart angelenkt ist, dass sie um den Arm unter der Wirkung der Torsionsfeder und der Kräfte, die auf die Rotation der Schaufel um die Rotationsachse der Windturbine zurückzuführen sind, nur gemäß der Spannweitenrichtung der Schaufel dreht,
- wobei die Volumenmasse der angelenkten starren Schaufeln und die Steifigkeit der Torsionsfedern durch das Verfahren nach einem der Ansprüche 14 bis 18 bestimmt sind.

**20.** Wind- oder Wasserturbine nach Anspruch 19, **dadurch gekennzeichnet, dass** die Windturbine mit vertikaler Rotationsachse oder mit horizontaler Rotationsachse ist, wenn die Windgeschwindigkeit U nicht orthogonal zur Rotationsebene der Schaufel ist.

21. Wind- oder Wasserturbine nach einem der Ansprüche 19 bis 20, wobei die Windturbine mit vertikaler Rotationsachse ist oder mit horizontaler Rotationsachse, wenn die Windgeschwindigkeit U nicht orthogonal zur Rotationsebene der Schaufel ist, **dadurch gekennzeichnet, dass** ein Ende der Torsionsfeder im Inneren der starren Schaufel befestigt ist, ein zweites Ende am Arm befestigt ist, wobei die Achse der Windung der Torsionsfeder kolinear mit der Spannweite ist, wobei die Spannweite die Höhe (L) der angelenkten starren Schaufel ist.

22. Wind- oder Wasserturbine nach Anspruch 21, **dadurch gekennzeichnet, dass** sich ein Ende der Windung auf dem Arm abstützt.

23. Wind- oder Wasserturbine nach einem der Ansprüche 19 bis 22, **dadurch gekennzeichnet, dass** der Arm ein Stützmittel der Schaufel aufweist, das sich in einer Aufnahme der Schaufel befindet, wobei dieses Stützmittel die Rotation der angelenkten Schaufel erlaubt, wobei das Stützmittel eine Zapfenverbindung oder eine Kugelverbindung ist.


**Claims**

1. A method for designing a predefined wind turbine or water turbine flexible blade, the flexible blade having a known geometrical profile: a known span as well as a thickness and a chord that are known and variable in the spanwise direction, a pitch angle at rest, the flexible blade being designed to be flexible at least according to the chord, for passively regulating the pitch angle of the wind turbine or water turbine in operation,
the method comprising the following steps:

   a) receiving the known geometrical profile,
   b) determining, for said geometrical profile applied to a reference rigid blade, a change of the optimum pitch angle of the rigid blade $\theta_{0\,opt\,rigid}$ as a function of the specific speed $\lambda$ equal to the ratio between the speed considered at the end of the blade and the incident fluid speed, for a speed regime of the fluid flowing around the reference rigid blade,
   c) determining the local behavior of the flexible blade, deforming under the effect, on the one hand, of the aerodynamic loading of the fluid circulating around flexible blade and, on the other hand, of the centrifugal force exerted on the flexible blade in rotation, and determining local ratios relating to the aerodynamic loading and to the centrifugal force exerted on the flexible blade,
   d) determining local values of bending modulus B and mass density $\rho$, using the local ratios and the behavior of the flexible blade determined in step c) so that the change of a effective pitch angle $\theta_{0\,eff}$ of the flexible blade, conferred by the flexibility at least according to the chord of the flexible blade, as a function of the specific speed $\lambda$, corresponds to the change determined in the previous step b), and
   e) restituting an information relating to the choice of the material, determined from the local values of bending modulus B and mass density $\rho$ calculated in step d) and from the geometrical profile received in step a).

2. The method according to claim 1, wherein the flexible blade is a flexible blade of a first category of wind turbines/water turbines called horizontal rotation axis wind turbines/water turbines and for which the wind direction U is orthogonal to the plane of rotation of the blade.

3. The method according to claim 1, wherein the flexible blade is a flexible blade of a second category of wind turbines/water turbines called vertical rotation axis or horizontal rotation axis wind turbines/water turbines, when the wind speed U is not orthogonal to the plane of rotation of the flexible blade, and in this case $\theta_{0\,opt\,rigid}$ is also a function of $\alpha$, $\alpha$ being the azimuthal angle (angle of rotation of the blade about the axis), and in step b), with each specific speed $\lambda$ is associated a distribution of $\theta_{0\,opt\,rigid}(\alpha)$.

4. The method according to any of claims 2 to 3, wherein:

   - in step b), the optimum value $\lambda_{max\,rigid}$ is determined, for which the efficiency $C_p$ of the wind turbine or water turbine with reference rigid blades of the same fixed geometrical profile as that of the wind turbine/water turbine with flexible blades is maximum, and wherein the maximum optimum operating point $[\theta_{0\,opt\,max\,rigid}, \lambda_{max\,rigid}]$ or respectively the maximum optimum operating point $[\theta_{0\,opt\,max\,rigid}(\alpha), \lambda_{max\,rigid}]$, is deduced, using the change of the optimum pitch angle of the reference rigid blade $\theta_{0\ opt\ rigid}$ for the first category of wind turbines/water turbines or respectively that of the optimum pitch angle of the reference rigid blade $\theta_{0\ opt\ rigid}(\alpha)$ for the second category of wind turbines/water turbines,

- and in step c), a value of the initial pitch angle $\theta_{0\ eff\ ini}$ of the flexible blades is determined so that, in operation, the maximum effective operating point $[\theta_{0\ eff\ max}, \lambda_{max}]$ for the first category of wind turbine/water turbine or respectively $[\theta_{0\ eff\ max}(\alpha), \lambda_{max}]$ for the second category of wind turbine/water turbine having these blades flexible, is equal to the maximum optimum operating point $[\theta_{0\ opt\ max\ rigid}, \lambda_{max\ rigid}]$ or respectively $[\theta_{0\ opt\ max\ rigid}(\alpha), \lambda_{max\ rigid}]$, of the wind turbine or water turbine with reference rigid blades.

5. The method according to any of claims 2 to 4, wherein during step c), the local ratios relating to the aerodynamic loading and to the centrifugal force exerted on the flexible blade, are the Cauchy's number $C_y$ and the centrifugal number $C_c$, and are determined at each point of the flexible blade, the Cauchy's number $C_y$ being the ratio of the moments of the aerodynamic force and elastic force, the product $C_c{}^* \lambda^2$ for the first category of wind turbine/water turbine, or respectively $C_c{}^* \lambda^2 {}^*(R/W)$ for the category of second wind turbine/water turbine, being the ratio of the moments of the centrifugal force and the elastic force.

6. The method according to any of claims 1 to 5, wherein during steps b) to c), the flexible blade being assimilated to a series of beams embedded in a radial rigid rod, and considered at different locations in the spanwise direction, and which deform according to the chord independently of each other, and the change of the effective pitch angle of the flexible blade is determined as a function of the curvilinear abscissa of the chord.

7. The method according to any of claims 1 to 5, wherein the flexible blade being designed to be flexible also according to the span.

8. The method according to any of claims 2 to 7, wherein during steps b) to c), the flexible blade is assimilated to a two-dimensional plate, embedded in a radial rigid rod, and which deforms according to the chord and possibly according to the radius, and wherein the plate equations derived from the Kirchhoff-Love theory are applied.

9. The method according to any of claims 1 to 8, wherein the information relating to the choice of the material relates to the distribution of the material(s) within the flexible blade, or includes an information on the distribution of the mass density within the flexible blade, the distribution of the bending modulus within the flexible blade, the insertion of elements external to a blade of fixed geometrical profile.

10. A method for manufacturing a flexible blade of a wind turbine or a water turbine, the method comprising steps of:

- implementing the method according to any of claims 1 to 9 so as to design a wind turbine or water turbine flexible blade;
- manufacturing said flexible blade according to the design of the wind turbine or water turbine flexible blade obtained.

11. A wind turbine or water turbine blade, **characterized in that** it is flexible according to the chord, and is manufactured according to the method according to claim 10, the flexibility of said blade passively regulating the pitch angle of the wind turbine or water turbine in operation.

12. The wind turbine or water turbine flexible blade according to claim 11, wherein the mass density is inhomogeneous and/or the bending modulus is inhomogeneous.

13. A wind turbine or water turbine comprising a plurality of flexible blades according to any of claims 11 to 12.

14. A method for designing a predefined wind turbine or water turbine rigid blade, the rigid blade having a known geometrical profile: a known span as well as a thickness and a chord that are known and variable in the spanwise direction, a pitch angle at rest, the rigid blade being hinged around an arm of the wind turbine/water turbine, the rigid blade being able to perform a rotational movement around the arm according to its span, at least one torsion spring connecting the rigid blade with the arm whose stiffness K is chosen for passively regulating the pitch angle of the wind turbine or water turbine in operation, the method comprising the following steps:

a) receiving the known geometrical profile,
b) determining, for said geometrical profile applied to a reference rigid blade, a change of the optimum pitch angle of the rigid blade $\theta_{0\text{ opt rigid}}$ as a function at least of the specific speed A equal to the ratio between the speed considered at the end of the blade and the incident fluid speed, for a speed regime of the fluid flowing around the rigid blade,

c) determining the behavior of the hinged rigid blade with torsion spring, the hinged rigid blade moving under the effect of the aerodynamic loading of the fluid circulating around this rigid blade, of the elastic return force of the torsion spring and of the centrifugal force exerted on this rigid blade in rotation, and determining local ratios relating to the aerodynamic loading, to the elastic return force and to the centrifugal force exerted on this hinged rigid blade,

d) determining the stiffness K of the torsion spring and local values of the mass density $\rho$ of the hinged rigid blade, using the local ratios and the behavior of the rigid blade determined in step c) so that the change of an effective pitch angle $\theta_{0\text{ eff}}$ of the rigid blade, conferred by the torsion of the spring of the rigid blade, as a function of the specific speed $\lambda$, corresponds to the change determined in the previous step b), and

e) restituting an information relating to the choice of the material of the hinged rigid blade, and the stiffness K of the torsion spring.

15. The method according to claim 14, wherein the blade belongs to a first category of wind turbines/water turbines called horizontal rotation axis wind turbines/water turbines and for which the wind direction U is orthogonal to the plane of rotation of the blade.

16. The method according to claim 14, wherein the blade belongs to a second category of wind turbines/water turbines called vertical rotation axis or horizontal rotation axis wind turbines/water turbines, when the wind speed U is not orthogonal to the plane of rotation of the blade, and in this case $\theta_{0\text{ opt rigid}}$ is a function of $\alpha$, $\alpha$ being the azimuthal angle (angle of rotation of the blade about the axis) and in step b), with each specific speed $\lambda$ is associated a distribution of $\theta_{0\text{ opt rigid}}(\alpha)$.

17. The method according to any of claims 14 to 16, wherein:

- in step b), the optimum value $\lambda_{\text{max rigid}}$ is determined, for which the efficiency $C_P$ of the wind turbine or water turbine with rigid blades of the same fixed geometrical profile as that of the wind turbine/water turbine with flexible blades is maximum, and wherein the maximum optimum operating point $[\theta_{0\text{ opt max rigid}}, \lambda_{\text{max rigid}}]$ or respectively the maximum optimum operating point $[\theta_{0\text{ opt max rigid}}(\alpha), \lambda_{\text{max rigid}}]$ is deduced, using the change of the optimum pitch angle of the reference rigid blade $\theta_{0\text{ opt rigid}}$ for the first category of wind turbines/water turbines or respectively $\theta_{0\text{ opt rigid}}(\alpha)$ for the second category of wind turbines/water turbines,

- and in step c), a value of the initial pitch angle $\theta_{0\text{ eff ini}}$ of the hinged rigid blades is determined so that, in operation, the maximum effective operating point $[\theta_{0\text{ eff max}}, \lambda_{\text{max}}]$ for the first category of wind turbine/water turbine or respectively $[\theta_{0\text{ max eff}}(\alpha), \lambda_{\text{max}}]$ for the second category of wind turbine/water turbine having these rigid blades hinged, is equal to the maximum optimum operating point $[\theta_{0\text{ opt max rigid}}, \lambda_{\text{max rigid}}]$ or respectively $[\theta_{0\text{ opt max rigid}}(\alpha), \lambda_{\text{max rigid}}]$ of the wind turbine or water turbine with reference rigid blades.

18. The method according to any of claims 14 to 17, wherein during step c), the local ratios relating to the aerodynamic loading and to the centrifugal force exerted on the hinged rigid blade, are the Cauchy's number $C_y$ and the centrifugal number $C_c$, and are determined at each point of the hinged rigid blade, the Cauchy's number $C_y$ being the ratio of the moments of the aerodynamic force and elastic force, the product $C_c * \lambda^2$ for the first category of wind turbine/water turbine, or respectively $C_c * \lambda^2 * (R/W)$ for the second category of wind turbine/water turbine, being the ratio of the moments of the centrifugal force and elastic force.

19. A wind turbine or water turbine comprising:

- a plurality of rigid blades each hinged to one or several arm(s) of the wind turbine/water turbine,
- at least one torsion spring per arm mechanically connecting the arm and the hinged rigid blade, the stiffness of the torsion spring being chosen for passively regulating the pitch angle of the wind turbine or water turbine in operation,
- each blade being hinged to the arm so as to rotate about the arm only in the direction of the span of the blade, under the effect of the torsion spring and of the forces due to the rotation of the blade about the axis of rotation of the wind turbine,
- the mass density of the hinged rigid blades and the stiffness of the torsion springs are determined by the method defined according to any one of claims 14 to 18.

20. The wind turbine or water turbine according to claim 19, **characterized in that** the wind turbine has a vertical axis of rotation, or a horizontal axis of rotation when the wind speed U is not orthogonal to the plane of rotation of the blade.

21. The wind turbine or water turbine according to any of claims 19 to 20, the wind turbine having a vertical axis of rotation, or a horizontal axis of rotation when the wind speed U is not orthogonal to the plane of rotation of the blade, **characterized in that** one end of the torsion spring is fixed inside the rigid blade, a second end is fixed to the arm, the axis of the turn of the torsion spring being collinear with the span, the span being the height (L) of the hinged rigid blade.

22. The wind turbine or water turbine according to claim 21, **characterized in that** one end of the turn is bearing on the arm.

23. The wind turbine or water turbine according to any of claims 19 to 22, **characterized in that** the arm has a means for supporting the blade, located in a housing of the blade, this support means allowing the rotation of the hinged blade, the support means being a pivot connection or a ball joint.

FIG. 1

Bout de pale

Corde

Epaisseur
de courbure

Envergure

z

y

x

Pied de pale

EP 3 583 312 B1

FIG. 2

# FIG. 3

# FIG. 4a

FIG. 4B

FIG. 4C

FIG. 5A

FIG. 5B

FIG. 5C

FIG. 6

FIG. 7

EP 3 583 312 B1

FIG. 8

EP 3 583 312 B1

**FIG. 9**

Sans vent, sans rotation

En fonctionnement

$W$

$W_f$

$\theta_0$

$\underline{RB}$

$\underline{F}$

$R$

$\theta_{0eff}$

$r\Omega$

$U$

Plan de rotation

$\vec{e_r}$

$\vec{e_z}$

$\vec{e_\phi}$

$0$

FIG. 10

Moindres carrés

# FIG. 11

Legend:
- ─·─○─·─ Courbe optimale $\theta_{0opt\ rigide}$ $(\lambda)$
- ─ ─ ─ ─ Pales rigides
- ───── Ajustement pales flexibles

Y-axis: $\theta_{0eff}$ (°)

X-axis: $\lambda$

EP 3 583 312 B1

# FIG. 12

FIG. 13

(a)   Cas RΩ < U :

(b)   Cas RΩ > U

EP 3 583 312 B1

FIG. 14

FIG. 15

FIG. 16

FIG. 17

FIG. 18

FIG. 19

## FIG. 20

Profil plat (2,2)

Profil plat (1.49,1.25)

NACA0012

$M_Z$ (N.m)

$M_Z$ (N.m)

$M_Z$ (N.m)

$\theta_0$ (°)

$\theta_0$ (°)

$\theta_0$ (°)

(a)

(b)

(c)

EP 3 583 312 B1

# FIG. 21a

(a)

# FIG. 21b

FIG. 22

(a)

**FIG. 23**

(a)

EP 3 583 312 B1

FIG. 24

(a)

EP 3 583 312 B1

FIG. 25

FIG. 26

**FIG. 27**

## FIG. 28

| Réception de profil géométrique | a |

↓

| Détermination d'une évolution de l'angle de calage optimal de pale rigide | b |

↓

| Détermination du comportement local de pale flexible | c |

↓

| Détermination de valeurs locales de modules de flexion et de masse volumique | d |

↓

| Restitution d'une information relative au choix du matériau | e |

## FIG. 29

| Réception de profil géométrique | a |

↓

| Détermination d'une évolution de l'angle de calage optimal de pale rigide | b |

↓

| Détermination du comportement de la pale rigide avec ressort de torsion | c |

↓

| Détermination de la raideur du ressort de torsion et de valeurs locales de la masse volumique | d |

↓

| Restitution d'une information relative au choix du matériau | e |

EP 3 583 312 B1

**EP 3 583 312 B1**

## RÉFÉRENCES CITÉES DANS LA DESCRIPTION

### Documents brevets cités dans la description

- EP 2818408 A1